# EUROPEAN PATENT SPECIFICATION

(11) **EP 2 976 795 B1**
(45) Date of publication and mention of the grant of the patent: **31.10.2018**
(21) Application number: 14712243.6
(22) Date of filing: 17.03.2014
(51) Int. Cl.: H01L 51/50

(54) **WHITE ORGANIC LIGHT-EMITTING DEVICE**
ORGANISCHE VORRICHTUNG ZUR EMISSION VON WEISSEM LICHT
DISPOSITIF ÉLECTROLUMINESCENT ORGANIQUE BLANC

(30) Priority: 20.03.2013 EP 13160198
(43) Date of publication of application: 27.01.2016
(73) Proprietor: UDC Ireland Limited, Ballycoolin, Dublin 15 (IE)
(72) Inventor: WATANABE, Soichi, Seoul 140-025 (KR); METZ, Stefan, 68165 Mannheim (DE); MURER, Peter, CH-4104 Oberwil (CH); WOLLEB, Heinz, CH-4232 Fehren (CH); HEINEMEYER, Ute, 67433 Neustadt (DE); LENNARTZ, Christian, 67105 Schifferstadt (DE); WAGENBLAST, Gerhard, 67157 Wachenheim (DE); SCHÄFER, Thomas, CH-4410 Liestal (CH)
(74) Representative: Maiwald Patent- und Rechtsanwaltsgesellschaft mbH
(86) International application number: PCT/EP2014/055250
(87) International publication number: WO 2014/147006

(56) References cited:
- WO-A1-2011/073149
- WO-A1-2012/039213
- US-A1- 2004 104 394
- US-A1- 2011 266 524
- US-A1- 2011 284 834
- PETER A. LEVERMORE ET AL: "Phosphorescent organic light-emitting diodes for high-efficacy long-lifetime solid-state lighting", JOURNAL OF PHOTONICS FOR ENERGY, vol. 2, no. 1, 26 March 2012 (2012-03-26), page 021205, XP055123091, ISSN: 1947-7988, DOI: 10.1117/1.JPE.2.021205 cited in the application
- YIFAN ZHANG ET AL: "Tenfold increase in the lifetime of blue phosphorescent organic light-emitting diodes", NATURE COMMUNICATIONS, vol. 5, 25 September 2014 (2014-09-25), page 5008, XP055362033, DOI: 10.1038/ncomms6008

## Description

The present invention relates to white organic light-emitting devices having separate stacked blue/green phosphorescent and red phosphorescent layers. The white organic light-emitting devices emit the desired natural white color and show a reduced power consumption, superior current efficiency (candela per ampere), efficacy (= lumen per watt), EQE (external quantum efficiency = photon per electron) and/or lifetime. In particular, the efficiency of the white organic light emitting device is improved and at the same time the lifetime of the white organic light emitting device is increased.

While all-fluorescent white OLEDs using red, green, and blue fluorescent emitters show already remarkably high lifetimes of several 10.000 hours, their efficacy is still limited. To reach higher efficacy values and to expand into the general lighting market, more efficient OLED stacks are investigated intensively. These stacks use either phosphorescent red, green, and blue emitters or combine fluorescent blue emitters with red and green phosphorescent emitters (hybrid OLEDs)

High-efficiency white organic light-emitting devices (OLEDs) have great potential for energy saving solid-state lighting and eco-friendly flat-display panels. In addition, white OLEDs are expected to open new designs in lighting technology, such as transparent lighting panels or luminescent wallpapers because of being able to form paper-like thin films. Phosphorescent OLED technology is an imperative methodology to realize high efficiency white OLEDs because phosphors, such as fac-tris(2-phenylpyridine)iridium(III) (Ir(ppy)₃) and iridium(III)bis(4,6-(difluorophenyl)pyridinato- N,C2')picolinate (Flrpic) enable an internal efficiency as high as 100% converting both singlet and triplet excitons into photons.

EP1390962B1 relates to an organic light emitting device, the device emitting white light and comprising an emissive region, wherein the emissive region comprises a host material, and a plurality of emissive dopants, wherein the emissive region is comprised of a plurality of bands and each emissive dopant is doped into a separate band within the emissive region, wherein at least one of the emissive dopants emits light by phosphorescence, and wherein the device color can be tuned by varying the thickness and the dopant concentrations in each band.

S. R. Forrest et al., Adv. Mater. 14 (2002) 147 discloses two white emitting OLEDs:
**Device 1 (configuration having 3 phosphorescent doping agents):**
   cathode: LiF/Al
   electron transport layer: 2,9-dimethyl-4,7-diphenyl-1,10-phenanthroline (BCP)
   yellow emit. band: 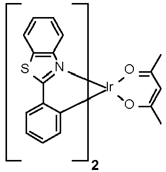 (Bt₂Ir(acac))/ 4,4'-N,N'-dicarbazole-biphenyl (CBP)
   red-emitting band: 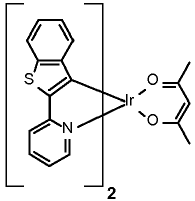 (Btp₂Ir(acac))/CBP
   blue-emiting band: 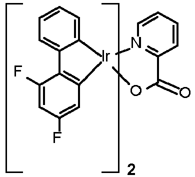 Flrpic/CBP
   hole transport layer: 4,4'-bis[N-(1-napthyl)-N-phenyl-amino]biphenyl (α-NPD)
   hole injection layer: poly(3,4-ethylenedioxythiophene):poly(styrene sulfonic acid) (PEDOT:PSS)
   anode: Indium/tin oxid (ITO)
   substrate: glass
**Device 2 (configuration having 2 phosphorescent doping agents and a blocking layer):**
   cathode: LiF/Al
   electron transport layer: BCP
   red-emitting band: Btp₂Ir(acac)/CBP
   hole/exciton-blocking layer: BCP
   blue-emitting band: Flrpic/CBP
   hole transport layer: α-NPD
   hole injection layer: PEDOT:PSS
   anode: Indium/tin oxid (ITO)
   substrate: glass

S. T. Lee et al. Applied Physics Letters 82 (2003) 4224-4226 reports that the efficiency of white organic light-emitting devices can be improved dramatically by the introduction of a phosphorescent material, Ir(ppy)₃ as a sensitizer. Ir(ppy)₃ and 4-dicyanomethylene)-2-t-butyl-6(1,1,7,7-tetramethyljulolidyl-9-enyl) are codoped into 4,4'-N,N'-dicarbazole-biphenyl (CBP) host. The chromaticity of white emission can be tuned by adjusting the thickness of the codoped CBP layer or the concentration of Ir(ppy)₃.

G. Schwartz et al., Adv. Mater. 2007, 19, 3672 reported hybrid white OLEDs with a power efficiency at 1000 cd/m² (η_{p,1000}) of 22 lm W⁻¹ (external quantum efficiency (EQE) of 10.4%) by using N,N'-di-1-naphthalenyl-N,N'-diphenyl-[quaterphenyl]-4,4"'-diamine (4P-NPD) as a blue fluorophore, and Ir(ppy)₃ and iridium(III)bis(2-methyldibenzo-[f,h]quinoxaline)(acetylacetonate) [Ir(MDQ)₂(acac)] as green and red phosphors, respectively.

M. E. Kondakova et al., J. Appl. Phys. 2010, 107, 014515 reported hybrid white OLEDs with η_{p,1000} of 30 lm W⁻¹ (EQE 13.6%) by using difluoro[6-mesityl-N-(2-(1H)-quinolinyl-idene-κN)-(6-mesityl-2-quinolinaminato-κN1)]boron (MQAB) as a blue fluorophore and fac -bis(2-phenylpyridine)(2-pyridylcoumarin)iridium(III) [Ir(ppy)₂pc] as a yellow phosphor.

S. Reineke et al., Nature 2009, 459, 234 reported white OLEDs with a fluorescent tube efficiency of 81 lm W⁻¹ at 1000 cd/m⁻² by combining red-, green-, blue(RGB)-phosphors and light-outcoupling enhancement techniques, such as high-refractive-index substrates and half-spheres. Notably, this three-color white OLED showed a high color rendering index (CRI) of 80, which is acceptable for an illumination light source. However, the efficiency was decreased to η_{p,1000} of 33 lm W⁻¹ (EQE 14.4%) without light-outcoupling enhancement. On the other hand, J. Kido et al., Adv. Mater. 2008 , 20 , 4189 reported two-color white OLEDs with η_{p,1000} of 44 lm W⁻¹ (EQE 25%). Although the efficacy is much higher than that of hybrid and three-color white OLEDs, the CRI is 68, which is not acceptable for illumination.

Peter A. Levermore et al, J. Photon. Energy. 2 (2012) 021205 report data for a pair of single stack all-phosphorescent 15×15□□cm² OLED light panels. Panel 1 has 62□□lm/W efficacy, CRI=81 and lifetime to LT70=18000□□h at 1000□□cd/m², while Panel 2 has 58□□lm/W efficacy, CRI=82 and lifetime to LT70=30000□□h at 1000□□cd/m². the emissive unit consists of two layers. A blue emitting layer, comprising a blue phosphorescent emitter, and a red/green emitting layer, comprising a red and a green phosphorescent emitter.

Adamovich et al., Journal of Photonics for Energy 2 (2012) 021202 report exceptional efficacy, lifetime and color stability for all-phosphorescent white stacked organic light-emitting devices. The organic light-emitting devices contain two emissive units connected in series by a charge generation layer (CGL). In Device 2 a RGB/RGB architecture was used. That is, the emissive unit consists of two layers. A blue emitting layer, comprising a blue phosphorescent emitter, and a red/green emitting layer, comprising a red and a green phosphorescent emitter. Data are reported for a 15 cm × 15 cm white OLED panel that operates at 3000 cd/m² with 48 Im/W efficacy, CRI = 86 and chromaticity meeting Energy Star criteria. The panel has extremely low operating temperature that is only 6.4°C above ambient, and exceptional lifetime of LT70 ≈ 13000 h when operated at 3000 cd/m².

J. Kido et al, Adv. Mater. 2010, 22, 5003-5007 report on the development of high-efficiency blue and white OLEDs incorporating a blue iridium carbene complex.
White OLED1 with a structure of [ITO (130 nm)/1,1-bis[4-[N,N-di(*p*-tolyl)amino]phenyl]-cyclohexane (TAPC; 40 nm)/ 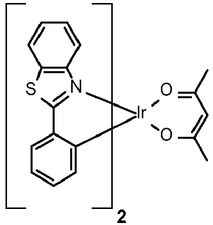 BT₂Ir(acac) 3 wt % doped 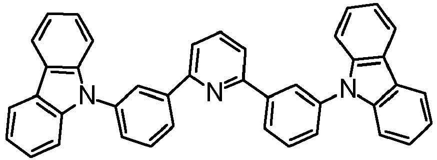 (DCzPPy; 10 nm)/ 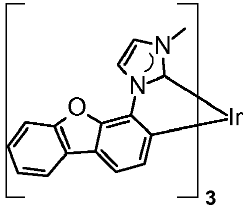 Ir(dbfmi) 10 wt % doped 3,6-bis(diphenylphosphoryl)-9-phenyl-carbazole (PO9; 10 nm)/ 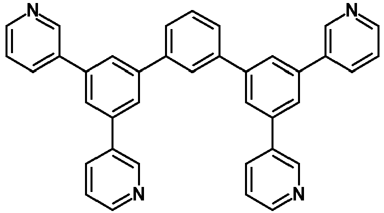 (B₃PyPB, 40 nm)/LiF (0.5 nm)/Al (100 nm)] were fabricated.

White OLED2 with a structure of [ITO (130 nm)/ TAPC (40 nm)/ 4,4',4"-tris(*N*-carbazolyl)-triphenylamine (TCTA; 5 nm)/BT₂Ir(acac) 3 wt % doped DCzPPy (0.5 nm)/Ir(dbfmi) 10 wt % doped 3,6-bis(diphenylphosphoryl)-9-phenylcarbazole (PO9; 10 nm)/B₃PyPB (50 nm)/LiF (0.5 nm)/Al (100 nm)] were fabricated.

White OLED3 with a structure of [ITO (130 nm/TAPC (40 nm/TCTA (5 nm)/ 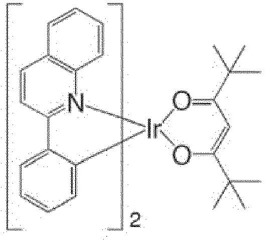 (PQ₂Ir(dpm)) 2 wt % doped CBP (1 nm)/Ir(ppy)₃ 6 wt % doped 4,4'-N,N'-dicarbazolylbiphenyl (CBP; 1 nm)/ Ir(dbfmi) 10 wt % doped PO9 (10 nm)/B₃PyPB (50 nm)/LiF (0.5 nm)/Al (100 nm)] were fabricated.

WO2011/073149 (US2013/032766) discloses metal-carbene complexes comprising a central atom selected from iridium and platinum, and diazabenzimidazolocarbene ligands and OLEDs which comprise such complexes.

In Example 11i of WO2011/073149 white diodes are described.

Example 11ia describes a diode having the following configuration: Anode/hole injection 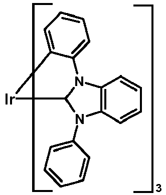 layer/ MoO_{X}/ **Ir(DPBIC)₃** (hole transport layer)/ Ir(OPBIC)₃ (exciton blocking layer)/ 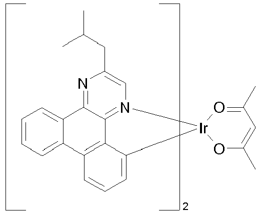 (Red1) & 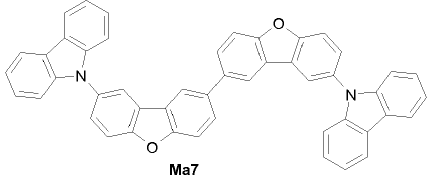 (first emitting layer)/ 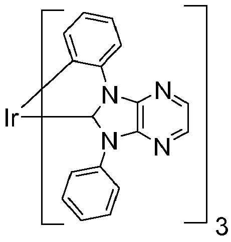 (fac-EM1) & Ma7 & Ir(OPBIC)₃ (second light-emitting layer)/ Ma7 (hole and exciton blocking layer)/ Cs₂CO₃-doped BCP layer (electron transport layer)/ cathode.

The white diode of Example 11ib has the same architecture as the white diode of Example 11ib, execept that the first emitting layer is comprised of Red1 & Ma7 & Ir(OPBIC)₃.

Example 11ic describes a white diode having the following configuration: Anode/hole 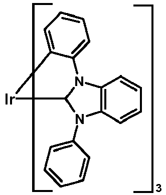 injection layer/ MoO_{X}/ **Ir(DPBIC)₃** (hole transport layer)/ Ir(OPBIC)₃ (exciton blocking layer)/(fac-EM1) & 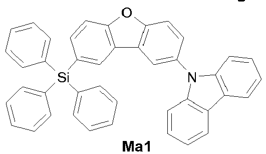 Ma1 & Ir(OPBIC)₃ (first light-emitting layer)/Ma-1 (exciton and hole blocker layer)/BCP doped with Cs₂CO₃ & (DPBIC)₃ (charge generating layer)/ Ir(OPBIC)₃ (hole conducting and exciton blocking layer)/(Red1) & 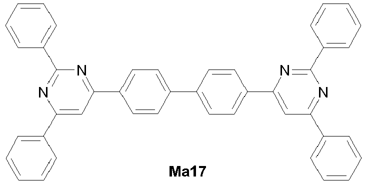 Ma17 & 4,4'-bis[N-(1-naphthyl)-N-phenylamino]biphenyl (α-NPD) (second emitting layer)/ bis(2-methyl-8-quinolinolato)-4-(phenylphenolato)aluminum (BAlq) (hole and exciton blocking layer)/ Cs₂CO₃-doped BCP layer (electron transport layer)/ cathode.

The white diode of Example 11id has the same architecture as the white diode of Example 11 ic, execept that the charge generating layer is comprised of Ir(DPBIC)₃) doped with 10% MoOₓ.

US2013/0153881 (WO2012/039213) relates to an organic light-emitting device comprising: a first electrode; a second electrode; organic multi-layers formed between the first electrode and the second electrode; the organic multi-layers having a hole blocking layer, an emission layer, and an electron blocking layer; and the emission layer being interposed between the hole blocking layer and the electron blocking layer; wherein a first light-emitting dopant is added to the hole blocking layer, a second light-emitting dopant is added to the emission layer, a third light-emitting dopant is added to the electron blocking layer, and the first light-emitting dopant and the third light-emitting dopant trap carriers that inject to the emission layer. According paragraphs [0039] to [0042] of US2013/0153881 a white color spectrum can be obtained in three ways:
(1) first electrode/red green emission layer/charge generation layer/blue emission layer/second electrode;
(2) first electrode/red blue emission layer/charge generation layer/green emission layer/second electrode; and
(3) first electrode/blue green emission layer/charge generation layer/red emission layer/second electrode.

The devices disclosed in US2013/0153881 are distinguished from those of the present invention in that the first light-emitting layer is not in direct contact with the second light-emitting layer. In addition, no device is disclosed in US2013/0153881, which comprises an emission layer comprising a phosphorescent blue emitter and a phosphorescent green emitter.

Other examples of white emitting OLEDs comprising phosphorescent dopants of different colors can be found in US 2004/104394 and US 2011/266524.

Even though there are already known white organic light-emitting devices, it is desirable to provide more stable and/or more efficient white organic light-emitting devices which are usable in industry.

It was surprisingly found that by doping the blue emitting layer with a green-emitter significantly enhances OLED stability and suppresses degradation pathways within blue-emitter based emitting layer without sacrificing external quantum efficiency (EQE) because of very efficient energy transfer. In particular, the critical energy loss by conversion into heat in the blue phosphorescence is significantly reduced.

Accordingly, the present invention relates to a white organic light-emitting device comprising
(a) an anode,
(i) a cathode,
(e) an emitting layer between the anode and cathode, comprising
   (e1) a first light-emitting layer and
   (e2) a second light-emitting layer, wherein
   the first light-emitting layer comprises a phosphorescent red emitter and a first host compound, and
   the second light-emitting layer comprises a phosphorescent blue emitter, a phosphorescent green emitter and a second host compound.

Preferably, the first light-emitting layer is in direct contact with the second light-emitting layer. That means, the first light-emitting layer (e1) is directly attached to the second light-emitting layer (e2).

Preferably, the first light-emitting layer (e1) is disposed between the anode (a) and the second light-emitting layer (e2). That means, a device, comprising in this order: an anode (a), an emitting layer (e), comprising a first light-emitting layer (e1) and a second light-emitting layer (e2), and a cathode (i) is more preferred than a device, comprising in this order: an anode (a), an emitting layer (e), comprising a second light-emitting layer (e2) and a first light-emitting layer (e1), and a cathode (i).
Fig. 1 is a plot luminance versus voltage of the devices obtained in Application Examples 1 and 2 and Comparative Appplication Examples 1 to 3 in logarithmic scale.
Fig. 2 is a plot External Quantum Efficiency versus luminance of the devices obtained in Application Examples 1 and 2 and Comparative Appplication Examples 1 to 3.
Fig. 3 is a graph showing the luminance decay curves (initial luminance at 1000 nits is 100 % and LT₅₀ is 50% of initial luminance).

The white organic light-emitting devices emit the desired natural white color and show a reduced power consumption, superior current efficiency, efficacy, EQE and/or lifetime. In particular, the efficiency of the white organic light emitting device is improved and at the same time the lifetime of the white organic light emitting device is increased. In addition, the white organic light emitting devices of the present invention show an onset of blue below 450 nm, especially below 445 nm, very especially below 440 nm.

The term "white light" as used herein refers to white emission the emission spectrum of which comprises the whole visible light range from 400 nm to 800 nm (onset to offset, here onset means 1% intensity of λₘₐₓ as 100% and offset means 1% intensity from λₘₐₓ as 100%), more preferably from 410 nm to 795 nm, most preferably from 420 nm to 790 nm, which is positioned on or near black body curve in the CIE (Commission Internationale de l'Eclairage) 1931 diagram, which has correlated colour temperature 2700 to 9500 Kelvin, preferably 3000 to 9500 Kelvin, most preferably 3500 to 9500 Kelvin.

The term "phosphorescent red emitter" as used herein refers to a phosphorescent emitter having an emission maximum (λ), which is located between 590 nm to 700 nm, preferably between 600 nm to 660 nm, most preferably between 600 nm to 640 nm with a FWHM (full width at half maximum) between 1 nm to 140 nm, more preferably between 30 nm to 120 nm, most preferably between 60 nm to 100 nm. The triplet decay time (intensity reduced to 1/e = 0.367879441 times its initial value) of the red emitter is 0.5 to 100 micro seconds, more preferably 0.5 to 10 micro seconds, most preferably 0.5 to 3 micro seconds.

The term "phosphorescent green emitter" as used herein refers to a phosphorescent emitter having an emission maximum (λ), which is located between 500 nm to 550 nm, preferably between 505 nm to 540 nm, most preferably between 505 nm to 530 nm with a FWHM between 1 nm to 140 nm, more preferably between 30 nm to 120 nm, most preferably between 60 nm to 100 nm. The triplet decay time of the green emitter is 0.5 to 100 micro seconds, more preferably 0.5 to 10 micro seconds, most preferably 0.5 to 3 micro seconds.

The term "phosphorescent blue emitter" as used herein refers to a phosphorescent emitter having an emission maximum (λ), which is located between 400 nm to 495 nm, preferably between 425 nm to 490 nm, most preferably between 450 nm to 485 nm with a FWHM between 1 nm to 140 nm, more preferably between 30 nm to 120 nm, most preferably between 60 nm to 100 nm. The triplet decay time of the blue emitter is 0.5 to 100 micro seconds, more preferably 0.5 to 10 micro seconds, most preferably 0.5 to 3 micro seconds.

The phosphosphorescent emitters emit preferably from triplet excited states. Phosphorescence may be preceded by a transition from a triplet excited state to an intermediate non-triplet state from which the emissive decay occurs. For example, organic molecules coordinated to lanthanide elements often phosphoresce from excited states localized on the lanthanide metal. However, such materials do not phosphoresce directly from a triplet excited state but instead emit from an atomic excited state centered on the lanthanide metal ion. The europium diketonate complexes illustrate one group of these types of species.

Any colour can be expressed by the chromaticity coordinates x and y on the CIE chromaticity diagram. The boundaries of this horseshoe-shaped diagram are the plots of monochromatic light, called spectrum loci, and all the colours in the visible spectrum fall within or on the boundary of this diagram. The arc near the centre of the diagram is called the Planckian locus, which is the plot of the coordinates of black body radiation at the temperatures from 1000 K to 20000 K, described as CCT. The colours of most of the traditional light sources fall in the region between 2850 and 6500 K of black body. For general illumination a light source should have high-energy efficiency and CIE-1931 chromaticity coordinates (x, y) close to the equal energy white (EEW) (0.33, 0.33).

The correlated colour temperature (CCT) is the temperature of a blackbody radiator that has a colour that most closely matches the emission from a nonblackbody radiator. For high quality white light illumination the CCT should between 2500K and 6500 K.

When considering the use of these white light sources for illumination, the CIE color rendering index (CRI) may be useful in addition to the CIE coordinates of the source. The CRI gives an indication of how well the light source will render colors of objects it illuminates. A perfect match of a given source to the standard illuminant gives a CRI of 100. Though a CRI value of at least 70 may be acceptable for certain applications, a preferred white light source will have a CRI of about 80 or higher.

Substrate may be any suitable substrate that provides desired structural properties. Substrate may be flexible or rigid. Substrate may be transparent, translucent or opaque. Plastic and glass are examples of preferred rigid substrate materials. Plastic and metal foils are examples of preferred flexible substrate materials. Substrate may be a semiconductor material in order to facilitate the fabrication of circuitry. For example, substrate may be a silicon wafer upon which circuits are fabricated, capable of controlling organic light emitting devices (OLEDs) subsequently deposited on the substrate. Other substrates may be used. The material and thickness of substrate may be chosen to obtain desired structural and optical properties.

In a preferred embodiment the white organic light-emitting device according to the present invention comprises in this order:
(a) an anode,
(b) optionally a hole injection layer,
(c) optionally a hole transport layer,
(d) optionally an exciton blocking layer
(e) an emitting layer, comprising
   (e1) a first light-emitting layer,
   (e2) a second light-emitting layer,
(f) optionally a hole/ exciton blocking layer
(g) optionally an electron transport layer,
(h) optionally an electron injection layer, and
(i) a cathode.

In a particularly preferred embodiment the white organic light-emitting device according to the present invention comprises in this order:
(a) an anode,
(b) optionally a hole injection layer,
(c) a hole transport layer,
(d) an exciton blocking layer
(e) an emitting layer, comprising
   (e1) a first light-emitting layer,
   (e2) a second light-emitting layer,
(f) a hole/ exciton blocking layer
(g) an electron transport layer, and
(h) optionally an electron injection layer, and
(i) a cathode.

The properties and functions of these various layers, as well as example materials are known from the prior art and are described in more detail below on basis of preferred embodiments.

### Anode (a):

The anode is an electrode which provides positive charge carriers. It may be composed, for example, of materials which comprise a metal, a mixture of different metals, a metal alloy, a metal oxide or a mixture of different metal oxides. Alternatively, the anode may be a conductive polymer. Suitable metals comprise the metals of groups 11, 4, 5 and 6 of the Periodic Table of the Elements, and also the transition metals of groups 8 to 10. When the anode is to be transparent, mixed metal oxides of groups 12, 13 and 14 of the Periodic Table of the Elements are generally used, for example indium tin oxide (ITO). It is likewise possible that the anode (a) comprises an organic material, for example polyaniline, as described, for example, in Nature, Vol. 357, pages 477 to 479 (June 11, 1992). Preferred anode materials include conductive metal oxides, such as indium tin oxide (ITO) and indium zinc oxide (IZO), aluminum zinc oxide (AlZnO), and metals. Anode (and substrate) may be sufficiently transparent to create a bottom-emitting device. A preferred transparent substrate and anode combination is commercially available ITO (anode) deposited on glass or plastic (substrate). A reflective anode may be preferred for some top-emitting devices, to increase the amount of light emitted from the top of the device. At least either the anode or the cathode should be at least partly transparent in order to be able to emit the light formed. Other anode materials and structures may be used.

### Hole injection layer (b):

Generally, injection layers are comprised of a material that may improve the injection of charge carriers from one layer, such as an electrode or a charge generating layer, into an adjacent organic layer. Injection layers may also perform a charge transport function. The hole injection layer may be any layer that improves the injection of holes from anode into an adjacent organic layer. A hole injection layer may comprise a solution deposited material, such as a spin-coated polymer, or it may be a vapor deposited small molecule material, such as, for example, CuPc or MTDATA. Polymeric hole-injection materials can be used such as poly(N-vinylcarbazole) (PVK), polythiophenes, polypyrrole, polyaniline, self-doping polymers, such as, for example, sulfonated poly(thiophene-3-[2[(2-methoxyethoxy)ethoxy]-2,5-diyl) (Plexcore® OC Conducting Inks commercially available from Plextronics), and copolymers such as poly(3,4-ethylenedioxythiophene)/poly(4-styrenesulfonate) also called PEDOT/PSS.

### Hole transport layer (c):

Either hole-transporting molecules or polymers may be used as the hole transport material. Suitable hole transport materials for layer (c) of the inventive OLED are disclosed, for example, in Kirk-Othmer Encyclopedia of Chemical Technology, 4th Edition, Vol. 18, pages 837 to 860, 1996, US20070278938, US2008/0106190, US2011/0163302 (triarylamines with (di)benzothiophen/(di)benzofuran; Nan-Xing Hu et al. Synth. Met. 111 (2000) 421 (indolocarbazoles), WO2010002850 (substituted phenylamine compounds) and WO2012/16601 (in particular the hole transport materials mentioned on pages 16 and 17 of WO2012/16601). Combination of different hole transport material may be used. Reference is made, for example, to WO2013/022419, wherein 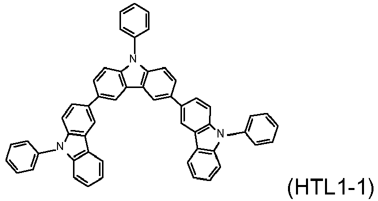 and 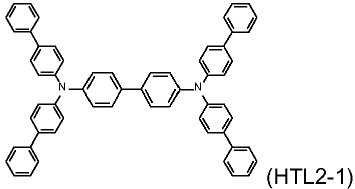 constitute the hole transport layer. Customarily used hole-transporting molecules are selected from the group consisting of 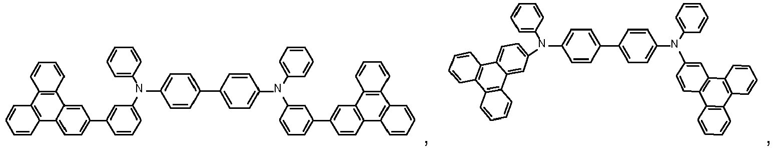 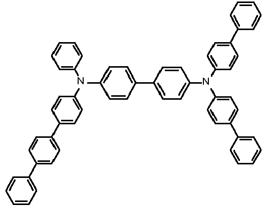 (4-phenyl-N-(4-phenylphenyl)-N-[4-[4-(N-[4-(4-phenyl-phenyl)phenyl]anilino)phenyl]phenyl]aniline), 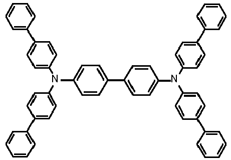 (4-phenyl-N-(4-phenylphenyl)-N-[4-[4-(4-phenyl-N-(4-phenylphenyl)anilino)phenyl]phenyl]a niline), 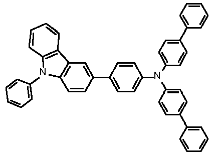 (4-phenyl-N-[4-(9-phenylcarbazol-3-yl)phenyl]-N-(4-phenylphenyl)aniline), 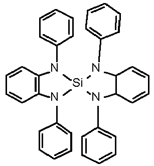 (1,1',3,3'-tetraphenylspiro[1,3,2-benzodiazasilole-2,2'-3a,7a-dihydro-1,3,2-b enzodiazasilole]), 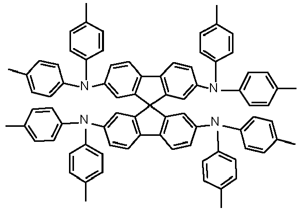 (N2,N2,N2',N2',N7,N7,N7',N7'-octakis(p-tolyl)-9,9'-spirobi[fluorene]-2,2',7,7'-tetramine), 4,4'-bis[N-(1-naphthyl)-N-phenyl-amino]biphenyl (α-NPD), N,N'-diphenyl-N,N'-bis(3-methylphenyl)-[1,1'-biphenyl]-4,4'-diamine (TPD), 1,1-bis[(di-4-tolylamino)phenyl]cyclohexane (TAPC), N,N'-bis(4-methylphenyl)-N,N'-bis(4-ethylphenyl)-[1,1'-(3,3'-dimethyl)-biphenyl]-4,4'-diamine (ETPD), tetrakis(3-methylphenyl)-N,N,N',N'-2,5-phenylenediamine (PDA), α-phenyl-4-N,N-diphenylaminostyrene (TPS), p-(diethylamino)benzaldehyde diphenylhydrazone (DEH), triphenylamine (TPA), bis[4-(N,N-diethylamino)-2-methylphenyl](4-methylphenyl)methane (MPMP), 1-phenyl-3-[p-(diethylamino)styryl]-5-[p-(diethylamino)phenyl]pyrazoline (PPR or DEASP), 1,2-trans-bis(9H-carbazol-9-yl)-cyclobutane (DCZB), N,N,N',N'-tetrakis(4-methylphenyl)-(1,1'-biphenyl)-4,4'-diamine (TTB), fluorine compounds such as 2,2',7,7'-tetra(N,N-di-tolyl)amino-9,9-spirobifluorene (spiro-TTB), N,N'-bis(naphthalen-1-yl)-N,N'-bis(phenyl)-9,9-spirobifluorene (spiro-NPB) and 9,9-bis(4-(N,N-bis-biphenyl-4-yl-amino)phenyl-9H-fluorene, benzidine compounds such as N,N'-bis(naphthalen-1-yl)-N,N'-bis(phenyl)-benzidine and porphyrin compounds such as copper phthalocyanines. In addition, polymeric hole-injection (hole transport) materials can be used such as poly(N-vinylcarbazole) (PVK), polythiophenes, polypyrrole, polyaniline, self-doping polymers, such as, for example, sulfonated poly(thiophene-3-[2[(2-methoxyethoxy)-ethoxy]-2,5-diyl) (Plexcore® OC Conducting Inks commercially available from Plextronics), and copolymers such as poly(3,4-ethylenedioxythiophene)/poly(4-styrenesulfonate) also called PEDOT/PSS.

In a preferred embodiment it is possible to use metal carbene complexes as hole transport materials. Suitable carbene complexes are, for example, carbene complexes as described in WO2005/019373A2, WO2006/056418 A2, WO2005/113704, WO2007/115970, WO2007/115981, WO2008/000727 and EP13162776.2. One example of a suitable carbene complex is Ir(OPBIC)₃ with the formula: 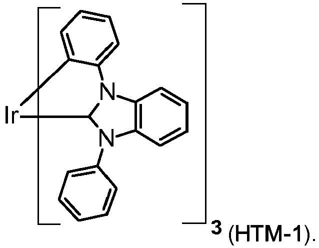 Another example of a suitable carbene complex is Ir(ABIC)₃ with the formula: 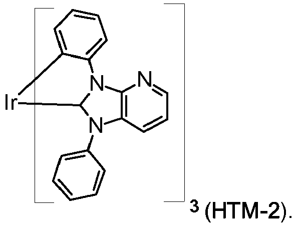 The hole-transporting layer may also be electronically doped in order to improve the transport properties of the materials used, in order firstly to make the layer thicknesses more generous (avoidance of pinholes/short circuits) and in order secondly to minimize the operating voltage of the device. Electronic doping is known to those skilled in the art and is disclosed, for example, in W. Gao, A. Kahn, J. Appl. Phys., Vol. 94, 2003, 359 (p-doped organic layers); A. G. Werner, F. Li, K. Harada, M. Pfeiffer, T. Fritz, K. Leo, Appl. Phys. Lett., Vol. 82, No. 25, 2003, 4495 and Pfeiffer et al., Organic Electronics 2003, 4, 89 - 103 and K. Walzer, B. Maennig, M. Pfeiffer, K. Leo, Chem. Soc. Rev. 2007, 107, 1233. For example it is possible to use mixtures in the hole-transporting layer, in particular mixtures which lead to electrical p-doping of the hole-transporting layer. p-Doping is achieved by the addition of oxidizing materials. These mixtures may, for example, be the following mixtures: mixtures of the abovementioned hole transport materials with at least one metal oxide, for example MoO₂, MoO₃, WOₓ, ReO₃ and/or V₂O₅, preferably MoO₃ and/or ReO₃, more preferably MoO₃, or mixtures comprising the aforementioned hole transport materials and one or more compounds selected from 7,7,8,8-tetracyanoquinodimethane (TCNQ), 2,3,5,6-tetrafluoro-7,7,8,8-tetracyanoquinodimethane (F₄-TCNQ), 2,5-bis(2-hydroxyethoxy)-7,7,8,8-tetracyanoquinodimethane, bis(tetra-n-butylammonium)tetracyanodiphenoquinodimethane, 2,5-dimethyl-7,7,8,8-tetracyanoquinodimethane, tetracyanoethylene, 11,11,12,12-tetracyanonaphtho-2,6-quinodimethane, 2-fluoro-7,7,8,8-tetracyanoquino-dimethane, 2,5-difluoro-7,7,8,8-etracyanoquinodimethane, dicyanomethylene-1,3,4,5,7,8-hexafluoro-6H-naphthalen-2-ylidene)malononitrile (F₆-TNAP), Mo(tfd)₃ (from Kahn et al., J. Am. Chem. Soc. 2009, 131 (35), 12530-12531), compounds as described in EP1988587, US2008265216, EP2180029, US20100102709, WO2010132236, EP2180029 and quinone compounds as mentioned in EP2401254. Preferred mixtures comprise the aforementioned carbene complexes, such as, for example, the carbene complexes **HTM-1** and **HTM-2,** and MoO₃ and/or ReO₃, especially MoO₃. In a particularly preferred embodiment the hole transport layer comprises from 0.1 to 10 wt % of MoO₃ and 90 to 99.9 wt % carbene complex, especially of a carbene complex **HTM-1** and **HTM-2,** wherein the total amount of the MoO₃ and the carbene complex is 100 wt %.

### Exciton blocking layer (d):

Blocking layers may be used to reduce the number of charge carriers (electrons or holes) and/or excitons that leave the emissive layer. An electron/exciton blocking layer (d) may be disposed between the first emitting layer (e1) and the hole transport layer (c), to block electrons from emitting layer (e1) in the direction of hole transport layer (c). Blocking layers may also be used to block excitons from diffusing out of the emissive layer. Suitable metal complexes for use as electron/exciton blocker material are, for example, carbene complexes as described in WO2005/019373A2, WO2006/056418A2, WO2005/113704, WO2007/115970, WO2007/115981, WO2008/000727 and EP13162776.2. Explicit reference is made here to the disclosure of the WO applications cited, and these disclosures shall be considered to be incorporated into the content of the present application. One example of a suitable carbene complex is compound **HTM-1.** Another example of a suitable carbene complex is compound **HTM-2.**

### Emitting layer (e)

The emitting layers contain phosphorescent emitting materials. Phosphorescent materials are preferred because of the higher luminescent efficiencies associated with such materials. The emitting layers also comprise host materials capable of transporting electrons and/or holes, doped with an emitting material that may trap electrons, holes, and/or excitons, such that excitons relax from the emissive material via a photoemissive mechanism. The device of the present invention is an all-phosphorescent white organic light-emitting device.

The device comprises a first light-emitting layer (e1) and a second light-emitting layer (e2) between the anode and cathode. The first light-emitting layer (e1) is in direct contact with the second light-emitting layer (e2).

### First light-emitting layer (e1):

The first light-emitting layer comprises a phosphorescent red emitter and a first host compound. The first light-emitting layer (e1) is preferably disposed between the anode (a) and the second light-emitting layer (e2).

### The phosphorescent red emitter:

Suitable phosphorescent red emitters are specified in the following publications:
WO2009/100991, WO2013/104649; WO2003033617, WO2006095943, WO2008109824, WO20100047707, WO2010033550, WO2012108878, WO2010047707, WO2012148511; EP1939208, WO2009157498, WO2009069535, WO2007066556, US20070244320, WO2008065975. WO2009145062, US20100105902, US20100123127, US20100181905, US20110082296, US20110284834, JP2012004526, US20120104373; and WO 2012053627.

In a particularly preferred embodiment the phosphorescent red emitter is a compound of formula 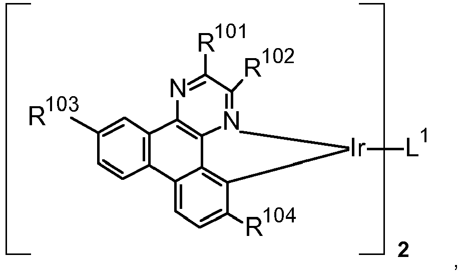 wherein
R¹⁰¹ is C₁-C₁₀alkyl, such as methyl, ethyl, propyl, isopropyl, n-butyl, sec-butyl, isobutyl, tert-butyl, 2-ethylbutyl, n-pentyl, isopentyl, 1-methylpentyl, 1,3-dimethylbutyl, n-hexyl, 1-methylhexyl, n-heptyl, isoheptyl, 1,1,3,3-tetramethylbutyl, 1-methylheptyl, 3-methylheptyl, n-octyl, 2-ethylhexyl, cyclohexyl, which can optionally be substituted by one to three C₁-C₄alkyl groups, R¹⁰² is H, or CH₃,
R¹⁰³ and R¹⁰⁴ are H, or C₁-C₄alkyl, such as methyl, ethyl, propyl, isopropyl, n-butyl, sec-butyl, isobutyl, tert-butyl, and L¹ is

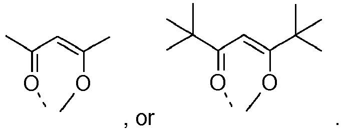

Preferred phosphorescent red emitters are compounds **RE-1** to **RE-43** shown in claim 4. Compounds **RE-1, RE-2, RE-3, RE-5, RE-6, RE-12, RE-14, RE-15, RE-18, RE-19, RE-28, RE-29, RE-35, RE-36** and **RE-40** are more preferred. Compounds **RE-1, RE-2, RE-3, RE-5** and **RE-6** are most preferred.

### The first host compound:

For efficient light emission the triplet energy of the 1^{st} host material has to be about 0.2 eV larger than the triplet energy of the phosphortescent red emitter used. Hence, all host materials fulfilling this requirement are, in principle, suitable as first host compound.

Suitable host materials for phosphorescent red emitters are, for example, described in EP2363398A1, WO2008031743, WO2008065975, WO2010145991, WO2010047707, US20090283757, US20090322217, US20100001638, WO2010002850, US20100060154, US20100060155, US20100076201, US20100096981, US20100156957, US2011186825, US2011198574, US20110210316, US2011215714, US2011284835 and WO2012045710 (PCT/EP2011/067255). The first host material may be an compound having hole-transporting property and/or an organic compound having electron-transporting property. Preferably, the host material is an organic compound or organometallic compound having hole-transporting property. Alternatively the first host compound may be a mixture of an organic compound or organometallic compound having hole-transporting property and an organic compound or organometallic compound having electron-transporting property. In principle, any organic compound or organometallic compound having hole-transporting property and sufficient triplet energy can be used as first host in the first light-emitting layer. Examples of organic compounds having a hole transport property which can be used for the host material include an aromatic amine compound such as 4,4'-bis[N-(1-naphthyl)N-phenylamino]biphenyl (a-NPD), 4,4'-bis[N-(naphthyl)-N-phenylamino]biphenyl (= NPB), 4, 4'-bis[N-(9-phenanthryl)-N-phenylamino]biphenyl (= PPB), 4, 4'-bis[N-(3-methylphenyl)-N-phenylamino]biphenyl (= TPD), 4, 4'-bis[N-(9, 9-dimethylfluoren-2-yl)-N-phenylamino]biphenyl (= DFLDPBi), 4, 4', 4"-tris(N, N-diphenylamino)-triphenylamine (= TDATA), 4, 4', 4"-tris[N-(3-methylphenyl)-N-phenylamino]triphenylamine (= m-MTDATA), 4,4', 4"-tris-(N-carbazolyl)triphenylamine (= TCTA), 1,1-bis[4-(diphenylamino)phenyl]-cyclohexane (= TPAC), 9,9-bis[4-(diphenylamino)phenyl]fluorene (= TPAF), N-[4-(9-carbazolyl)phenyl]-N-phenyl-9, 9-dimethylfluoren-2-amine (abbreviation: YGAF) and a carbazole derivative such as 4, 4'-di(carbazolyl)biphenyl (abbreviation: CBP), 1,3-bis(carbazolyl)benzene (abbreviation: mCP) or 1,3,5-tris(N-carbazolyl)benzene (abbreviation: TCzB), = DNTPD, 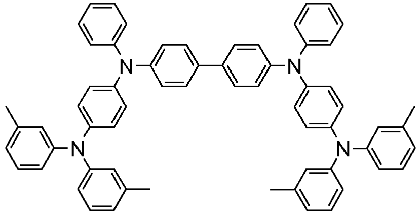 (abbreviation: DNTPD),

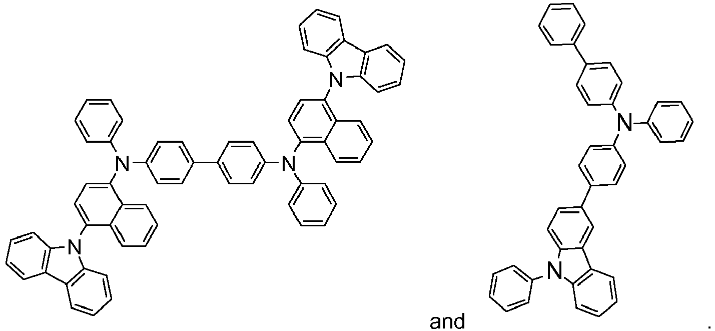

Examples of organometallic compound having a hole transport property which can be used for the host material include iridium-carbene complexes such as compounds **HTM-1** and **HTM-2.**

In principle, any organic compound or organo metallic compound having electron-transporting property and sufficient triplet energy can be used as host in the emitting layer. Examples of organic compounds having an electron transport property which can be used for the host material include a heteroaromatic compound such as 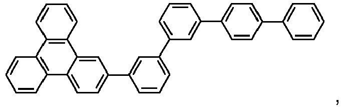 9-[4-(5-phenyl-1,3,4-oxadiazo1-2-yl)phenyl]carbazole, 1, 3-bis[5-(p-tert-butylphenyl)-1,3,4-oxadiazol-2-yl]benzene (= OXD-7), 2-(4-biphenylyl)-5-(4-tert-butylphenyl)-1,3,4-oxadiazole (= PBD), 2,2',2"-(1,3,5-benzenetriyl)tris(1-phenyl-1H-benzimidazole) (= TPBI), 3-(4-tert-butylphenyl)-4-phenyl-5-(4-biphenylyl)-1,2,4-triazole (= TAZ), 3-(4-tert-butylphenyl)-4-(4-ethylphenyl)-5-(4-biphenylyl)-1,2,4-triazole (= p-EtTAZ), 9,9',9"-[1,3,5-triazine-2,4,6-triyl]tricarbazole (= TCz TRZ), 2,2',2"-(1,3,5-benzenetriyl)tris(6,7-dimethyl-3-phenylquinoxaline) (= TriMeQn), 2,3-bis(4-diphenylamino-phenyl)quinoxaline (= TPAQn), 9,9'-(quinoxaline-2,3-diyldi-4,1-phenylene)di(9H-carbazole) (= CzQn), 3,3',6,6'-tetraphenyl-9,9'-(quinoxaline-2, 3-diyldi-4,1 -phenylene)di(9H-carbazole) (= DCzPQ), bathophenanthroline (= BPhen), or bathocuproine (= BCP), and a metal complex such as tris(8-quinolinolato)aluminum (= Alq₃), bis(2-methyl-8-quino-linolato)(4-phenylphenolato)aluminum(III) (= BAlq), tris [2(2-hydroxyphenyl)-5-phenyl-1,3,4-oxadiazolato]aluminum(III) (= Al(OXD)₃), tris(2-hydroxyphenyl-1-phenyl-1-H-benzimidazolato)aluminum(III) (= Al(BIZ)₃), bis[2-(2-hydroxyphenyl)-benzothiazolato]zinc(II) (= Zn(BTZ)₂), bis[2-(2-hydroxyphenyl)benzoxazolato]zinc(II) (= Zn(PBO)₂), bis[2-(2-hydroxyphenyl)pyridinato]zinc (= Znpp₂), 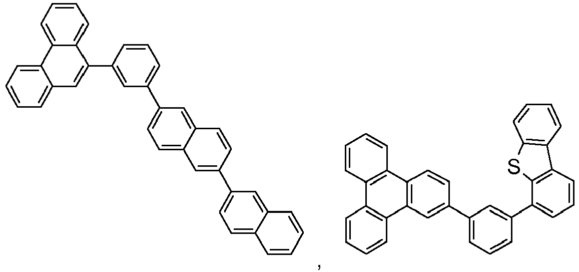 and

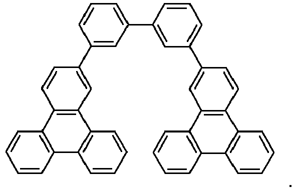

The at present more preferred first host compounds are iridium-carben complexes as specified in WO2012/121936A2, US2012/0305894A1, WO2005/019373A2 and WO2012/172482A1.

The at present preferred first host compounds are **HTM-1** and **HTM-2.**
In addition, all materials suitable as second host compound for the blue and green emitter are, in principle, also suitable as first host compound, because their triplet energy is sufficiently high.

In a preferred embodiment, the first light-emitting layer (e1) comprises the phosphorescent red emitter in an amount of 0.01 to 20% by weight, preferably 0.1 to 10.0 % by weight, more preferably 0.1 to 2.0 % by weight and the first host compound in an amount of 99.99 to 80 % by weight, preferably 99.9 to 90.0 % by weight, more preferably 99.9 to 98.0 % by weight, where the amount of the phosphorescent red emitter and the first host compound(s) adds up to a total of 100% by weight.

The first host compound can be one compound or it can be a mixture of two or more compounds.

### The second light-emitting layer (e2)

The second light-emitting layer comprises a phosphorescent blue emitter, a phosphorescent green emitter and a second host compound.

### The phosphorescent blue emitter

Suitable phosphorescent blue emitters are specified in the following publications:
WO2006/056418A2, WO2005/113704, WO2007/115970, WO2007/115981, WO2008/000727, WO2009050281, WO2009050290, WO2011051404, US2011/057559 WO2011/073149, WO2012/121936A2, US2012/0305894A1, WO2012/170571, WO2012/170461, WO2012/170463, WO2006/121811, WO2007/095118, WO2008/156879, WO2008/156879, WO2010/068876, US2011/0057559, WO2011/106344, US2011/0233528, WO2012/048266 and WO2012/172482.

The second light emitting layer comprises preferably a compound of the formula 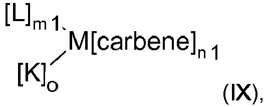 which are described in WO2005/019373A2, wherein the symbols have the following meanings:
M is a metal atom selected from the group consisting of Co, Rh, Ir, Nb, Pd, Pt, Fe, Ru, Os, Cr, Mo, W, Mn, Tc, Re, Cu, Ag and Au in any oxidation state possible for the respective metal atom;
Carbene is a carbene ligand which may be uncharged or monoanionic and monodentate, bidentate or tridentate, with the carbene ligand also being able to be a biscarbene or triscarbene ligand;
L is a monoanionic or dianionic ligand, which may be monodentate or bidentate;
K is an uncharged monodentate or bidentate ligand selected from the group consisting of phosphines; phosphonates and derivatives thereof, arsenates and derivatives thereof;
phosphites; CO; pyridines; nitriles and conjugated dienes which form a *π* complex with M¹;
n1 is the number of carbene ligands, where n1 is at least 1 and when n1 > 1 the carbene ligands in the complex of the formula I can be identical or different;
m1 is the number of ligands L, where m1 can be 0 or ≥ 1 and when m1 > 1 the ligands L can be identical or different;
o is the number of ligands K, where o can be 0 or ≥ 1 and when o > 1 the ligands K can be identical or different;
where the sum n1 + m1 + o is dependent on the oxidation state and coordination number of the metal atom and on the denticity of the ligands carbene, L and K and also on the charge on the ligands, carbene and L, with the proviso that n1 is at least 1.

The phosphorescent blue emitter is more preferably a compound of formula 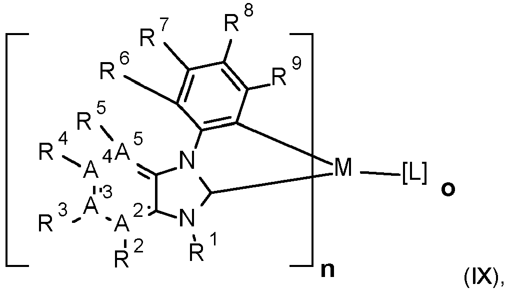 which are described in WO2011/073149, wherein M is Ir,
n is 1, 2 or 3,
A², A³, A⁴ and A⁵ are each independently N or C, where 2 A = nitrogen atoms and at least one carbon atom is present between two nitrogen atoms in the ring,
R¹ is a linear or branched alkyl radical having 1 to 6 carbon atoms, substituted or unsubstituted aryl radical having 6 to 30 carbon atoms, substituted or unsubstituted heteroaryl radical having a total of 5 to 18 carbon atoms and/or heteroatoms, R², R³, R⁴ and R⁵ are each, if A², A³, A⁴ and/or A⁵ is N, a free electron pair, or, if A², A³, A⁴ and/or A⁵ is C, each independently hydrogen, linear or branched alkyl radical having 1 to 6 carbon atoms, substituted or unsubstituted aryl radical having 6 to 30 carbon atoms, substituted or unsubstituted heteroaryl radical having a total of 5 to 18 carbon atoms and/or heteroatoms, or
R³ and R⁴ together with A³ and A⁴ form an optionally substituted, unsaturated ring optionally interrupted by at least one further heteroatom and having a total of 5 to 18 carbon atoms and/or heteroatoms,
R⁶, R⁷, R⁸ and R⁹ are each independently hydrogen, linear or branched alkyl radical optionally interrupted by at least one heteroatom, optionally bearing at least one functional group and having 1 to 20 carbon atoms, substituted or unsubstituted aryl radical optionally interrupted by at least one heteroatom, optionally bearing at least one functional group and having 6 to 30 carbon atoms, substituted or unsubstituted heteroaryl radical optionally interrupted by at least one heteroatom, optionally bearing at least one functional group and having a total of 5 to 18 carbon atoms and/or heteroatoms,
L is a monoanionic bidentate ligand, and
o is 0, 1 or 2.

The phosphorescent blue emitter is preferably a compound **BE-1** to **BE-120** as shown in claim 8. Additional preferred phosphorescent blue emitters are described in
- WO2011/157339: **BE-121** as shown in claim 8;
- WO2010/086089: **BE-122**, **BE-123**, **BE-124**, **BE-125**, and **BE-126** as shown in claim 8. Compounds **BE-1, BE-2, BE-7, BE-12, BE-16, BE-64, BE-70, BE-104, BE-110, BE-113, BE-114, BE-115** and **BE-116** are more preferred. Compound **BE-1** is most preferred.

The homoleptic metal-carbene complexes may be present in the form of facial or meridional isomers, preference being given to the facial isomers.

In the case of the heteroleptic metal-carbene complexes, four different isomers may be present, preference being given to the pseudo-facial isomers

### The phosphorescent green emitter

Suitable phosphorescent green emitters are, for example, specified in the following publications: WO2006014599, WO20080220265, WO2009073245, WO2010027583, WO2010028151, US20110227049, WO2011090535, WO2012/08881, WO20100056669, WO20100118029, WO20100244004, WO2011109042, WO2012166608, US20120292600, EP2551933A1; US6687266, US20070190359, US20070190359, US20060008670; WO2006098460, US20110210316, WO 2012053627; US6921915, US20090039776; and JP2007123392.

Compounds **GE-1** to **GE-39** shown in claim 10 are preferred. Compounds **GE-1, GE-3, GE-8, GE-12, GE-5, GE-14, GE-38, GE-15, GE-16, GE-21, GE-23, GE-24, GE-25, GE-26, GE-33, GE-34** and **GE-35** are more preferred. Compounds **GE-1, GE-3, GE-5, GE-18, GE-38, GE-15, GE-23, GE-24, GE-25, GE-26, GE-34** and **GE-35** are most preferred.

### The second host compound

For efficient light emission the triplet energy of the second host material has to be about 0.2 eV larger than the triplet energy of the phosphorescent blue emitter used. Therefore all host materials fulfilling this requirement with respect to the phosphorescent blue emitter used are, in principle, suitable as second host compound.

Suitable as second host compound are carbazole derivatives, for example 4,4'-bis(carbazol-9-yl)-2,2'-dimethylbiphenyl (CDBP), 4,4'-bis(carbazol-9-yl)biphenyl (CBP), 1,3-bis(N-carbazolyl)benzene (mCP), and the host materials specified in the following applications: WO2008/034758, WO2009/003919.

Further suitable second host materials, which may be small molecules or (co)polymers of the small molecules mentioned, are specified in the following publications: WO2007108459 (H-1 to H-37), preferably H-20 to H-22 and H-32 to H-37, most preferably H-20, H-32, H-36, H-37, WO2008035571 A1 (Host 1 to Host 6), JP2010135467 (compounds 1 to 46 and Host-1 to Host-39 and Host-43), WO2009008100 compounds No.1 to No.67, preferably No.3, No.4, No.7 to No. 12, No.55, No.59, No. 63 to No.67, more preferably No. 4, No. 8 to No. 12, No. 55, No. 59, No.64, No.65, and No. 67, WO2009008099 compounds No. 1 to No. 110, WO2008140114 compounds 1-1 to 1-50, WO2008090912 compounds OC-7 to OC-36 and the polymers of Mo-42 to Mo-51, JP2008084913 H-1 to H-70, WO2007077810 compounds 1 to 44, preferably 1, 2, 4-6, 8, 19-22, 26, 28-30, 32, 36, 39-44, WO201001830 the polymers of monomers 1-1 to 1-9, preferably of 1-3, 1-7, and 1-9, WO2008029729 the (polymers of) compounds 1-1 to 1-36, WO20100443342 HS-1 to HS-101 and BH-1 to BH-17, preferably BH-1 to BH-17, JP2009182298 the (co)polymers based on the monomers 1 to 75, JP2009170764, JP2009135183 the (co)polymers based on the monomers 1-14, WO2009063757 preferably the (co)polymers based on the monomers 1-1 to 1-26, WO2008146838 the compounds a-1 to a-43 and 1-1 to 1-46, JP2008207520 the (co)polymers based on the monomers 1-1 to 1-26, JP2008066569 the (co)polymers based on the monomers 1-1 to 1-16, WO2008029652 the (co)polymers based on the monomers 1-1 to 1-52, WO2007114244 the (co)polymers based on the monomers 1-1 to 1-18, JP2010040830 the compounds HA-1 to HA-20, HB-1 to HB-16, HC-1 to HC-23 and the (co)polymers based on the monomers HD-1 to HD-12, JP2009021336, WO2010090077 the compounds 1 to 55, WO2010079678 the compounds H1 to H42, WO2010067746, WO2010044342 the compounds HS-1 to HS-101 and Poly-1 to Poly-4, JP2010114180 the compounds PH-1 to PH-36, US2009284138 the compounds 1 to 111 and H1 to H71, WO2008072596 the compounds 1 to 45, JP2010021336 the compounds H-1 to H-38, preferably H-1, WO2010004877 the compounds H-1 to H-60, JP2009267255 the compounds 1-1 to 1-105, WO2009104488 the compounds 1-1 to 1-38, WO2009086028, US2009153034, US2009134784, WO2009084413 the compounds 2-1 to 2-56, JP2009114369 the compounds 2-1 to 2-40, JP2009114370 the compounds 1 to 67, WO2009060742 the compounds 2-1 to 2-56, WO2009060757 the compounds 1-1 to 1-76, WO2009060780 the compounds 1-1 to 1-70, WO2009060779 the compounds 1-1 to 1-42, WO2008156105 the compounds 1 to 54, JP2009059767 the compounds 1 to 20, JP2008074939 the compounds 1 to 256, JP2008021687 the compounds 1 to 50, WO2007119816 the compounds 1 to 37, WO2010087222 the compounds H-1 to H-31, WO2010095564 the compounds HOST-1 to HOST-61, WO2007108362, WO2009003898, WO2009003919, WO2010040777, US2007224446, WO06128800, WO2012014621, WO2012105310, WO2012/130709, WO2014/009317 (EP12175635.7), PCT/EP2013/069403 (EP12185230.5) and PCT/EP2013/073120 (EP12191408.9; in particular page 25 to 29 of EP12191408.9).

The above-mentioned small molecules are more preferred than the above-mentioned (co)polymers of the small molecules.

Further suitable second host materials, are described in WO2011137072 (for example, 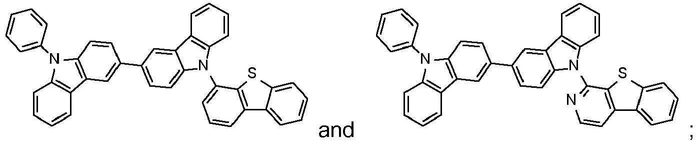 best results are achieved if said compounds are combined with 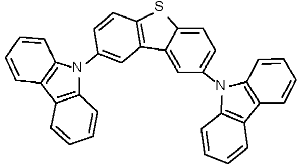 ); WO2012048266 (for example, 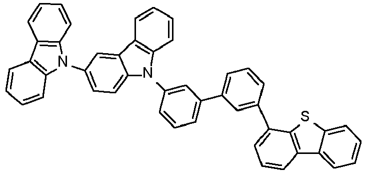 and 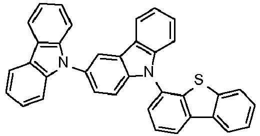 ); WO2012162325 (for example, 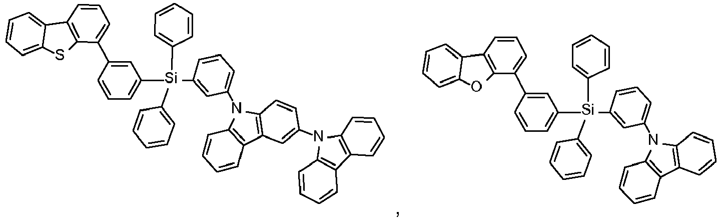 and 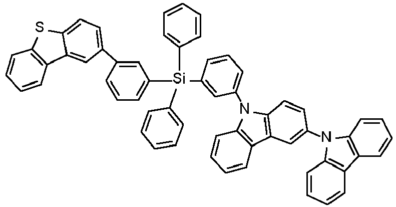 ); and EP2551932 (for example, 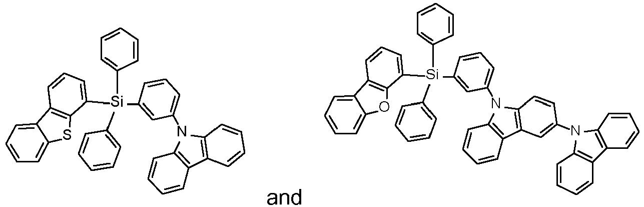 )·

In a particularly preferred embodiment, one or more compounds of the general formula (X) specified hereinafter are used as second host material. 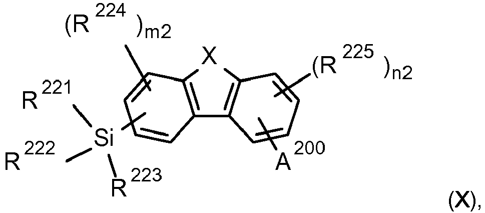 wherein
X is NR, S, O or PR;
R is aryl, heteroaryl, alkyl, cycloalkyl, or heterocycloalkyl;
A²⁰⁰ is -NR²⁰⁶R²⁰⁷, -P(O)R²⁰⁸R²⁰⁹, -PR²¹⁰R²¹¹, -S(O)₂R²¹², -S(O)R²¹³, -SR²¹⁴, or - OR²¹⁵; R²²¹, R²²² and R²²³ are independently of each other aryl, heteroaryl, alkyl, cycloalkyl, or heterocycloalkyl, wherein at least on of the groups R²²¹, R²²², or R²²³ is aryl, or heteroaryl; R²²⁴ and R²²⁵ are independently of each other alkyl, cycloalkyl, heterocycloalkyl, aryl, heteroaryl, a group A²⁰⁰, or a group having donor, or acceptor characteristics;
n2 and m2 are independently of each other 0, 1, 2, or 3;
R²⁰⁶ and R²⁰⁷ form together with the nitrogen atom a cyclic residue having 3 to 10 ring atoms, which can be unsubstituted, or which can be substituted with one, or more substituents selected from alkyl, cycloalkyl, heterocycloalkyl, aryl, heteroaryl and a group having donor, or acceptor characteristics; and/or which can be annulated with one, or more further cyclic residues having 3 to 10 ring atoms, wherein the annulated residues can be unsubstituted, or can be substituted with one, or more substituents selected from alkyl, cycloalkyl, heterocycloalkyl, aryl, heteroaryl and a group having donor, or acceptor characteristics; and
R²⁰⁸, R²⁰⁹, R²¹⁰, R²¹¹, R²¹², R²¹³, R²¹⁴ und R²¹⁵ are independently of each other aryl, heteroaryl, alkyl, cycloalkyl, or heterocycloalkyl. Compounds of formula X, such as, for example, 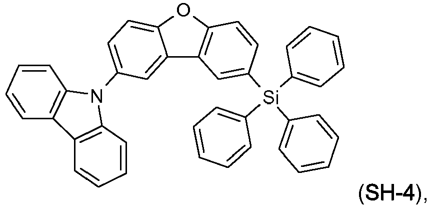 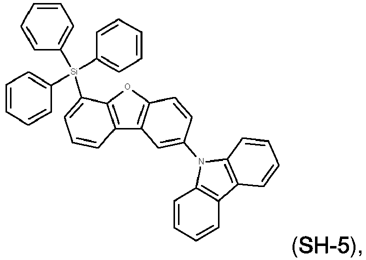 or 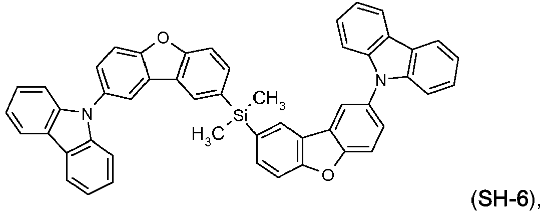 are described in WO2010079051 (in particular pages on 19 to 26 and in tables on pages 27 to 34, pages 35 to 37 and pages 42 to 43). Additional host materials on basis of dibenzofurane are, for example, described in US2009066226, EP1885818B1, EP1970976, EP1998388 and EP2034538. Examples of particularly preferred host materials are shown below: 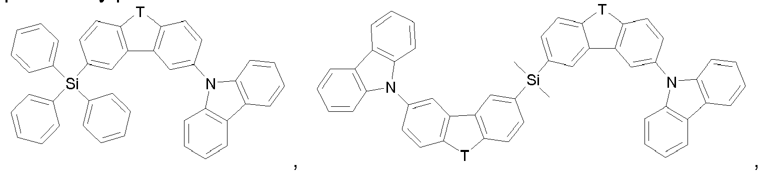 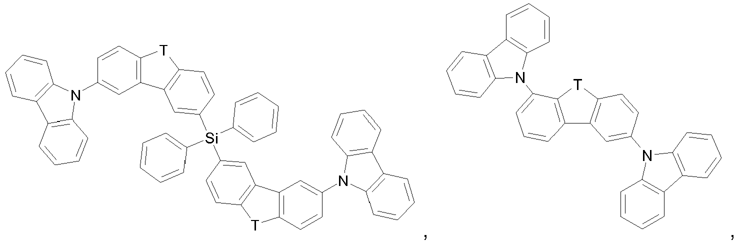 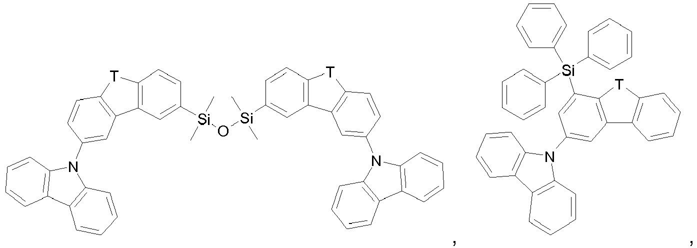 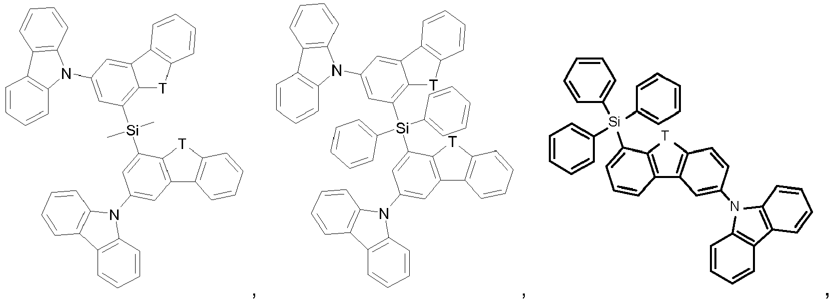 especially

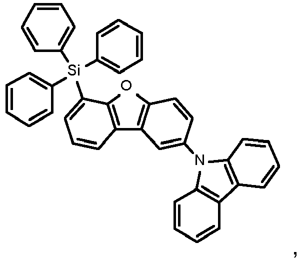

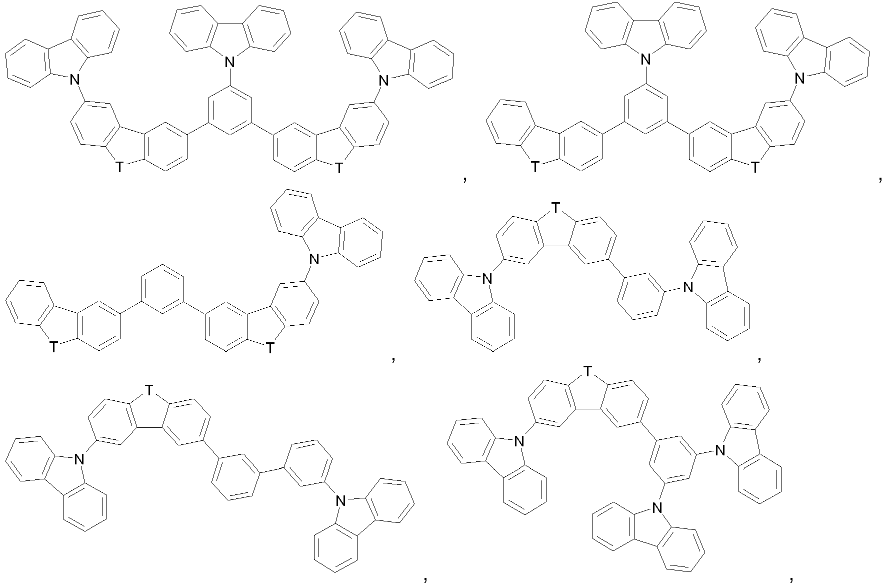

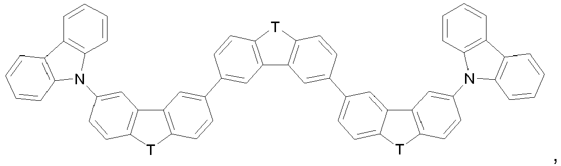

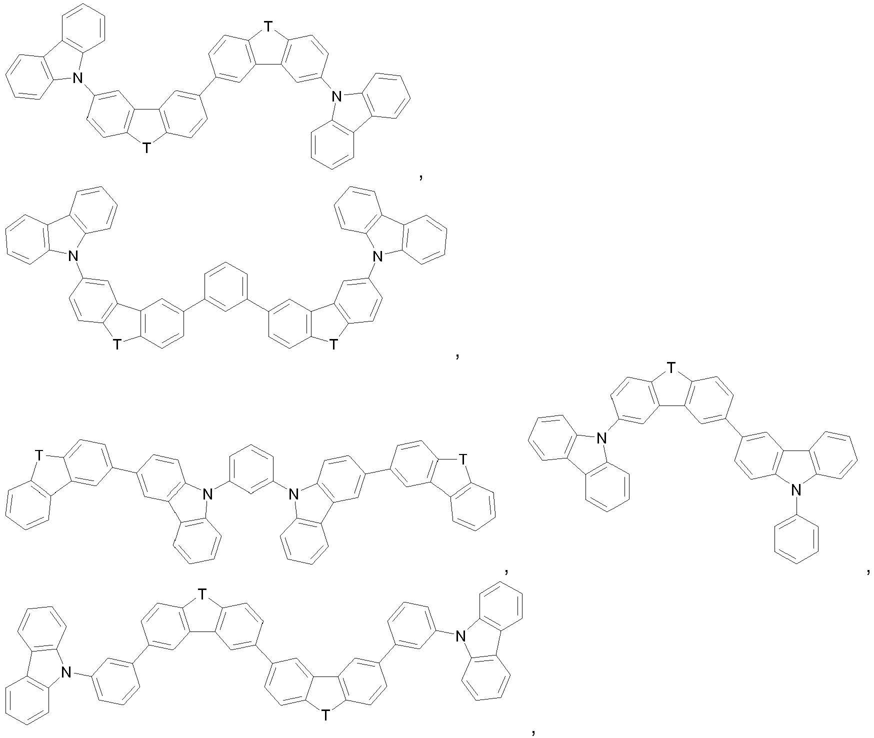

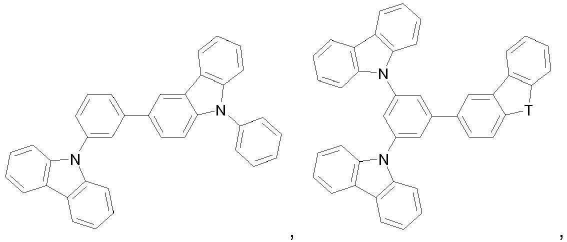

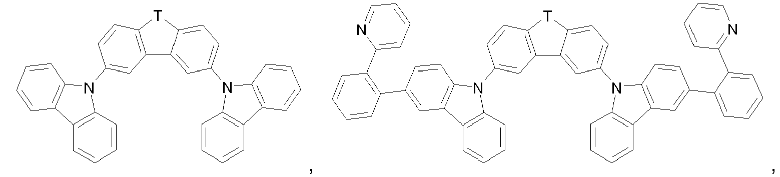

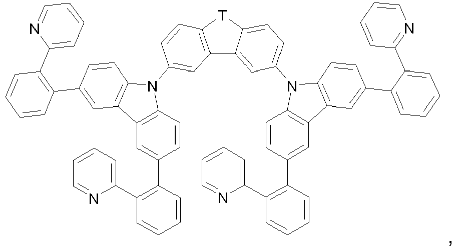

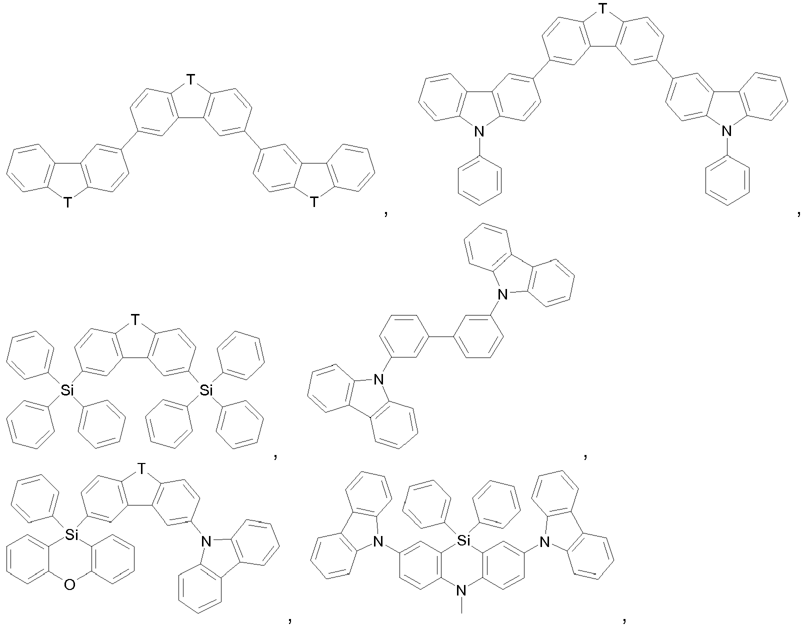

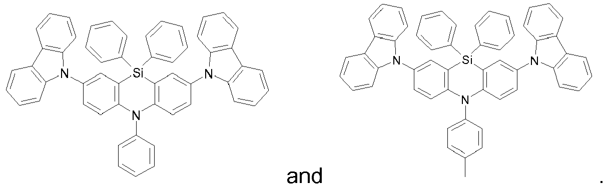

In the above-mentioned compounds T is O, or S, preferably O. If T occurs more than one time in a molecule, all groups T have the same meaning. Compounds **SH-1, SH-2, SH-3, SH-4, SH-5, SH-6, SH-7, SH-8, SH-9** and **SH-10** shown in claim 13 are most preferred.

In a preferred embodiment, the second light-emitting layer (e2) comprises the phosphorescent blue emitter in an amount of 5.0 to 40.0 % by weight, preferably 10.0 to 30.0 % by weight, more preferably 15.0 to 25.0 by weight, the phosphorescent green emitter in an amount of 0.05 to 5.0 % by weight, preferably 0.05 to 3.0 % by weight, more preferably 0.1 to 1.0 % by weight, and the second host compound in an amount of 94.95 to 55.0 % by weight, preferably 89.95 to 67.0 % by weight, more preferably 84.9 to 74.0 % by weight, where the amount of phosphorescent blue emitter, the phosphorescent green emitter and the second host compound(s) adds up to a total of 100% by weight.

The second host compound can be one compound or it can be a mixture of two or more compounds. Advantageously compounds **HTM-1** and **HTM-2** may be added as co-host.

The preferred combinations of host compounds and emitter compounds used in the first and second emitting layer are shown in the table below:

| **Device** | **Red Emitter** | **1^{st} Host** | **Blue Emitter** | **Green Emitter** | **2^{nd} Host** |
|---|---|---|---|---|---|
| **1** | **RE-1** | **HTM-1** | **BE-1** | **GE-1** | **SH-1** |
| **2** | **RE-1** | **HTM-2** | **BE-1** | **GE-1** | **SH-1** |
| **3** | **RE-1** | **HTM-1** | **BE-1** | **GE-1** | **SH-2** |
| **4** | **RE-1** | **HTM-2** | **BE-1** | **GE-1** | **SH-2** |
| **5** | **RE-1** | **HTM-1** | **BE-1** | **GE-1** | **SH-3** |
| **6** | **RE-1** | **HTM-2** | **BE-1** | **GE-1** | **SH-3** |
| **7** | **RE-1** | **HTM-1** | **BE-1** | **GE-1** | **SH-4** |
| **8** | **RE-1** | **HTM-2** | **BE-1** | **GE-1** | **SH-4** |
| **9** | **RE-1** | **HTM-1** | **BE-1** | **GE-1** | **SH-5** |
| **10** | **RE-1** | **HTM-2** | **BE-1** | **GE-1** | **SH-5** |
| **11** | **RE-2** | **HTM-1** | **BE-1** | **GE-1** | **SH-1** |
| **12** | **RE-2** | **HTM-2** | **BE-1** | **GE-1** | **SH-1** |
| **13** | **RE-2** | **HTM-1** | **BE-1** | **GE-1** | **SH-2** |
| **14** | **RE-2** | **HTM-2** | **BE-1** | **GE-1** | **SH-2** |
| **15** | **RE-2** | **HTM-1** | **BE-1** | **GE-1** | **SH-3** |
| **16** | **RE-2** | **HTM-2** | **BE-1** | **GE-1** | **SH-3** |
| **17** | **RE-2** | **HTM-1** | **BE-1** | **GE-1** | **SH-4** |
| **18** | **RE-2** | **HTM-2** | **BE-1** | **GE-1** | **SH-4** |
| **19** | **RE-2** | **HTM-1** | **BE-1** | **GE-1** | **SH-5** |
| **20** | **RE-2** | **HTM-2** | **BE-1** | **GE-1** | **SH-5** |

### Hole/exciton blocking layer (f):

Blocking layers may be used to reduce the number of charge carriers (electrons or holes) and/or excitons that leave the emissive layer. The hole blocking layer may be disposed between the second emitting layer (e2) and electron transport layer (g), to block holes from leaving layer (e2) in the direction of electron transport layer (g). Blocking layers may also be used to block excitons from diffusing out of the emissive layer. Suitable hole/exciton material are, in principle, the second host compounds mentioned above. The same preferences apply as for the second host material.

The at present most preferred hole/exciton blocking materials are compounds **SH-1, SH-2, SH-3, SH-4, SH-5, SH-6, SH-7, SH-8, SH-9** and **SH-10.**

### Electron transport layer (g):

Electron transport layer may include a material capable of transporting electrons. Electron transport layer may be intrinsic (undoped), or doped. Doping may be used to enhance conductivity. Suitable electron-transporting materials for layer (g) of the inventive OLEDs comprise metals chelated with oxinoid compounds, such as tris(8-hydroxyquinolato)aluminum (Alq₃), compounds based on phenanthroline such as 2,9-dimethyl-4,7-diphenyl-1,10phenanthroline (DDPA = BCP), 4,7-diphenyl-1,10-phenanthroline (Bphen), 2,4,7,9-tetraphenyl-1,10-phenanthroline, 4,7-diphenyl-1,10-phenanthroline (DPA) or phenanthroline derivatives disclosed in EP1786050, in EP1970371, or in EP1097981, and azole compounds such as 2-(4-biphenylyl)-5-(4-t-butylphenyl)-1,3,4-oxadiazole (PBD) and 3-(4-biphenylyl)-4-phenyl-5-(4-t-butylphenyl)-1,2,4-triazole (TAZ).

It is likewise possible to use mixtures of at least two materials in the electron-transporting layer, in which case at least one material is electron-conducting. Preferably, in such mixed electron-transporting layers, at least one phenanthroline compound is used, preferably BCP, or at least one pyridine compound according to the formula (**VIII**) below, preferably a compound of the formula (**VIIIaa**) below. More preferably, in mixed electron-transporting layers, in addition to at least one phenanthroline compound, alkaline earth metal or alkali metal hydroxyquinolate complexes, for example Liq, are used. Suitable alkaline earth metal or alkali metal hydroxyquinolate complexes are specified below (**formula VII**). Reference is made to WO2011/157779.

The electron-transporting layer may also be electronically doped in order to improve the transport properties of the materials used, in order firstly to make the layer thicknesses more generous (avoidance of pinholes/short circuits) and in order secondly to minimize the operating voltage of the device. Electronic doping is known to those skilled in the art and is disclosed, for example, in W. Gao, A. Kahn, J. Appl. Phys., Vol. 94, No. 1, 1 July 2003 (p-doped organic layers); A. G. Werner, F. Li, K. Harada, M. Pfeiffer, T. Fritz, K. Leo, Appl. Phys. Lett., Vol. 82, No. 25, 23 June 2003 and Pfeiffer et al., Organic Electronics 2003, 4, 89 - 103 and K. Walzer, B. Maennig, M. Pfeiffer, K. Leo, Chem. Soc. Rev. 2007, 107, 1233. For example, it is possible to use mixtures which lead to electrical n-doping of the electron-transporting layer. n-Doping is achieved by the addition of reducing materials. These mixtures may, for example, be mixtures of the abovementioned electron transport materials with alkali/alkaline earth metals or alkali/alkaline earth metal salts, for example Li, Cs, Ca, Sr, Cs₂CO₃, with alkali metal complexes and with Y, Ce, Sm, Gd, Tb, Er, Tm, Yb, Li₃N, Rb₂CO₃, dipotassium phthalate, W(hpp)₄ from EP1786050, or with compounds described in EP1837926B1, EP1837927, EP2246862 and WO2010132236.

In a preferred embodiment, the electron-transporting layer comprises at least one compound of the general formula (**VII**) 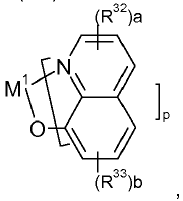 in which
R³² and R³³ are each independently F, C₁-C₈-alkyl, or C₆-C₁₄-aryl, which is optionally substituted by one or more C₁-C₈-alkyl groups, or
two R³² and/or R³³ substituents together form a fused benzene ring which is optionally substituted by one or more C₁-C₈-alkyl groups;
a and b are each independently 0, or 1, 2 or 3,
M¹ is an alkaline metal atom or alkaline earth metal atom,
p is 1 when M¹ is an alkali metal atom, p is 2 when M¹ is an earth alkali metal atom.

A very particularly preferred compound of the formula (VII) is 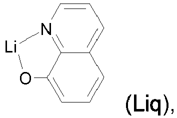 which may be present as a single species, or in other forms such as Li_{g}Q_{g} in which g is an integer, for example Li₆Q₆. Q is an 8-hydroxyquinolate ligand or an 8-hydroxyquinolate derivative.

In a further preferred embodiment, the electron-transporting layer comprises at least one compound of the formula (**VIII**), 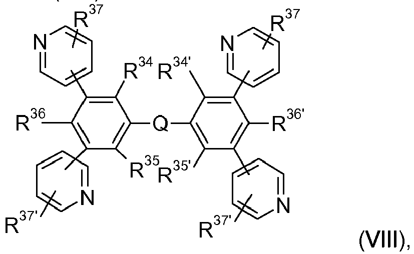 in which
R³⁴, R³⁵, R³⁶, R³⁷, R^{34'}, R^{35'}, R^{36'} and R^{37'} are each independently H, C₁-C₁₈-alkyl, C₁-C₁₈-alkyl which is substituted by E and/or interrupted by D, C₆-C₂₄-aryl, C₆-C₂₄-aryl which is substituted by G, C₂-C₂₀-heteroaryl or C₂-C₂₀-heteroaryl which is substituted by G, Q is an arylene or heteroarylene group, each of which is optionally substituted by G;
D is -CO-; -COO-; -S-; -SO-; -SO₂-; -O-; -NR⁴⁰-; -SiR⁴⁵R⁴⁶-; -POR⁴⁷-; -CR³⁸=CR³⁹-; or -C≡C-;
E is -OR⁴⁴; -SR⁴⁴; -NR⁴⁰R⁴¹; -COR⁴³; -COOR⁴²; -CONR⁴⁰R⁴¹; -CN; or F;
G is E, C₁-C₁₈-alkyl, C₁-C₁₈-alkyl which is interrupted by D , C₁-C₁₈-perfluoroalkyl, C₁-C₁₈-alkoxy, or C₁-C₁₈-alkoxy which is substituted by E and/or interrupted by D, in which
R³⁸ and R³⁹ are each independently H, C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-;
R⁴⁰ and R⁴¹ are each independently C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-; or R⁴⁰ and R⁴¹ together form a 6-membered ring;
R⁴² and R⁴³ are each independently C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-, R⁴⁴ is C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-,
R⁴⁵ and R⁴⁶ are each independently C₁-C₁₈-alkyl, C₆-C₁₈-aryl or C₆-C₁₈-aryl which is substituted by C₁-C₁₈-alkyl,
R⁴⁷ is C₁-C₁₈-alkyl, C₆-C₁₈-aryl or C₆-C₁₈-aryl which is substituted by C₁-C₁₈-alkyl.

Preferred compounds of the formula (VIII) are compounds of the formula (Villa) 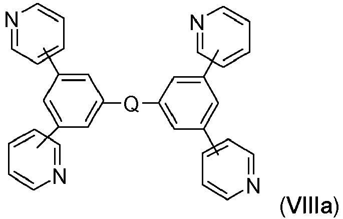 in which Q is: 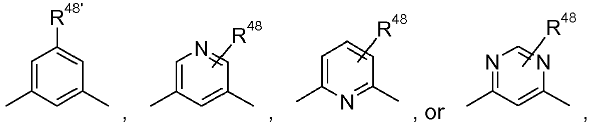 R⁴⁸ is H or C₁-C₁₈-alkyl and R^{48'} is H, C₁-C₁₈-alkyl or

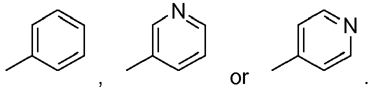

Particular preference is given to a compound of the formula

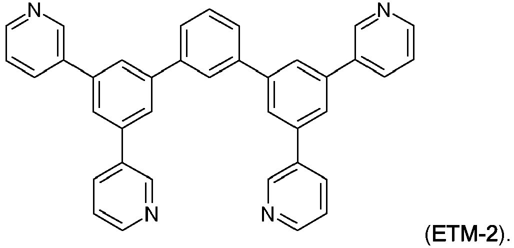

In a further, very particularly preferred embodiment, the electron-transporting layer comprises a compound Liq and a compound ETM-2.

In a preferred embodiment, the electron-transporting layer comprises the compound of the formula (VII) in an amount of 99 to 1% by weight, preferably 75 to 25% by weight, more preferably about 50% by weight, where the amount of the compounds of the formulae (VII) and the amount of the compounds of the formulae (**VIII**) adds up to a total of 100% by weight.

The preparation of the compounds of the formula (**VIII**) is described in J. Kido et al., Chem. Commun. (2008) 5821- 5823, J. Kido et al., Chem. Mater. 20 (2008) 5951- 5953 and JP2008/127326, or the compounds can be prepared analogously to the processes disclosed in the aforementioned documents.

It is likewise possible to use mixtures of alkali metal hydroxyquinolate complexes, preferably Liq, and dibenzofuran compounds in the electron-transporting layer. Reference is made to WO2011/157790. Dibenzofuran compounds **A-1** to **A-36** and **B-1** to **B-22** described in WO2011/157790 are preferred, wherein dibenzofuran compound 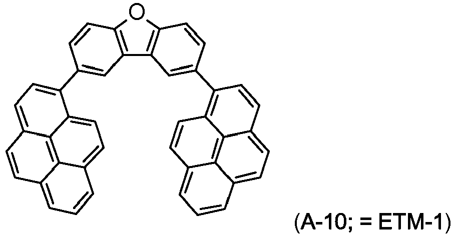 is most preferred.

In a preferred embodiment, the electron-transporting layer comprises Liq in an amount of 99 to 1% by weight, preferably 75 to 25% by weight, more preferably about 50% by weight, where the amount of **Liq** and the amount of the dibenzofuran compound(s), especially **ETM-1,** adds up to a total of 100% by weight.

In a preferred embodiment, the electron-transporting layer comprises at least one phenanthroline derivative and/or pyridine derivative.

In a further preferred embodiment, the electron-transporting layer comprises at least one phenanthroline derivative and/or pyridine derivative and at least one alkali metal hydroxyquinolate complex.

In a further preferred embodiment, the electron-transporting layer comprises at least one of the dibenzofuran compounds **A-1** to **A-36** and **B-1** to **B-22** described in WO2011/157790, especially **ETM-1.**

In a further preferred embodiment, the electron-transporting layer comprises a compound described in WO2012/111462, WO2012/147397, WO2012014621, such as, for example, a compound of formula 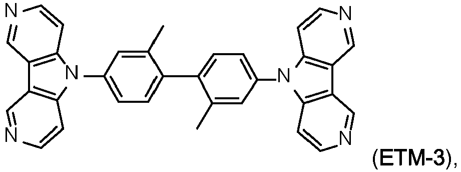 US2012/0261654 , such as, for example, a compound of formula 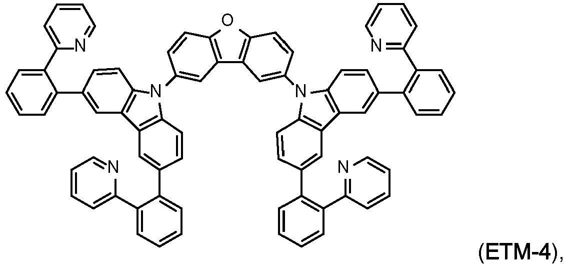 and WO2012/115034, such as for example, such as, for example, a compound of formula

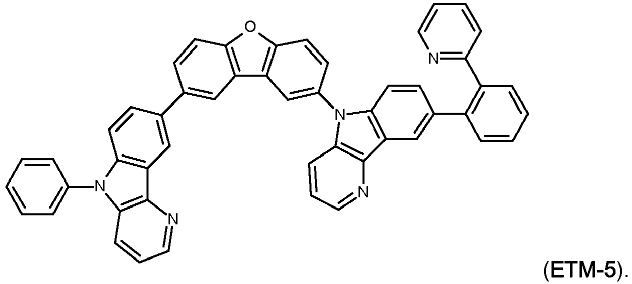

### Electron injection layer (h):

The electron injection layer may be any layer that improves the injection of electrons into an adjacent organic layer. Lithium-comprising organometallic compounds such as 8-hydroxyquinolatolithium (Liq), CsF, NaF, KF, Cs₂CO₃ or LiF may be applied between the electron transport layer (g) and the cathode (i) as an electron injection layer (h) in order to reduce the operating voltage.

### Cathode (i):

The cathode (i) is an electrode which serves to introduce electrons or negative charge carriers. The cathode may be any metal or nonmetal which has a lower work function than the anode. Suitable materials for the cathode are selected from the group consisting of alkali metals of group 1, for example Li, Cs, alkaline earth metals of group 2, metals of group 12 of the Periodic Table of the Elements, comprising the rare earth metals and the lanthanides and actinides. In addition, metals such as aluminum, indium, calcium, barium, samarium and magnesium, and combinations thereof, may be used.

In general, the different layers, if present, have the following thicknesses:
anode (a): 500 to 5000 Å (ångström), preferably 1000 to 2000 Å;
hole injection layer (b): 50 to 1000 Å, preferably 200 to 800 Å,
hole-transport layer (c): 50 to 1000 Å, preferably 100 to 800 Å,
exciton blocking layer (d): 10 to 500 Å, preferably 50 to 100 Å,
first light-emitting layer (e1): 10 to 1000 Å, preferably 50 to 600 Å,
second light-emiting layer (e2): 10 to 1000 Å, preferably 50 to 600 Å,
hole/ exciton blocking layer (f): 10 to 500 Å, preferably 50 to 100 Å,
electron-transport layer (g): 50 to 1000 Å, preferably 200 to 800 Å,
electron injection layer (h): 10 to 500 Å, preferably 20 to 100 Å,
cathode (i): 200 to 10 000 Å, preferably 300 to 5000 Å.

The device architecture and the layer composition of particularly preferred organic light-emitting devices is shown below:

| | **Device 1** | **Device 2** | **Device 3** | **Device 4** |
|---|---|---|---|---|
| **anode (a)** | ITO | ITO | ITO | ITO |
| **hole injection layer (b)** | ¹⁾ | ¹⁾ | ¹⁾ | ¹⁾ |
| **hole transport layer (c)** | **MoO₃/ HTM-1** | **MoO₃/ HTM-1** | **MoO₃/ HTM-1** | **MoO₃/HTM-2** |
| **exciton blocking layer (d)** | **HTM-1** | **HTM-2** | **HTM-1** | **HTM-2** |
| **first light-emitting layer (e1)** | **RE-2 / HTM-1** | **RE-2 / HTM-2** | **RE-1 / HTM-1** | **RE-1 / HTM-2** |
| **second light-emitting layer (e2)** | **BE-1 / GE-1 / SH-2** | **BE-1 / GE-1 / SH-2** | **BE-1 / GE-1 / SH-1** | **BE-1 / GE-1 / SH-1** |
| **exciton blocking layer (f)** | **SH-2** | **SH-2** | **SH-1** | **SH-1** |
| **electron transport layer (g)** | **ETM-1 / Liq** | **ETM-1 / Liq** | **ETM-1 / Liq** | **ETM-1 / Liq** |
| **electron injection layer (h)** | **KF** | **KF** | **KF** | **KF** |
| **cathode (i)** | **Al** | **Al** | **Al** | **Al** |

| | | | | |
|---|---|---|---|---|
| ¹⁾ (sulfonated poly(thiophene-3-[2[(2-methoxyethoxy)ethoxy]-2,5-diyl) | | | | |

In a further embodiment of a white OLED, several different-colored OLEDs are stacked one on top of another (stacked device). For the stacking of two OLEDs, what is called a charge generation layer (CG layer) is used. This CG layer may be formed, for example, from one electrically n-doped and one electrically p-doped transport layer. The expression "stacked OLED" and suitable embodiments are known to those skilled in the art.

It is possible to stack only two OLEDs or to stack more than three OLEDs ("stacked device concept"). These devices may use a transparent charge generating interlayer such as indium tin oxide (ITO), V₂O₅, or an organic p-n junction.

The stacked OLED (SOLED) includes at least two individual sub-elements. Each sub-element emits white light.

Each sub-element comprises at least three layers: an electron transporting layer, an emitting layer (e), comprising the first emitting layer (e1) and the second emitting layer (e2) and a hole transporting layer. Additional layers may be added to a sub-element. Each SOLED sub-element may include a hole injection layer, a hole transport layer, an electron/exciton blocking layer, an emissive layer (e), a hole/exciton blocking layer, an electron transport layer, an electron injection layer. Each SOLED sub-element may have the same layer structure or different layer structure from the other sub-elements.

Charge-generating layers separate the sub-elements of the SOLED. The charge-generating layers are layers that injects charge carriers into the adjacent layer(s) but do not have a direct external connection. Each of the charge-generating layers may be composed of the same material(s), or many have different compositions. When a voltage is applied across the SOLED having a charge-generating layer, the charge-generating layer may inject holes into the organic phosphorescent sub-element on the cathode side of the charge-generating layer, and electrons into the organic phosphorescent sub-element on the anode side. As will be understood by one skilled in the art, the "anode side" of a layer or device refers to the side of the layer or device at which holes are expected to enter the layer or device. Similarly, a "cathode side" refers to the side of the layer or device to which electrons are expected to enter the layer or device.

Each charge-generating layer may be formed by the contact of doped n-type (Li, Cs, Mg, etc. doped) layer with a p-type (metal oxides, F₄-TCNQ, etc.) layer. In preferred embodiments, the doped n-type layer may be selected from an alkali metal or alkaline earth metal doped organic layer, such as Li doped BCP or Mg doped Alq₃, with Li doped BCP being preferred. In other preferred embodiments, the charge-generating layers comprise an inorganic material selected from stable metal oxides, including MoO₃, V₂O₅, ITO, TiO₂, WO₃ and SnO₂. In other preferred embodiments of the invention, the charge-generating layers employ a layer of MoO₃ or V₂O₅, with MoO₃ being most preferred. The currently preferred solution is an organic n-doped electron transport layer (ETL) (NDN-26 (Novaled): NET-18 (Novaled)) connected with an organic p-doped hole transport layer (HTL) (NDP-9 (Novaled):α-NPD or NPD-9:Spiro-TAD (2,2',7,7'-tetrakis(N,N-diphenylamino)-9,9'-spirobifluoren), or an metal (e.g. Li) n-doped ETL connected with an acceptor layer (e.g. HAT-CN (hexaazatriphenylen-carbonitrile, LGChem)).

The device architecture of a SOLED including two individual sub-elements is exemplified below:
(a) an anode,
(b) optionally a hole injection layer,
(c) optionally a hole transport layer,
(d) optionally an exciton blocking layer
(e1) a first light-emitting layer,
(e2) a second light-emitting layer,
(f) optionally a hole/ exciton blocking layer
(g) optionally an electron transport layer,
(h) optionally an electron injection layer, and
   charge-generating layer
(b') optionally a hole injection layer,
(c') optionally a hole transport layer,
(d') optionally an exciton blocking layer
(e1') a first light-emitting layer,
(e2') a second light-emitting layer,
(f') optionally a hole/ exciton blocking layer
(g') optionally an electron transport layer,
(h') optionally an electron injection layer,
(I) a cathode.

For the individual layers and the materials used in the SOLED the same preferences apply as described above with reference to the white organic light emitting device.

In addition, the present invention is dirtected to an emitting layer (e), comprising
(e1) a first light-emitting layer and
(e2) a second light-emitting layer, wherein
the first light-emitting layer is in direct contact with the second light-emitting layer,
the first light-emitting layer comprises a phosphorescent red emitter and a first host compound, and
the second light-emitting layer comprises a phosphorescent blue emitter, a phosphorescent green emitter and a second host compound; and its use for generating white light.

With respect to the first light-emitting layer (e1), the second light-emitting layer (e2), the phosphorescent red emitter, the first host compound, the phosphorescent blue emitter, the phosphorescent green emitter and the second host compound the same preferences apply as described above with reference to the white organic light emitting device.

The inventive OLED can be produced by methods known to those skilled in the art. In general, the inventive OLED is produced by successive vapor deposition of the individual layers onto a suitable substrate. Suitable substrates are, for example, glass, inorganic semiconductors or polymer films. For vapor deposition, it is possible to use customary techniques, such as thermal evaporation, chemical vapor deposition (CVD), physical vapor deposition (PVD) and others. In an alternative process, the organic layers of the OLED can be applied from solutions or dispersions in suitable solvents, employing coating techniques known to those skilled in the art.

The OLEDs can be used in all apparatus in which white electroluminescence is useful. Suitable devices are preferably selected from stationary and mobile visual display units and illumination units. Stationary visual display units are, for example, visual display units of computers, televisions, visual display units in printers, kitchen appliances and advertising panels, illuminations and information panels. Mobile visual display units are, for example, visual display units in cellphones, tablet PCs, laptops, digital cameras, MP3 players, vehicles and destination displays on buses and trains. Further apparatus in which the inventive OLEDs can be used are, for example, keyboards; items of clothing; furniture; wallpaper.

Accordingly, the present invention relates to an apparatus selected from the group consisting of stationary visual display units such as visual display units of computers, televisions, visual display units in printers, kitchen appliances and advertising panels, illuminations, information panels, and mobile visual display units such as visual display units in cellphones, tablet PCs, laptops, digital cameras, MP3 players, vehicles and destination displays on buses and trains; illumination units; keyboards; items of clothing; furniture; wallpaper, comprising at least one inventive organic light-emitting device, or emitting layer.

The following examples are included for illustrative purposes only and do not limit the scope of the claims. Unless otherwise stated, all parts and percentages are by weight.

### Examples

The examples which follow, more particularly the methods, materials, conditions, process parameters, apparatus and the like detailed in the examples, are intended to support the present invention, but not to restrict the scope of the present invention. All experiments are carried out in protective gas atmosphere. The percentages and ratios mentioned in the examples below - unless stated otherwise - are % by weight and weight ratios.

### Comparative Application Example 1

The ITO substrate (ITO thickness 120nm, Product name OD-B01, purchased from Geomatec company) used as the anode is cleaned first with commercial detergents for LCD production (Deconex® 20NS, and 25ORGAN-ACID® neutralizing agent) and then in an acetone/isopropanol mixture in an ultrasound bath. To eliminate possible organic residues, the substrate is exposed to a continuous ozone atmosphere in an ozone oven for a further 25 minutes. This treatment also improves the hole injection properties of the ITO. Next, the hole injection layer AJ20-1000 from Plexcore is spun on from solution.

After the hole injection layer, the organic materials specified hereinafter are applied to the cleaned substrate by vapor deposition at a rate of approx. 0.5-5 nm/min at about 10⁻⁷-10⁻⁹ mbar. The hole transport and exciton blocker material applied to the substrate is HTM-1 (Ir(DPBIC)₃) with a thickness of 20 nm, of which the first 10 nm have been doped with 10% MoO₃ to improve the conductivity.

Subsequently, a blue and a red emitting layer are applied by vapor deposition.

The blue emitting layer comprises a mixture of the materials **BE-1** (20 %), **SH-2** (75 %) and **HTM-1** (5 %). The thickness of the blue emitting layer is 40 nm.

The red emitting layer comprises a mixture of the materials **RE-2 (1** %) and **SH-2** (99 %). The thickness of the red emitting layer is 40 nm.

Subsequently, the material **SH-2** is applied with a layer thickness of 5 nm as a hole and exciton blocker. The subsequent electron transport layer used is a mixture of material **ETM-1** (50 %) and **Liq** (50 %) with a layer thickness of 35 nm. KF is applied with a layer thickness of 4 nm as an electron injection layer. An aluminum cathode of thickness 100 nm concludes the diode.

### Comparative Application Example 2

Comparative Application Example 1 is repeated except that first the red emitting layer and then the blue emitting layer is applied and **HTM-1** is used instead of **SH-2** as host.

### Comparative Application Example 3

The ITO substrate (ITO thickness 120nm, Product name OD-B01, purchased from Geomatec company) used as the anode is cleaned first with commercial detergents for LCD production (Deconex® 20NS, and 25ORGAN-ACID® neutralizing agent) and then in an acetone/isopropanol mixture in an ultrasound bath. To eliminate possible organic residues, the substrate is exposed to a continuous ozone atmosphere in an ozone oven for a further 25 minutes. This treatment also improves the hole injection properties of the ITO. Next, the hole injection layer AJ20-1000 from Plexcore is spun on from solution.

After the hole injection layer, the organic materials specified hereinafter are applied to the cleaned substrate by vapor deposition at a rate of approx. 0.5-5 nm/min at about 10⁻⁷-10⁻⁹ mbar. The hole transport and exciton blocker material applied to the substrate is HTM-1 with a thickness of 20 nm, of which the first 10 nm have been doped with 10% MoOₓ to improve the conductivity.

Subsequently, a red, a green and a blue emitting layer are applied in this order by vapor deposition.
The red emitting layer comprises a mixture of the materials **RE-2** (1 %) and **HTM-1** (99 %). The thickness of the red emitting layer is 10 nm.
The green emitting layer comprises a mixture of the materials **GE-1** (10 %) and **HTM-1** (90 %). The thickness of the green emitting layer is 10 nm.
The blue emitting layer comprises a mixture of the materials **BE-1** (20 %), **SH-2** (75 %) and **HTM-1** (5 %). The thickness of the blue emitting layer is 40 nm.

Subsequently, the material **SH-2** is applied with a layer thickness of 5 nm as a hole and exciton blocker. The subsequent electron transport layer used is a mixture of material **ETM-1** (50 %) and **Liq** (50 %) with a layer thickness of 35 nm. KF is applied with a layer thickness of 4 nm as an electron injection layer. An aluminum cathode of thickness 100 nm concludes the diode.

### Application Example 1

The ITO substrate (ITO thickness 120nm, Product name OD-B01, purchased from Geomatec company) used as the anode is cleaned first with commercial detergents for LCD production (Deconex® 20NS, and 25ORGAN-ACID® neutralizing agent) and then in an acetone/isopropanol mixture in an ultrasound bath. To eliminate possible organic residues, the substrate is exposed to a continuous ozone atmosphere in an ozone oven for a further 25 minutes. This treatment also improves the hole injection properties of the ITO. Next, the hole injection layer AJ20-1000 from Plexcore is spun on from solution.

After the hole injection layer, the organic materials specified hereinafter are applied to the cleaned substrate by vapor deposition at a rate of approx. 0.5-5 nm/min at about 10⁻⁷-10⁻⁹ mbar. The hole transport and exciton blocker material applied to the substrate is **HTM-1** with a thickness of 20 nm, of which the first 10 nm have been doped with 10% MoOₓ to improve the conductivity.

Subsequently, a first (red) and a second (blue/green) emitting layer are applied in this order by vapor deposition.
The first (red) emitting layer comprises a mixture of the materials **RE-2** (0.5 %) and **HTM-1** (99.5 %). The thickness of the red emitting layer is 10 nm.
The second (blue/green) emitting layer comprises a mixture of the materials **BE-1** (20 %), **GE-1** (0.5 %) and **SH-2** (79.5 %). The thickness of the blue emitting layer is 40 nm.

Subsequently, the material **SH-2** is applied with a layer thickness of 5 nm as a hole and exciton blocker. The subsequent electron transport layer used is a mixture of material **ETM-1** (50 %) and **Liq** (50 %) with a layer thickness of 35 nm. **KF** is applied with a layer thickness of 4 nm as an electron injection layer. An aluminum cathode of thickness 100 nm concludes the diode.

### Application Example 2

The ITO substrate (ITO thickness 120nm, Product name OD-B01, purchased from Geomatec company) used as the anode is cleaned first with commercial detergents for LCD production (Deconex® 20NS, and 25ORGAN-ACID® neutralizing agent) and then in an acetone/isopropanol mixture in an ultrasound bath. To eliminate possible organic residues, the substrate is exposed to a continuous ozone atmosphere in an ozone oven for a further 25 minutes. This treatment also improves the hole injection properties of the ITO. Next, the hole injection layer AJ20-1000 from Plexcore is spun on from solution. After the hole injection layer, the organic materials specified hereinafter are applied to the cleaned substrate by vapor deposition at a rate of approx. 0.5-5 nm/min at about 10⁻⁷-10⁻⁹ mbar. The hole transport and exciton blocker material applied to the substrate is **HTM-2** with a thickness of 20 nm, of which the first 10 nm have been doped with 10% MoOₓ to improve the conductivity. Subsequently, a first (red) and a second (blue/green) emitting layer are applied in this order by vapor deposition. The first (red) emitting layer comprises a mixture of the materials **RE-2** (1.0 %) and **HTM-2** (99.0 %). The thickness of the red emitting layer is 10 nm. The second (blue/green) emitting layer comprises a mixture of the materials **BE-1** (20 %), **GE-1** (0.5 %) and **SH-2** (79.5 %). The thickness of the blue emitting layer is 40 nm. Subsequently, the material **SH-2** is applied with a layer thickness of 5 nm as a hole and exciton blocker. The subsequent electron transport layer used is a mixture of material **ETM-1** (50 %) and **Liq** (50 %) with a layer thickness of 35 nm. KF is applied with a layer thickness of 4 nm as an electron injection layer. An aluminum cathode of thickness 100 nm concludes the diode.

To characterize the OLED, electroluminescence spectra are recorded at various currents and voltages. In addition, the current-voltage characteristic is measured in combination with the light output emitted. The light output can be converted to photometric parameters by calibration with a photometer. To determine the lifetime, the OLED is operated at a constant current density and the decrease in the light output is recorded. The lifetime is defined as that time which lapses until the luminance decreases to half of the initial luminance. Voltage (V), current efficiency (cd/A), efficacy (Im/W), External Quantum Efficiency (EQE) (%), Correlated Color Temperature (CCT; K) and lifetime (h) measured for the devices of the Application Examples and Comparative Application Examples at 1000 nits are shown in the Table 1 below, wherein the measured values of voltage, current efficiency, efficacy, EQE and lifetime of the device of Comparative Application Example 1 are set to 100 and the values of the devices of Comparative Application Examples 2 and 3 and Application Examples 1 and 2 are specified in relation to those of the device of Comparative Application Example 1.

**Table 1**

| **Device** | **Relative Voltage (%)** | **Rel. Cur. Efficiency (%)** | **Relative Efficacy (%)** | **Relative EOE¹⁾ (%)** | **CCT (K)** | **Relative Lifetime²⁾ (%)** | **Colour** |
|---|---|---|---|---|---|---|---|
| **Comp. Appl. Ex. 1** | 100 | 100 | 100 | 100 | - | 100 | Light Blue |
| **Comp. Appl. Ex. 2** | 62 | 100 | 164 | 125 | 4160 | 85 | Natural White |
| **Comp. Appl. Ex. 3** | 60 | 208 | 349 | 157 | - | 85 | Green |
| **Appl. Ex. 1** | 64 | 143 | 224 | 131 | 3960 | 126 | Natural White |
| **Appl. Ex. 2** | 52 | 166 | 320 | 153 | 4020 | 396 | Natural White |

| | | | | | | | |
|---|---|---|---|---|---|---|---|
| ¹⁾ External quantum efficiency (EQE) is # a of generated photons escaped from a substance or a device / # of electrons flowing through it. ²⁾ Drop to 50% of initial luminance. | | | | | | | |

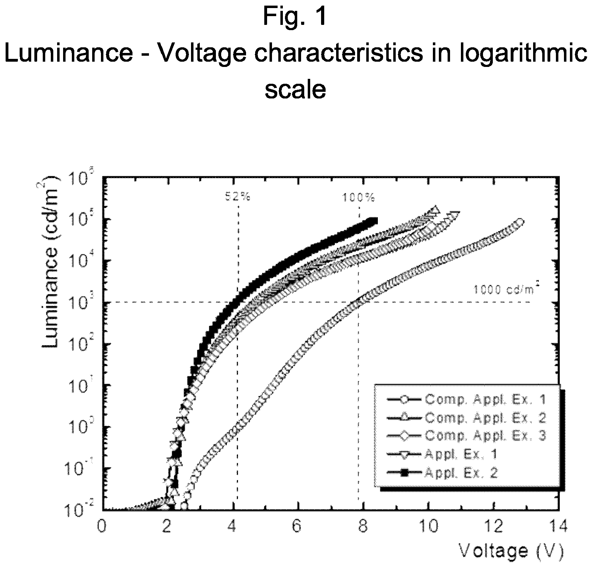

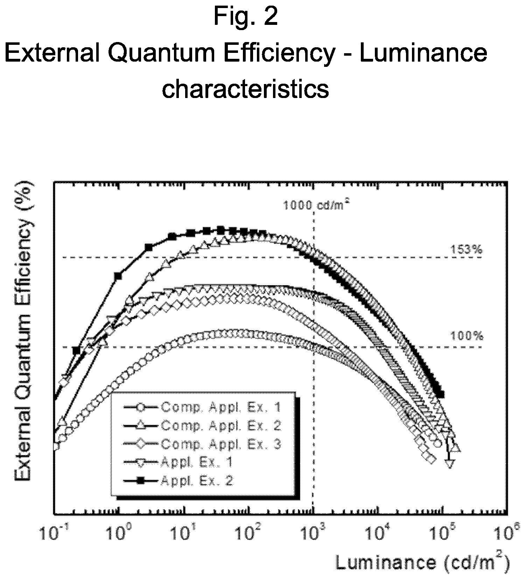

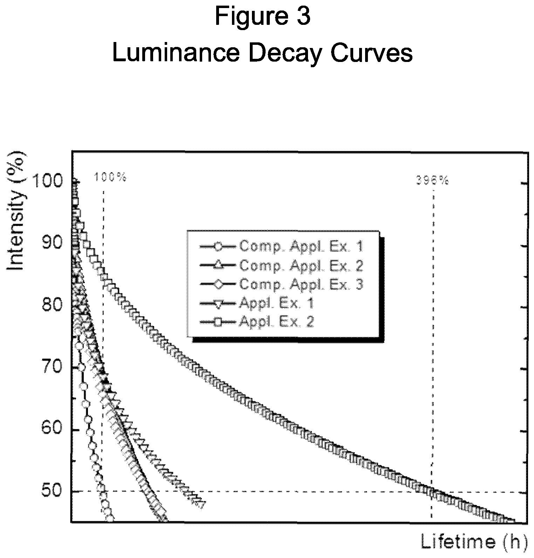

In comparison to the device of Comp. Appl. Ex. 2, which shows the desired natural white color, the devices of Appl. Ex. 1 and 2 show a reduced voltage (reduced power consumption), superior current efficiency, efficacy, EQE and lifetime. Reference is made to Fig. 1 to 3.

## Claims

1. An emitting layer (e) for generating white light, comprising (e1) a first light-emitting layer and (e2) a second light-emitting layer, wherein the first light-emitting layer is in direct contact with the second light-emitting layer, the first light-emitting layer comprises a phosphorescent red emitter and a first host compound, the second light-emitting layer comprises a phosphorescent blue emitter, a phosphorescent green emitter and a second host compound.

2. A white organic light-emitting device comprising
(a) an anode,
(i) a cathode,
(e) an emitting layer according to claim 1.

3. The organic light-emitting device according to claim 2, wherein the first light-emitting layer (e1) is disposed between the anode (a) and the second light-emitting layer (e2).

4. The organic light-emitting device according to claim 2 or 3, comprising in this order:
(a) an anode,
(b) optionally a hole injection layer,
(c) a hole transport layer,
(d) exciton blocking layer
(e) an emitting layer, comprising
(e1) a first light-emitting layer,
AO:AO
(e2) a second light-emitting layer,
(f) a hole/ exciton blocking layer
(g) an electron transport layer,
(h) optionally an electron injection layer, and
(i) a cathode.

5. The organic light-emitting device according to any of claims 2 to 4, wherein the phosphorescent red emitter is a compound of formula 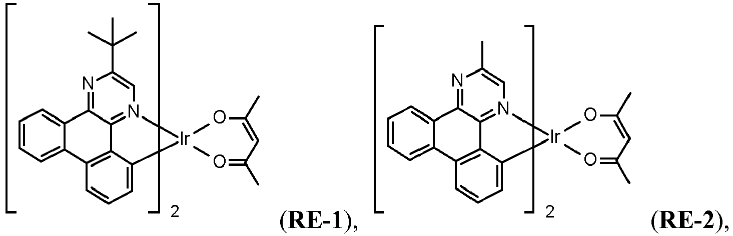 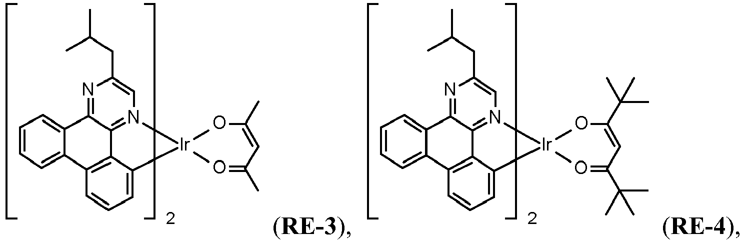 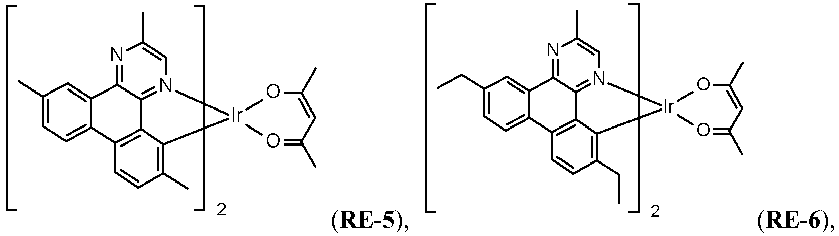 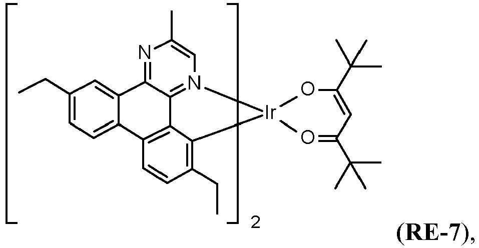 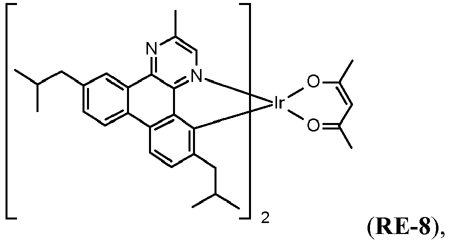 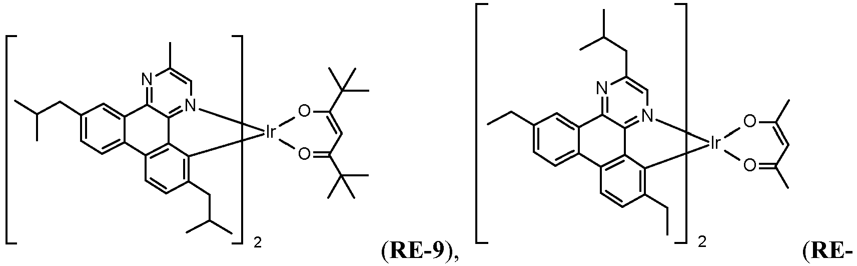 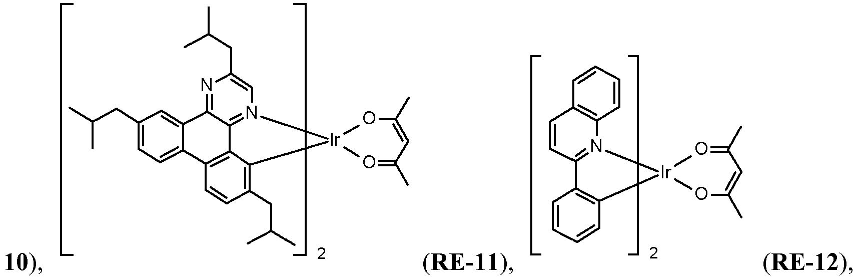 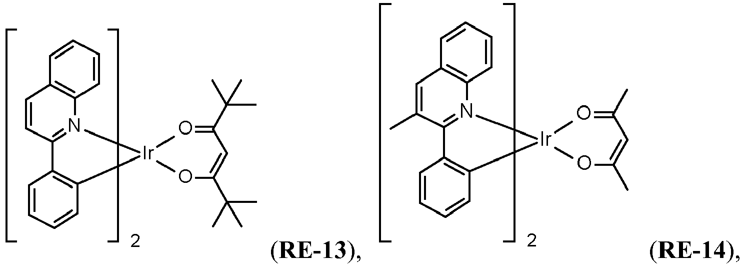 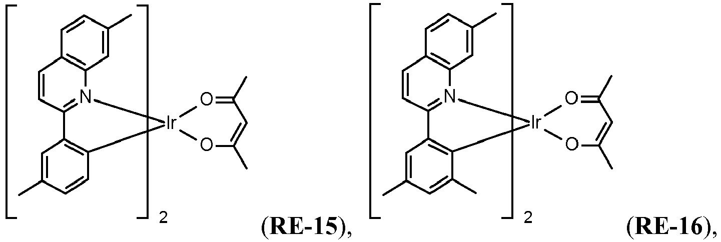 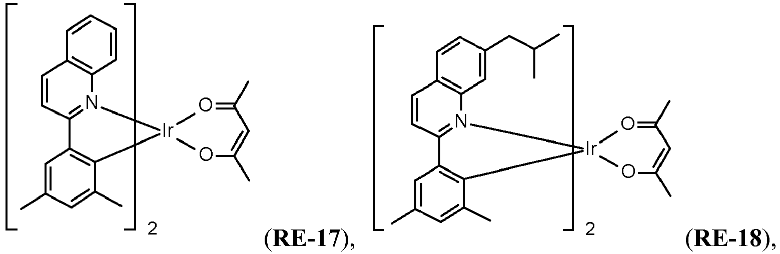 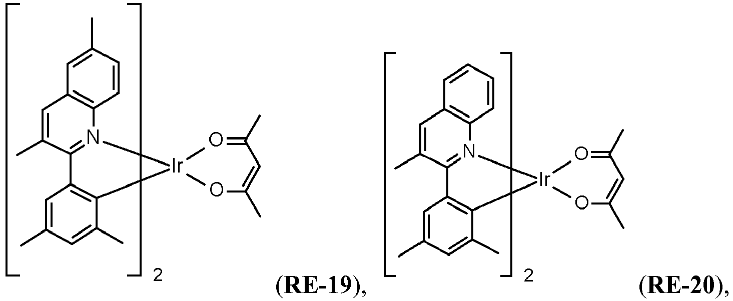 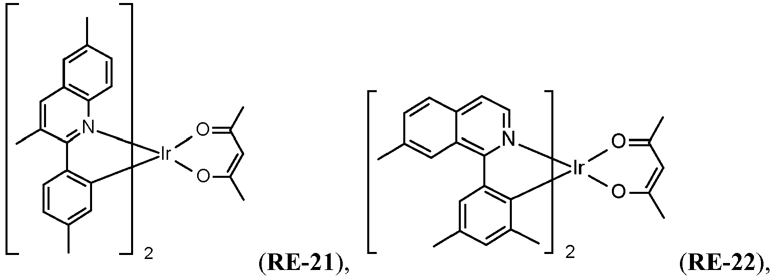 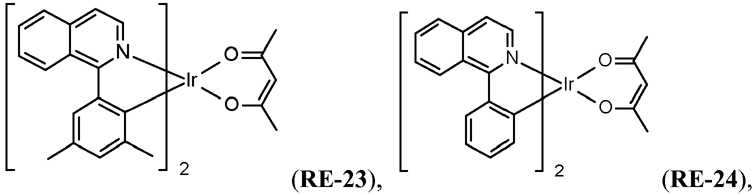 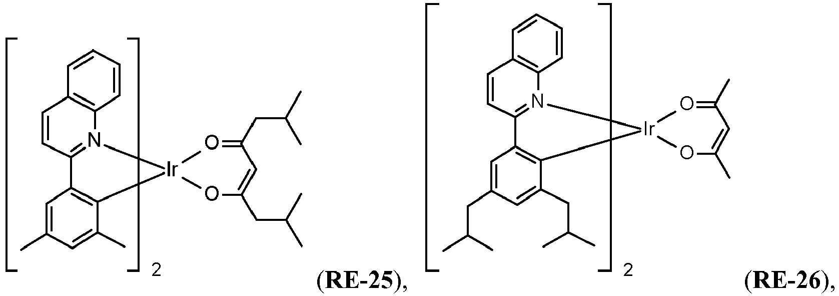 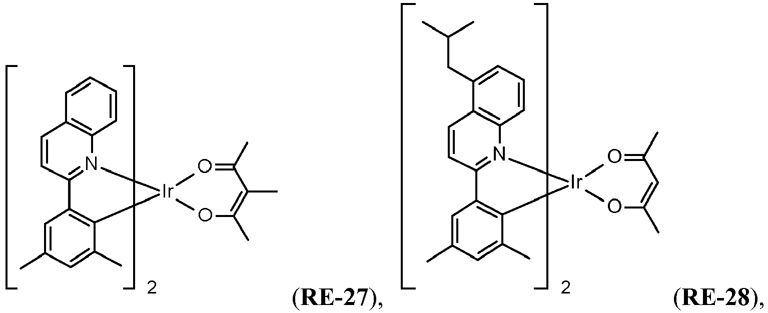 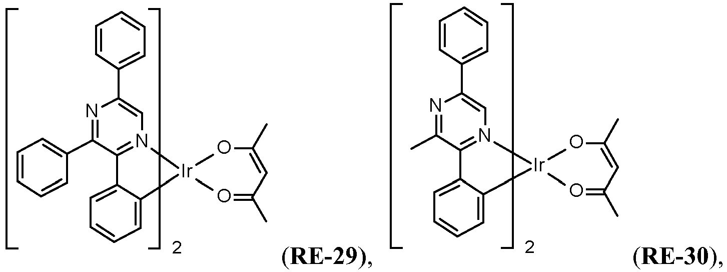 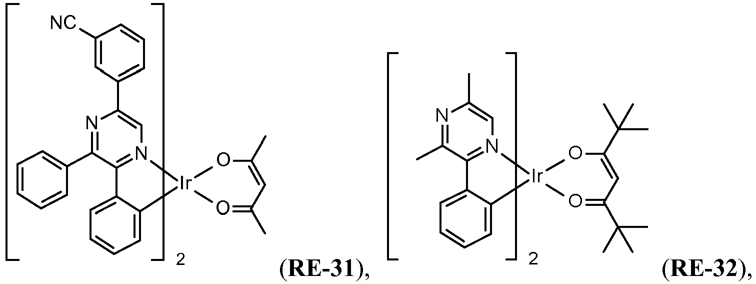 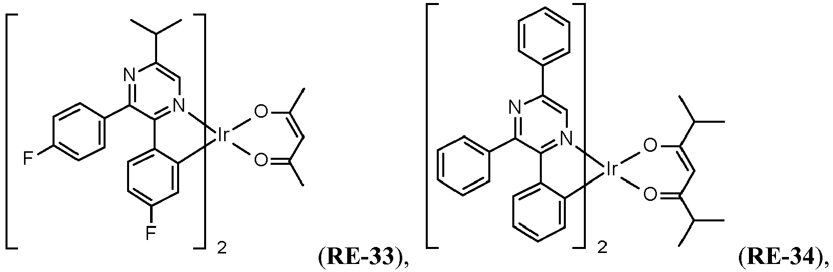 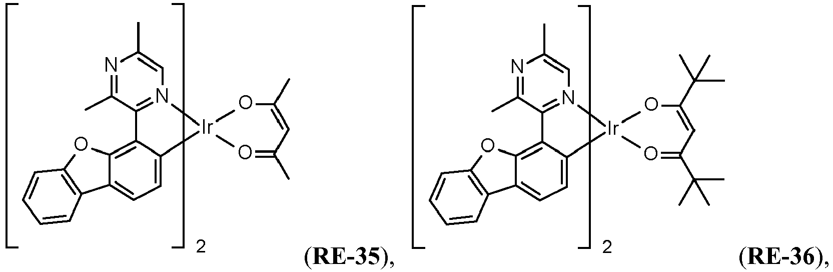 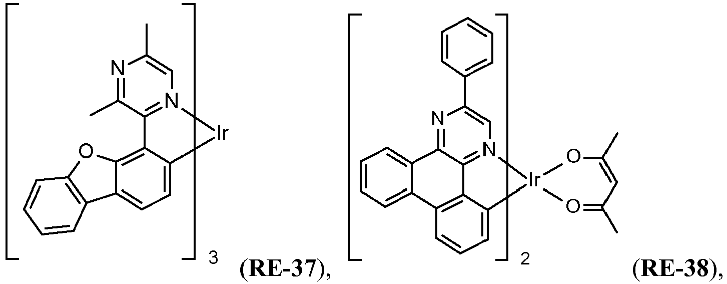 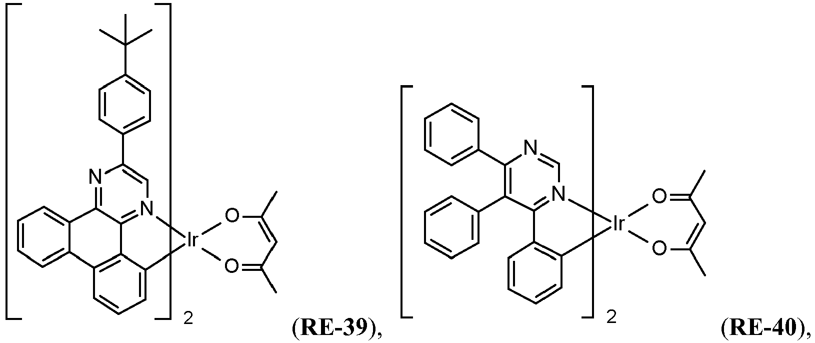 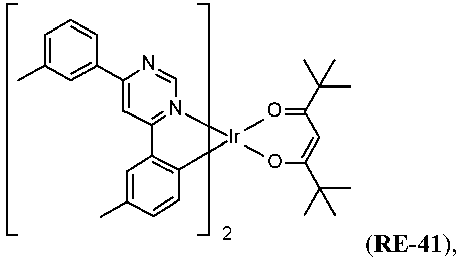 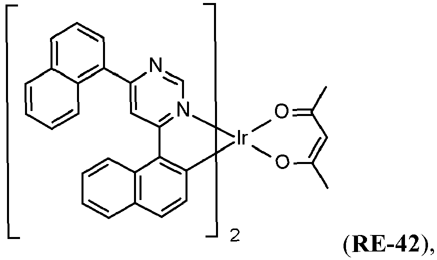 or

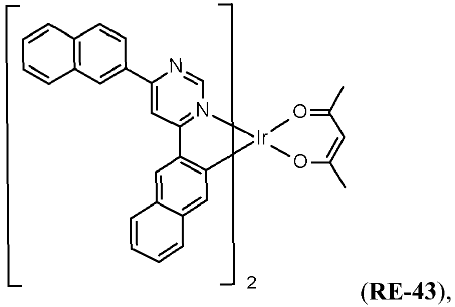

6. The organic light-emitting device according to claim 5, wherein the phosphorescent red emitter is a compound of formula

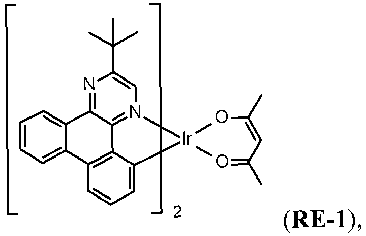

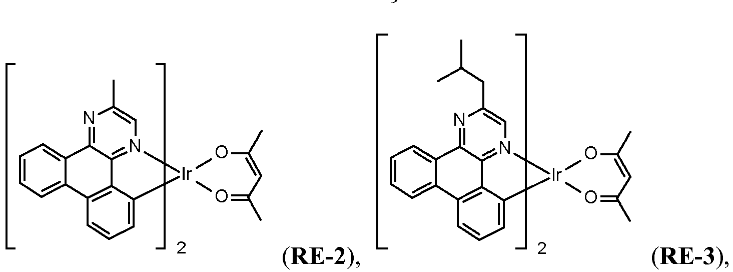

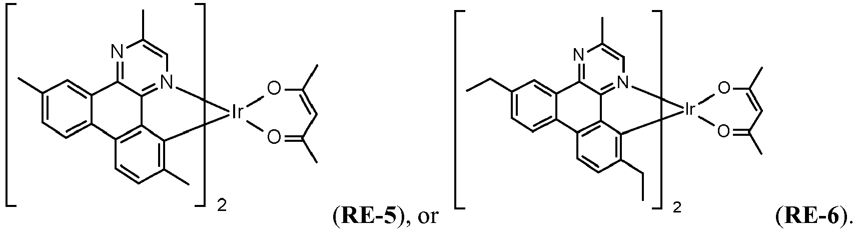

7. The organic light-emitting device according to any of claims 2 to 6, wherein the first host compound is a compound of formula 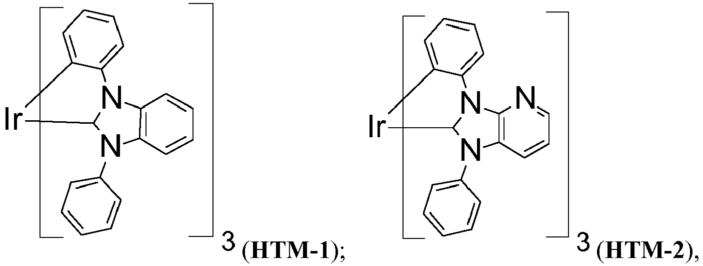 4,4'-bis[N-(1-naphthyl)-N-phenylamino]biphenyl (**FH-1**), or 4,4',4" -tris(N-carbazolyl)triphenylamine (**FH-2**),

8. The organic light-emitting device according to claim 7, wherein the first host compound is a compound of formula 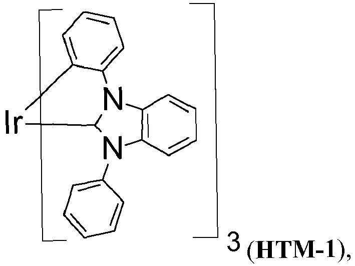 or

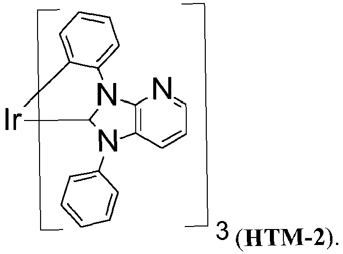

9. The organic light-emitting device according to any of claims 2 to 8, wherein the phosphorescent blue emitter is a compound of formula

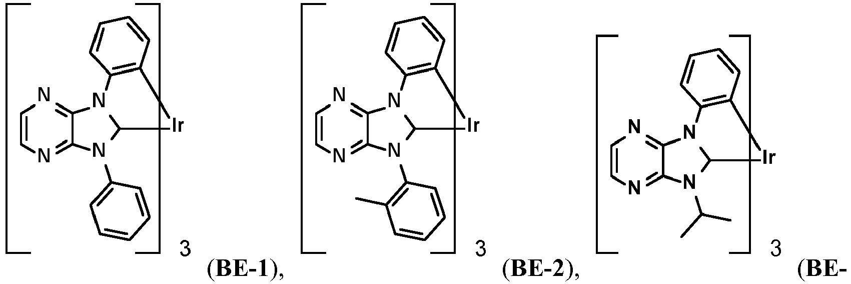

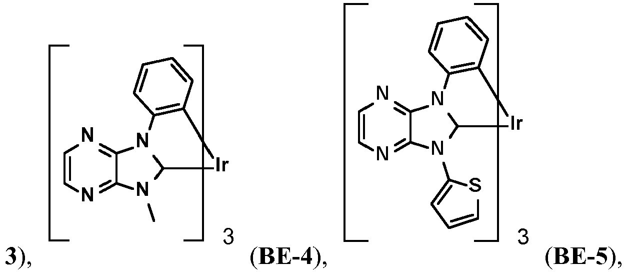

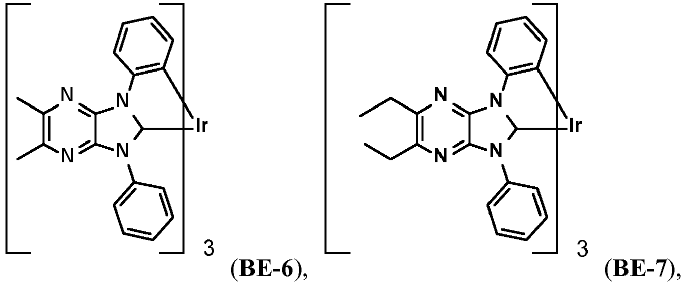

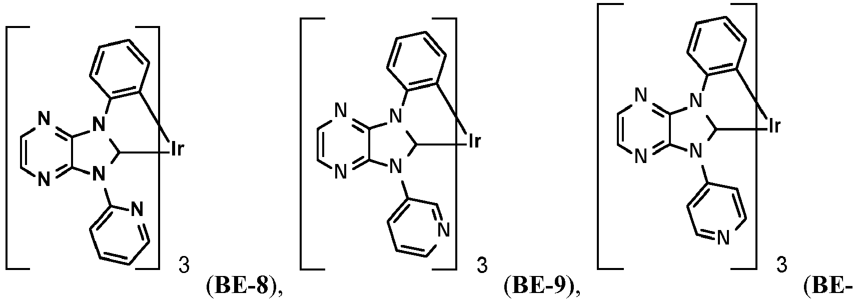

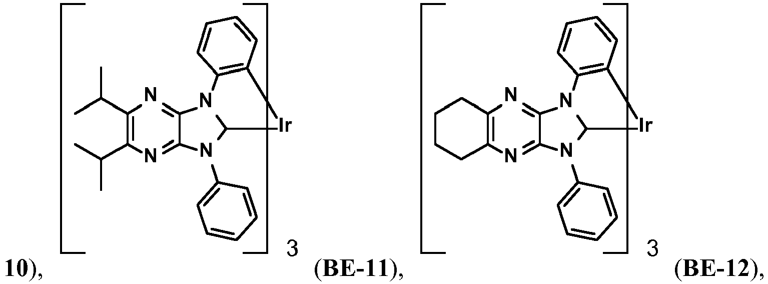

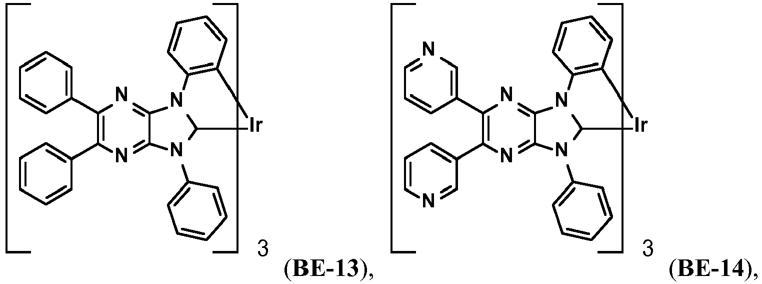

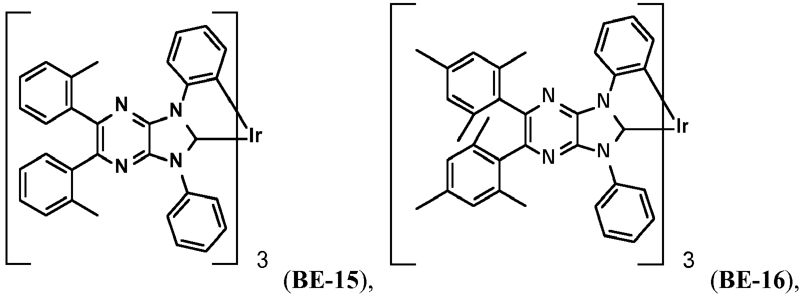

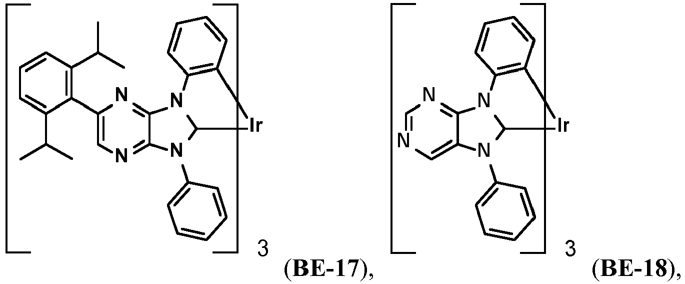

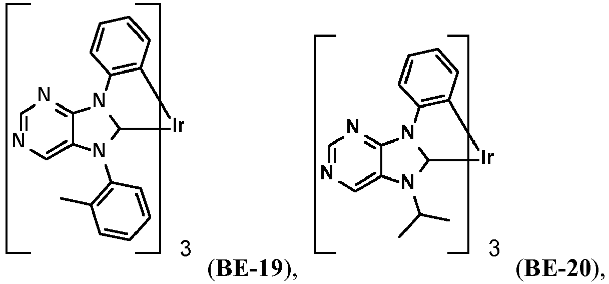

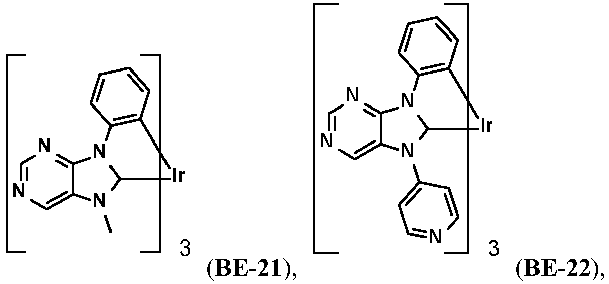

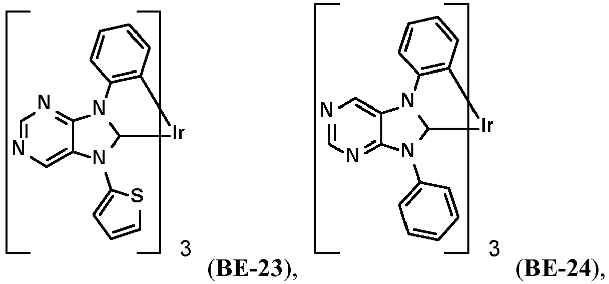

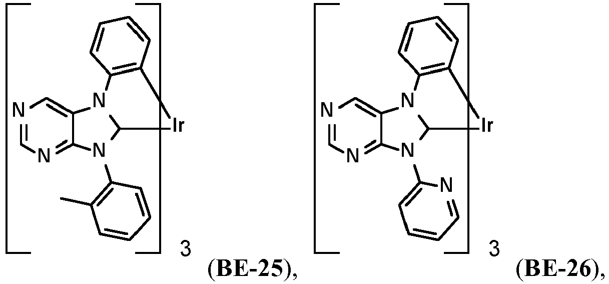

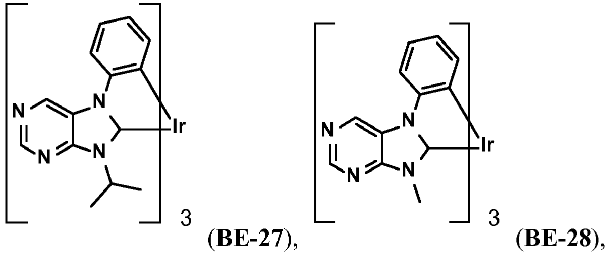

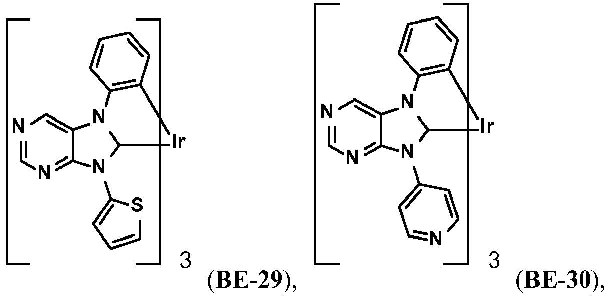

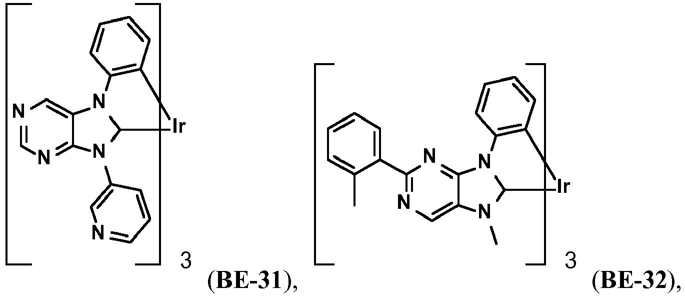

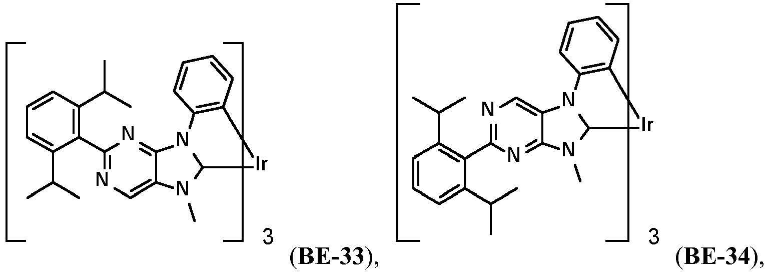

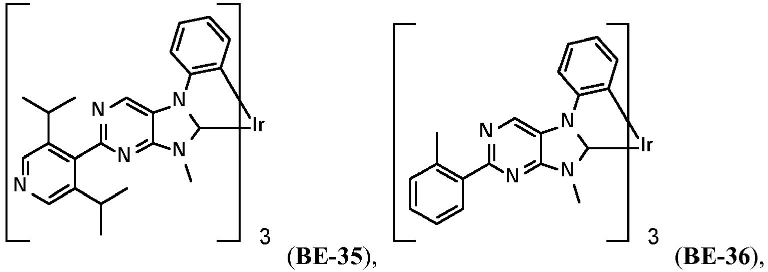

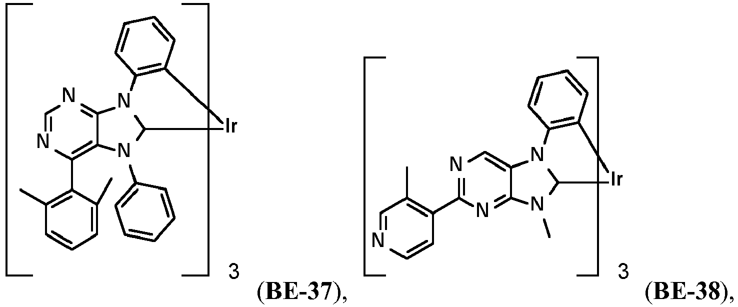

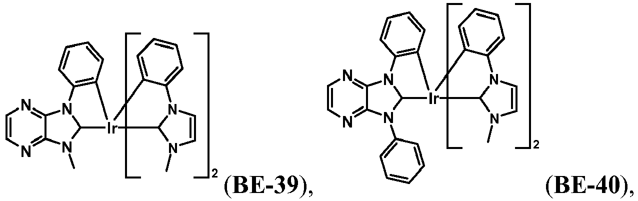

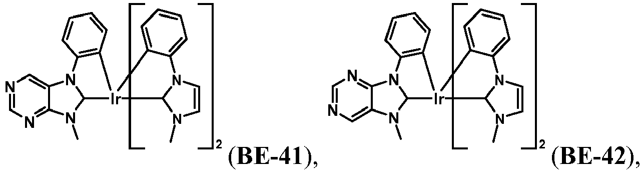

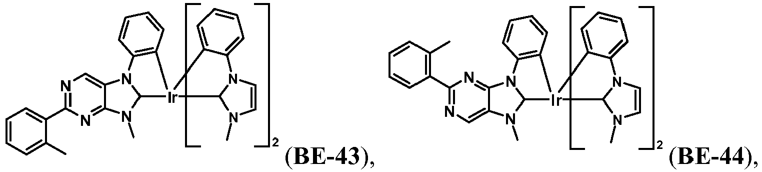

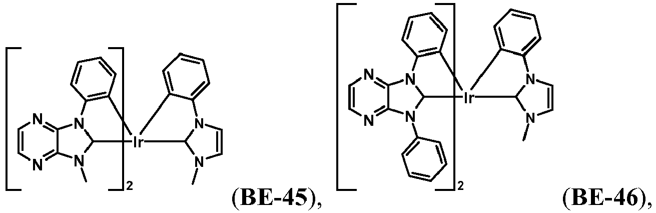

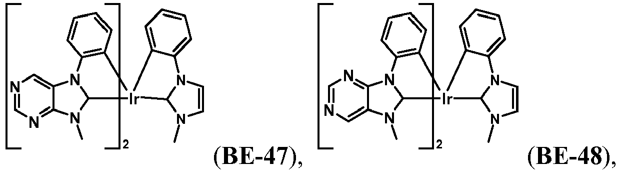

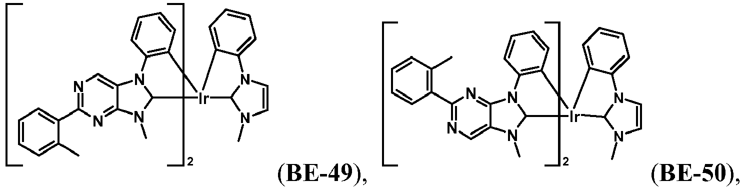

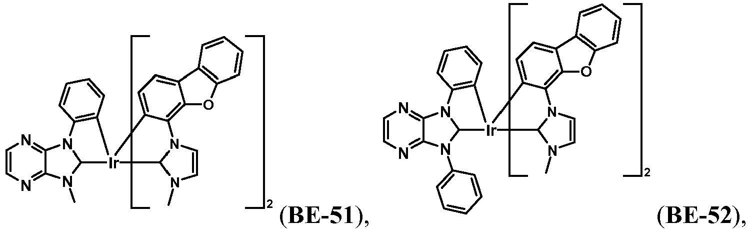

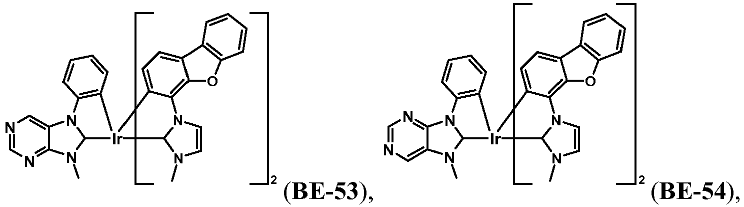

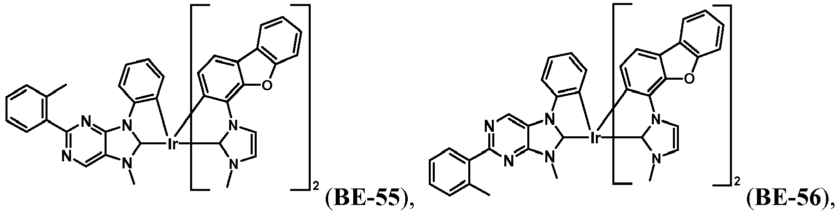

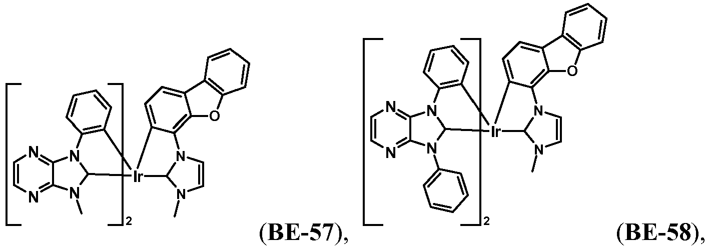

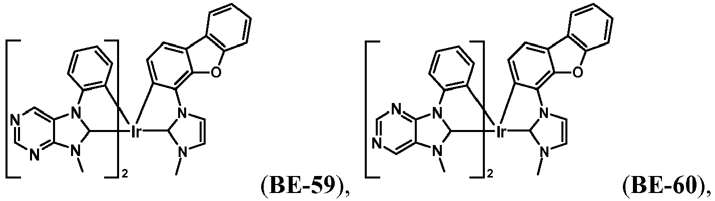

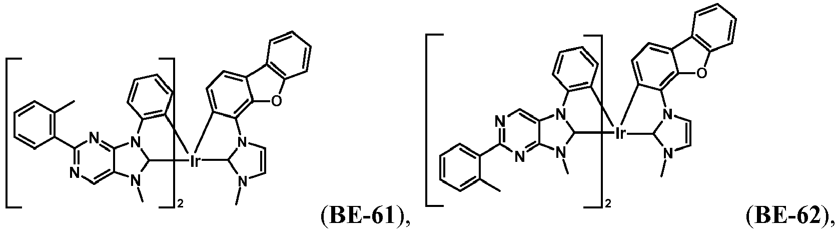

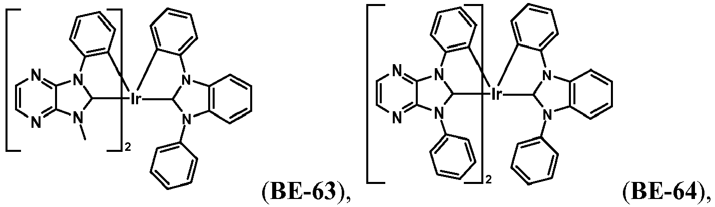

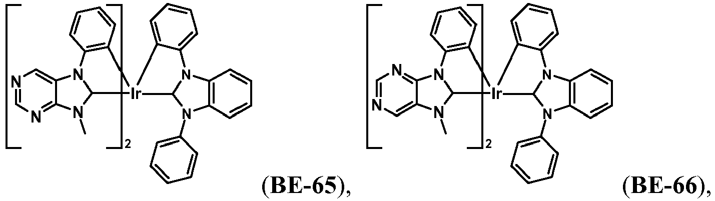

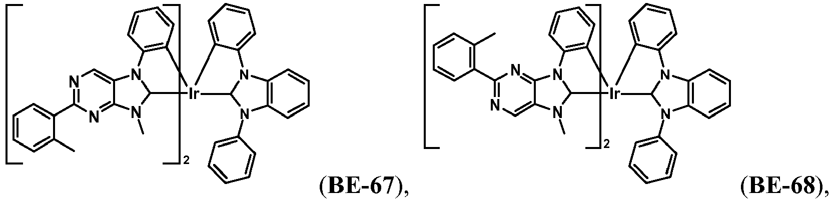

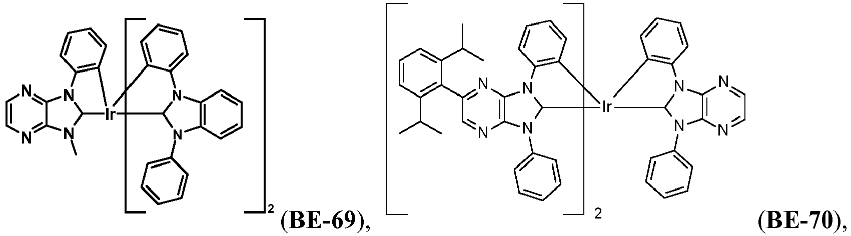

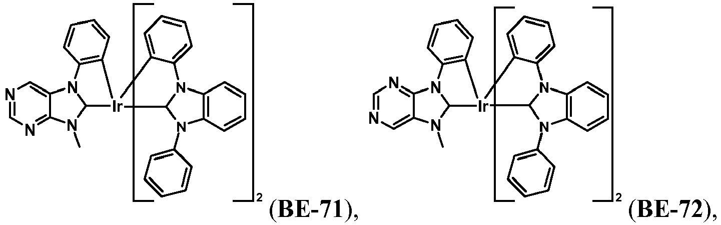

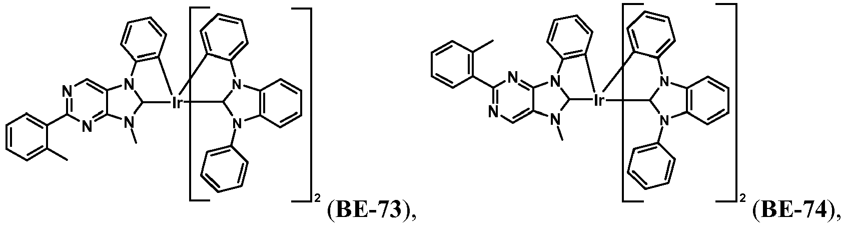

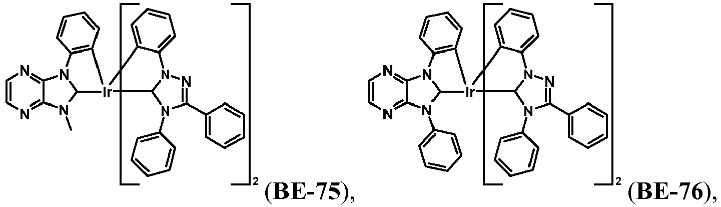

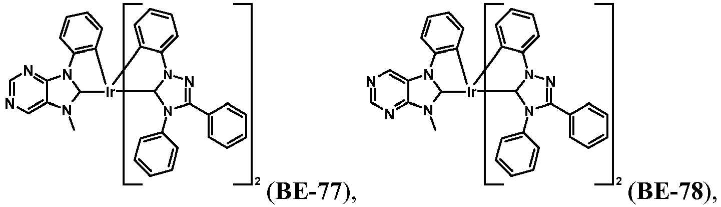

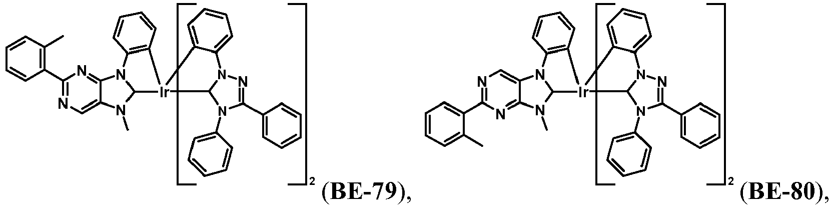

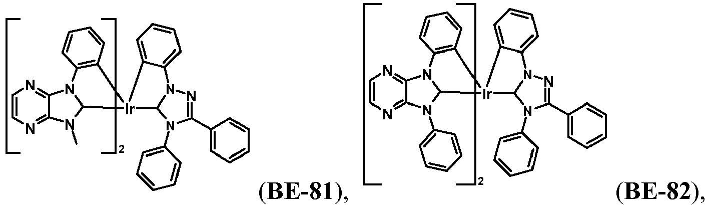

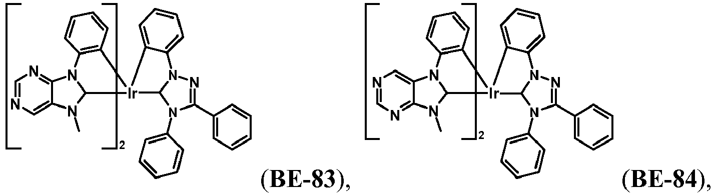

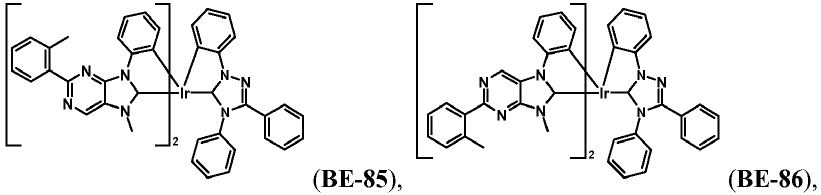

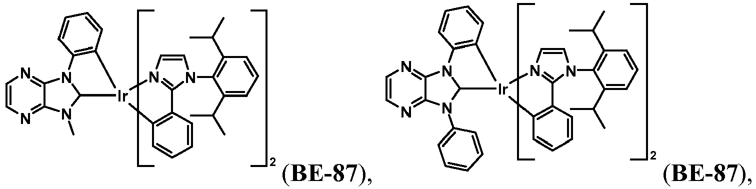

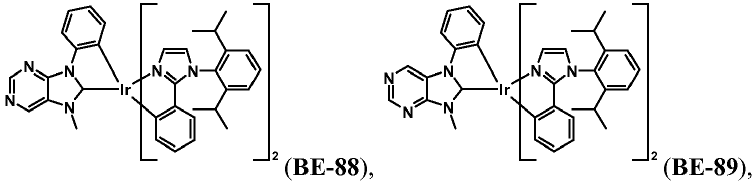

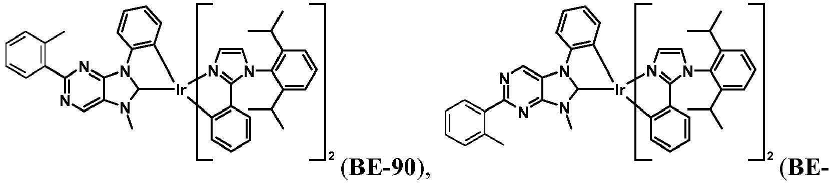

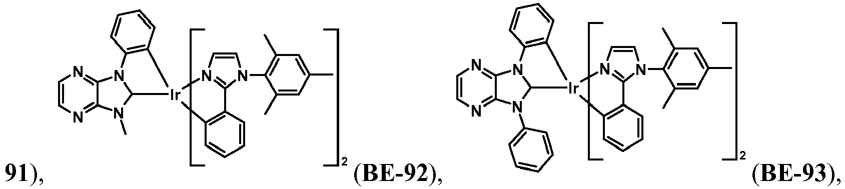

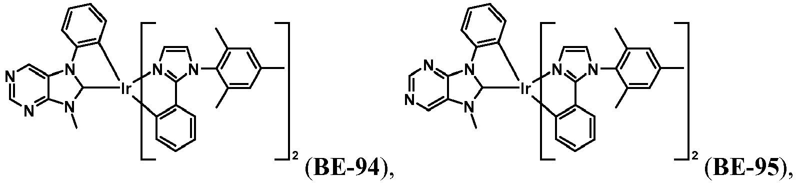

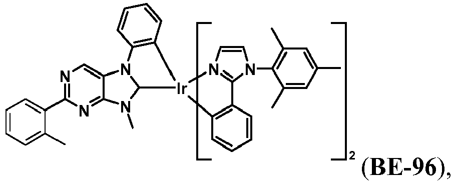

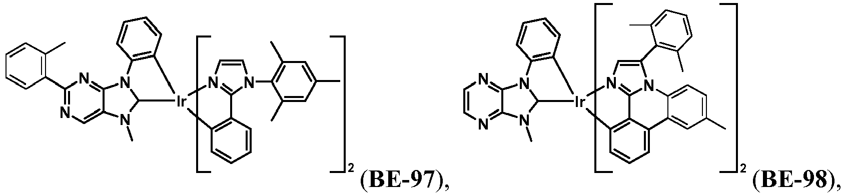

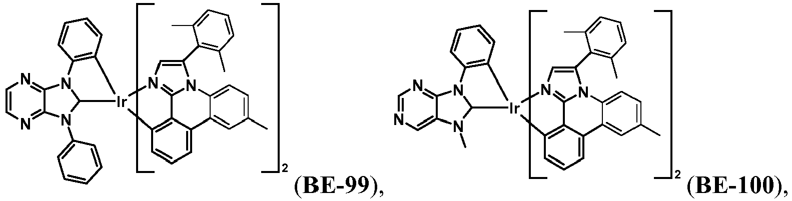

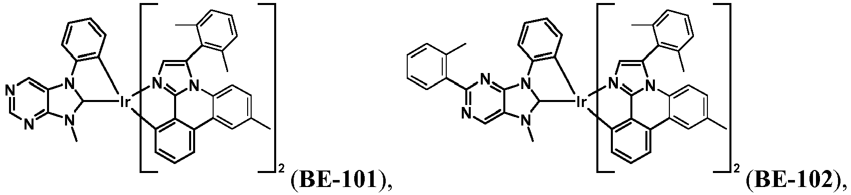

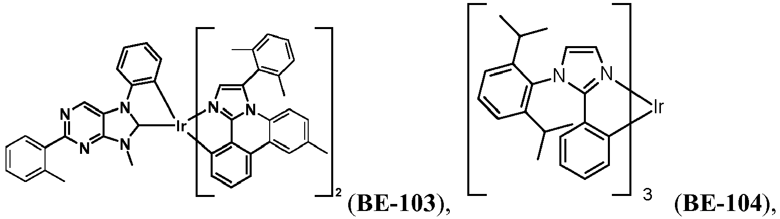

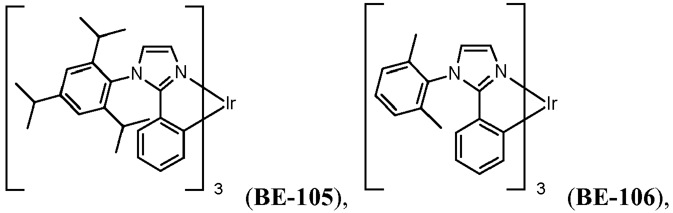

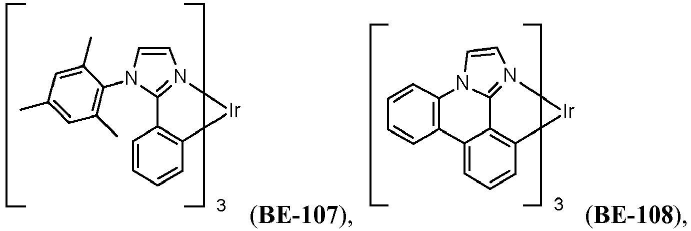

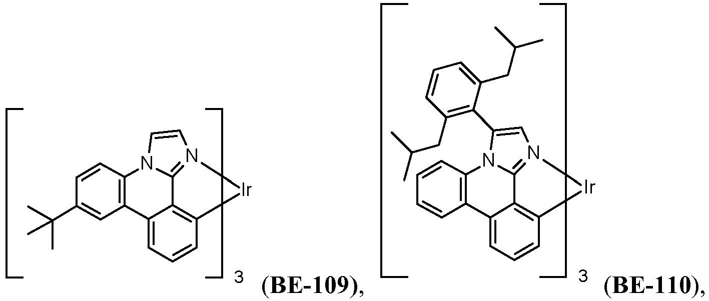

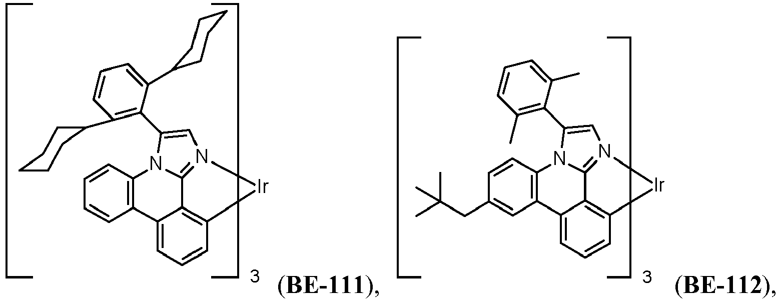

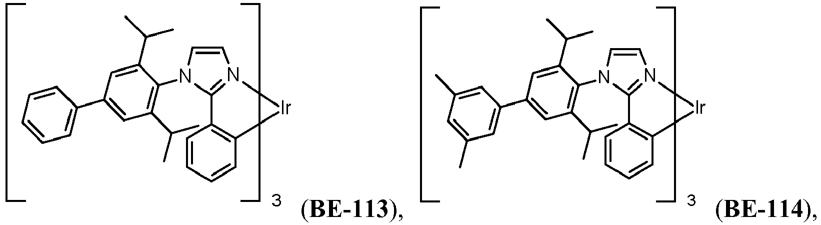

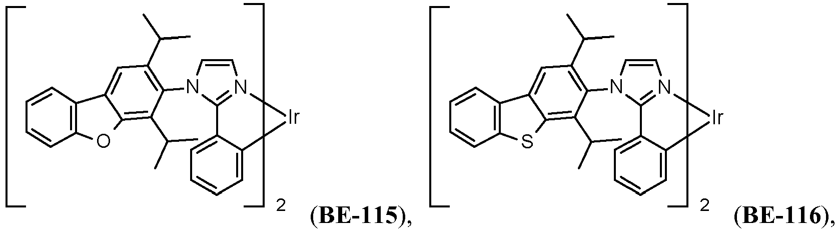

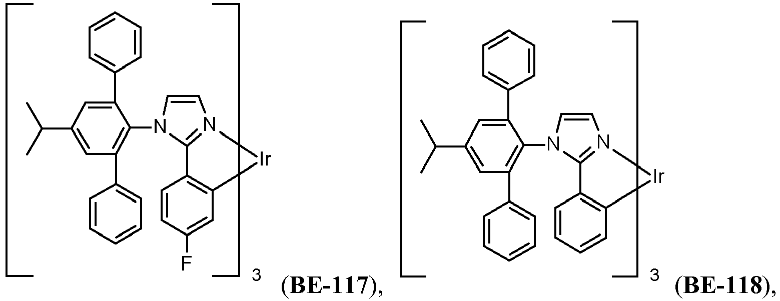

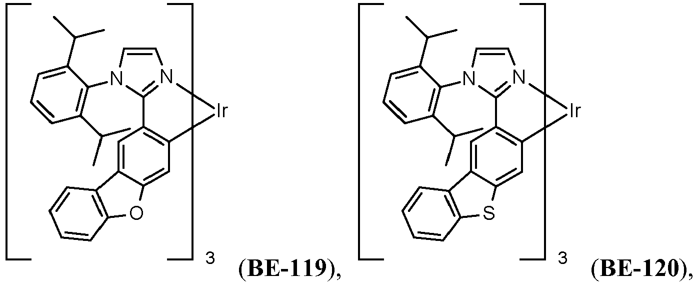

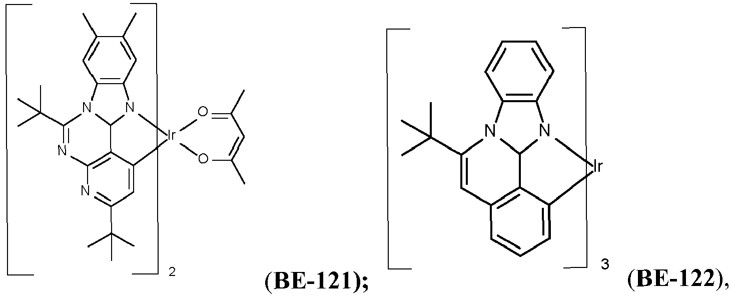

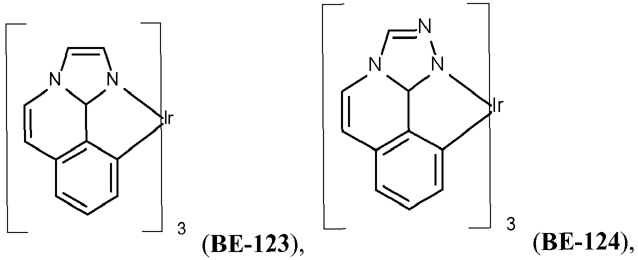

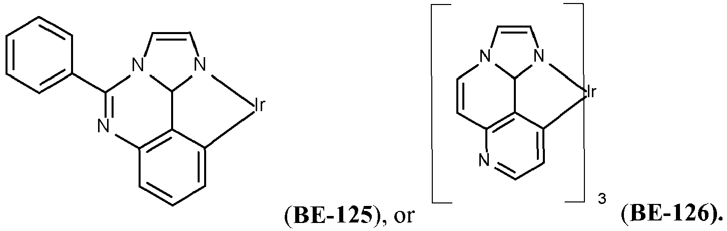

10. The organic light-emitting device according to any of claims 2 to 9 wherein the phosphorescent blue emitter is a compound of formula

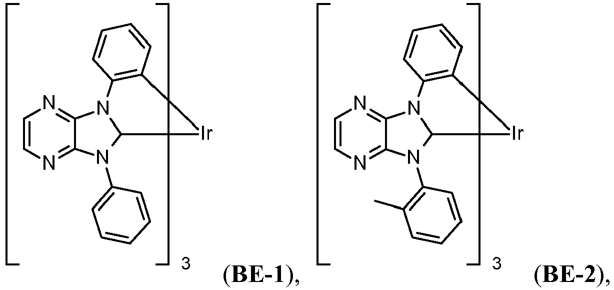

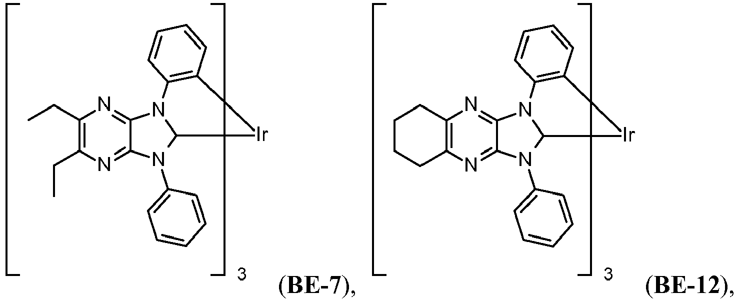

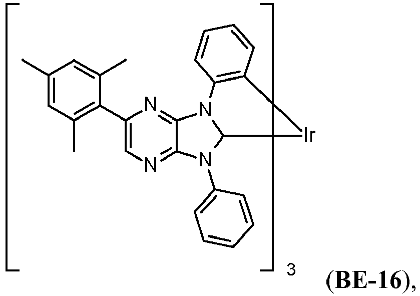

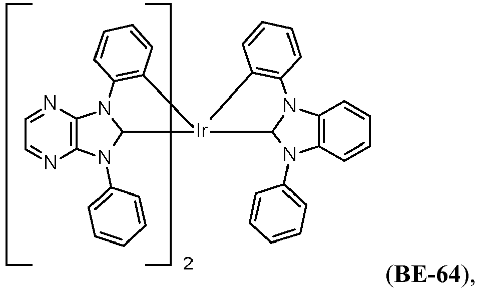

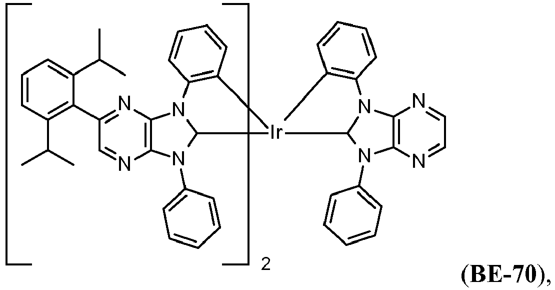

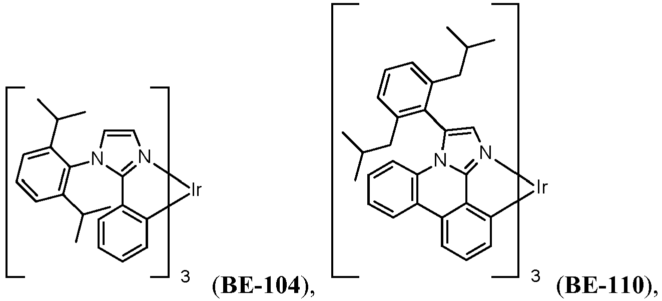

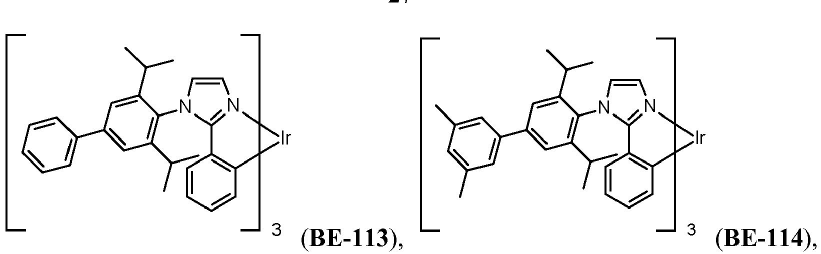

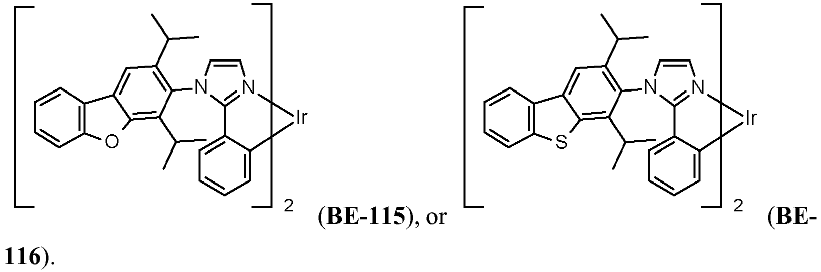

11. The organic light-emitting device according to any of claims 2 to 10, wherein the phosphorescent green emitter is a compound of

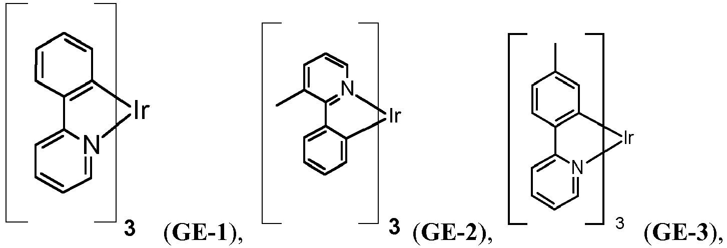

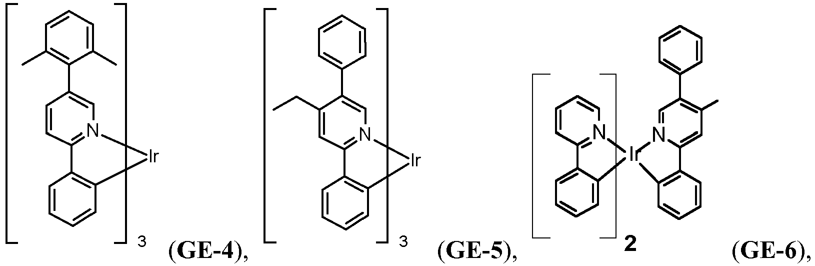

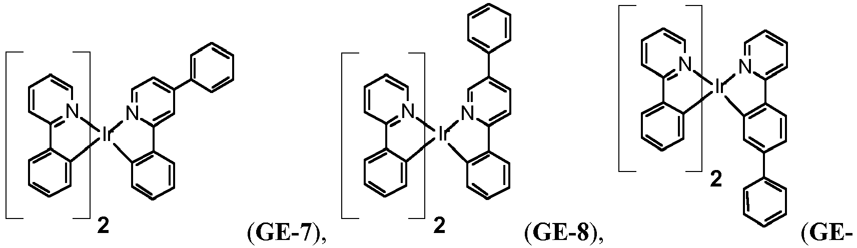

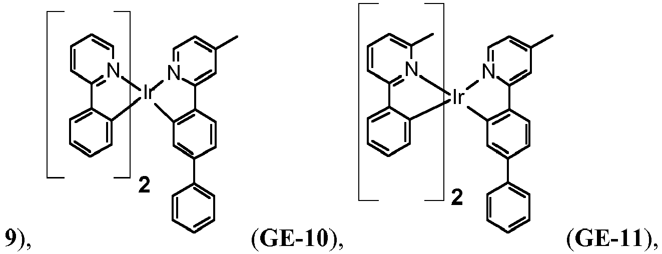

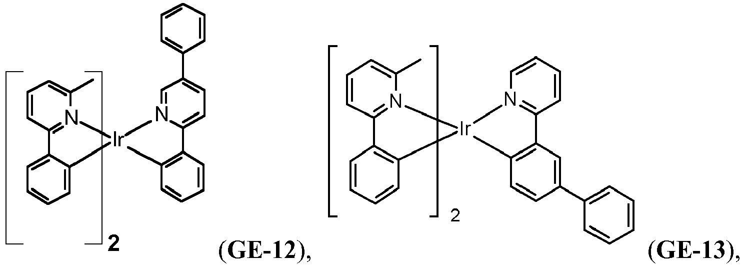

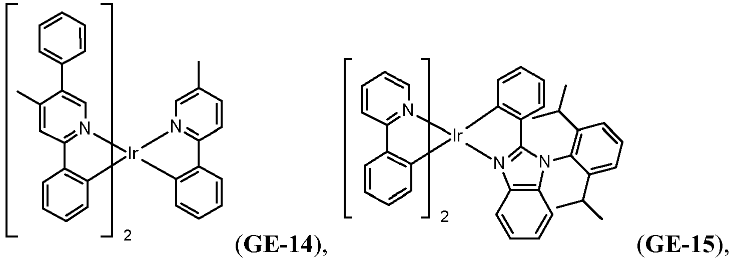

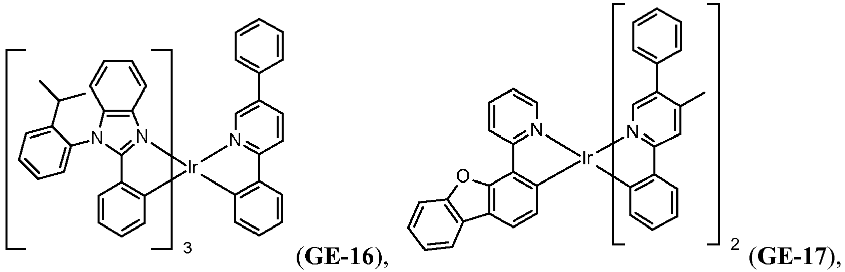

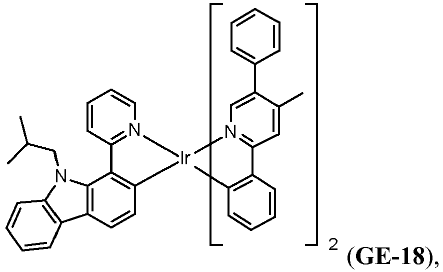

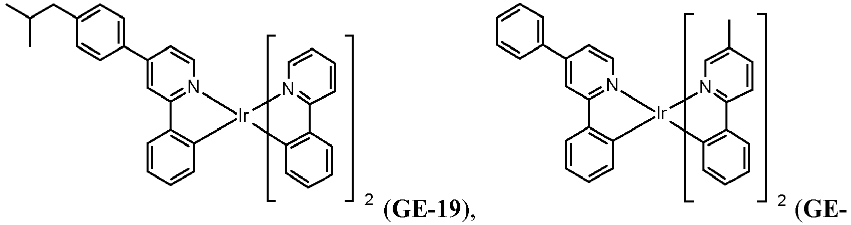

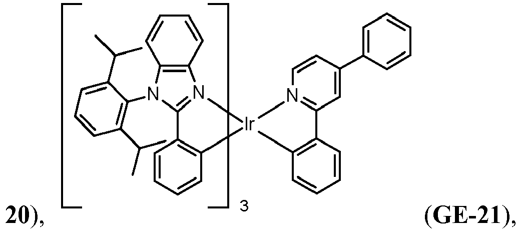

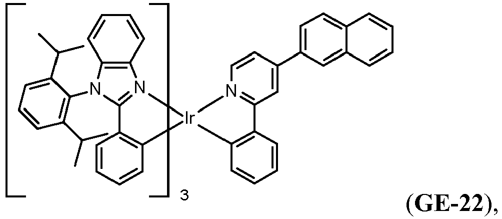

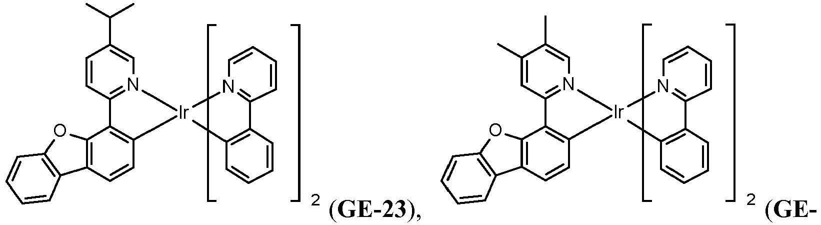

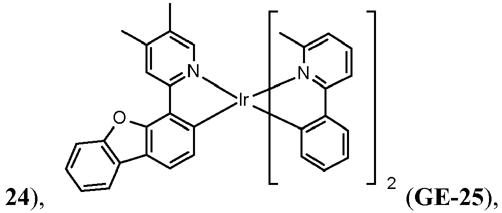

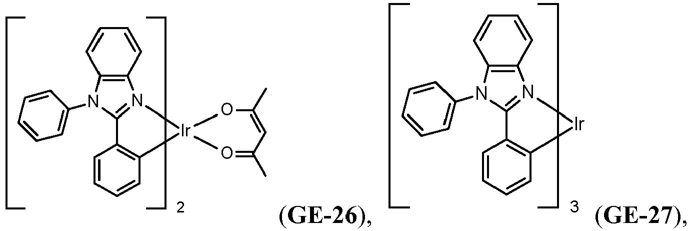

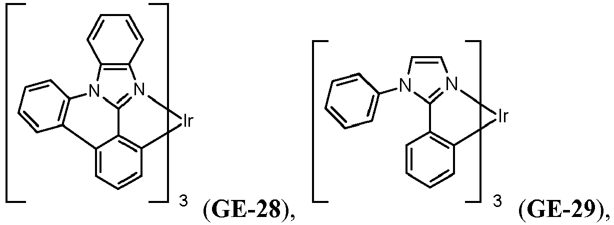

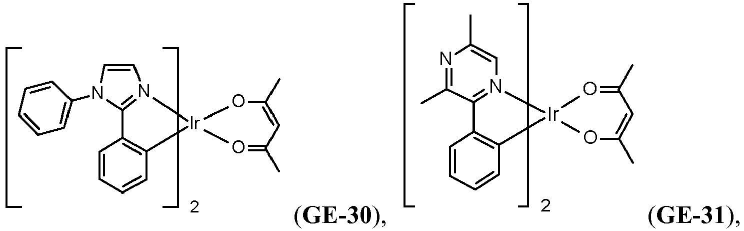

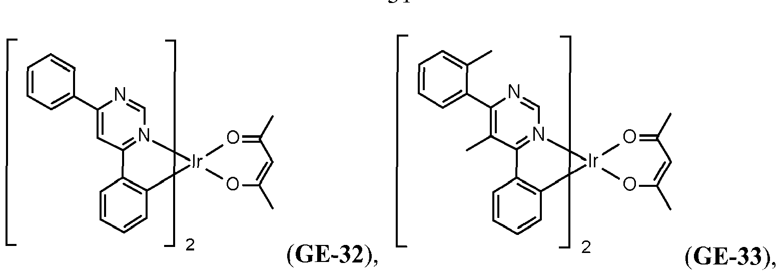

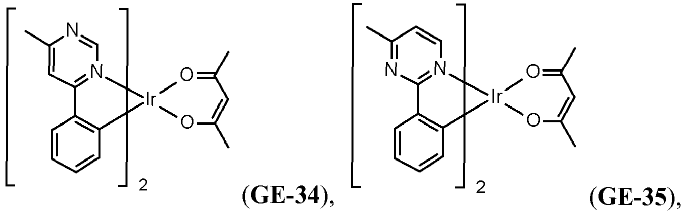

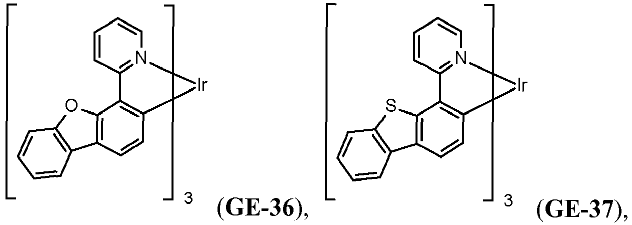

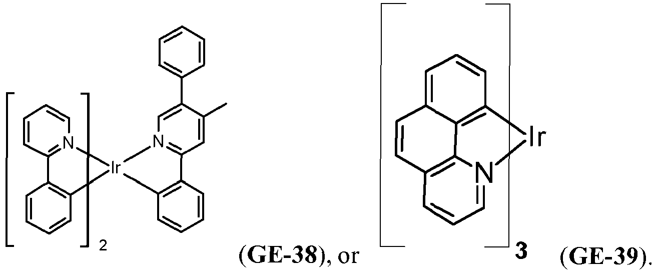

12. The organic light-emitting device according to claim 11, wherein the phosphorescent green emitter is a compound of formula 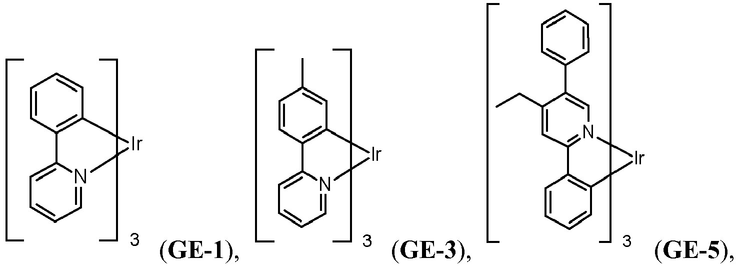 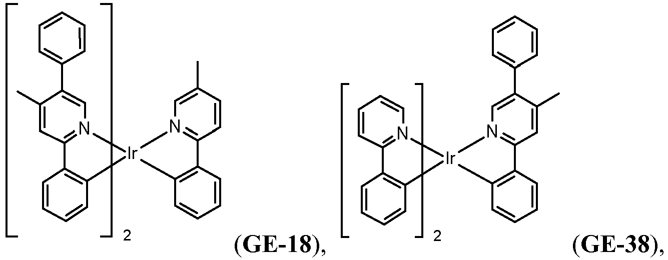 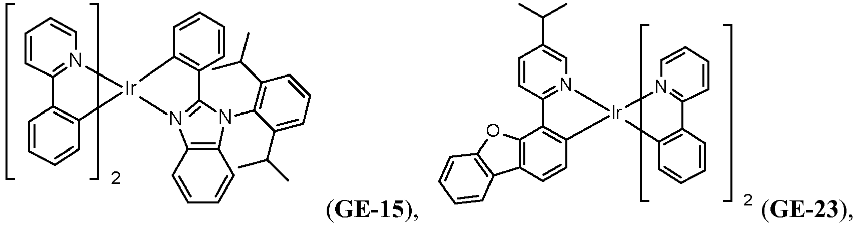 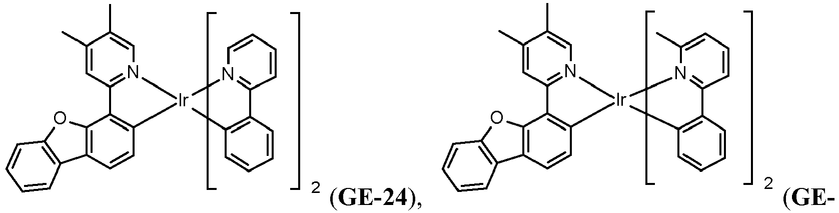 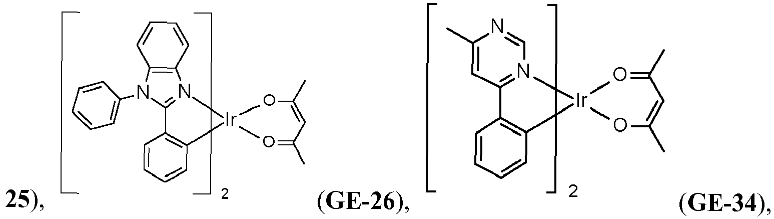 or

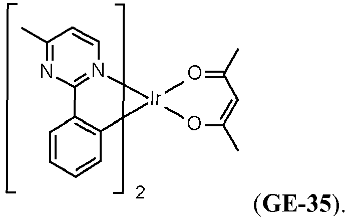

13. The organic light-emitting device according to any of claims 2 to 12, wherein the second host compound is a compound of formula 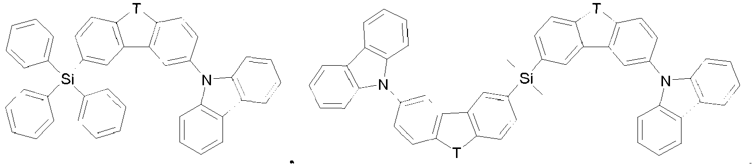 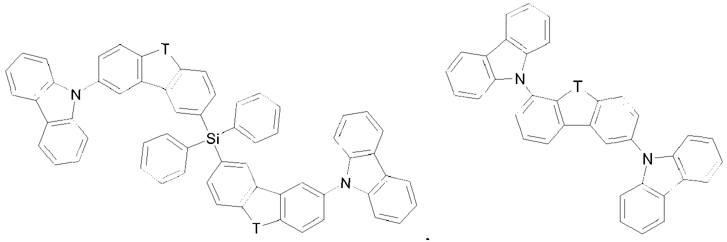 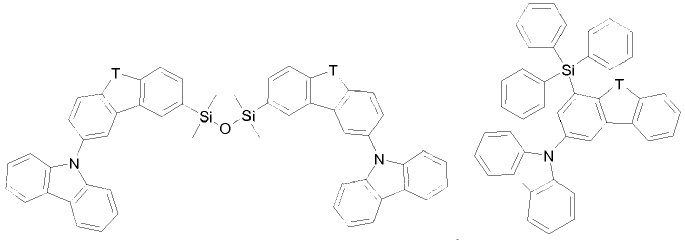 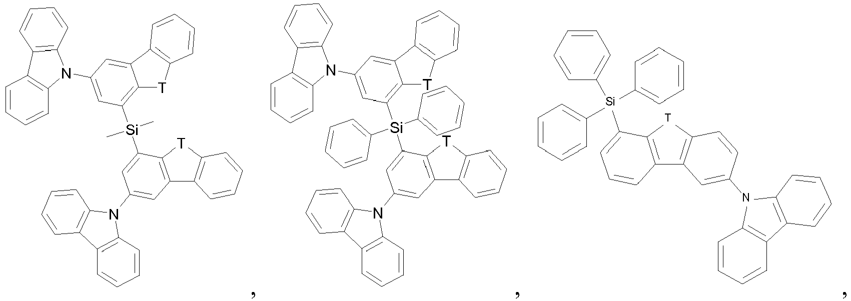 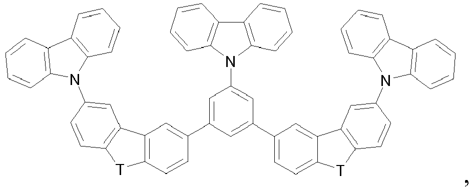 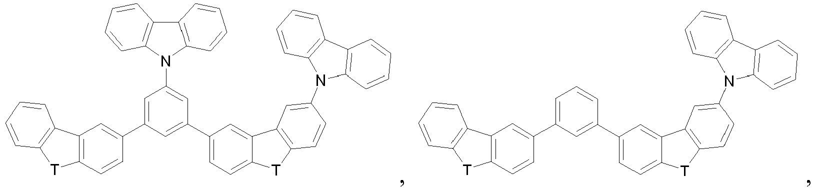 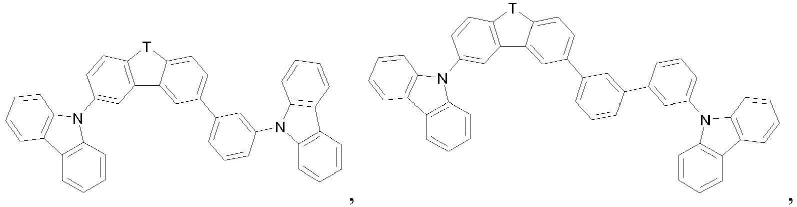 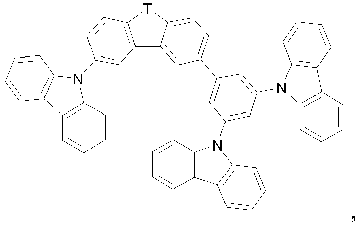 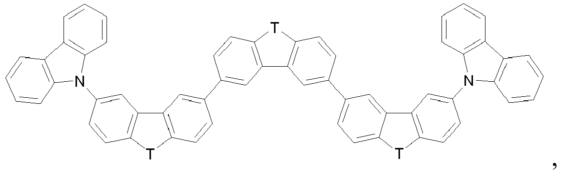 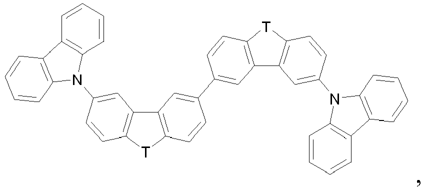 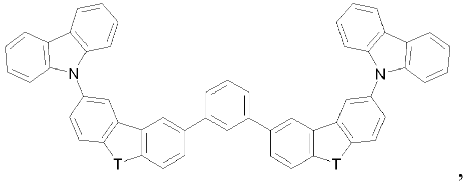 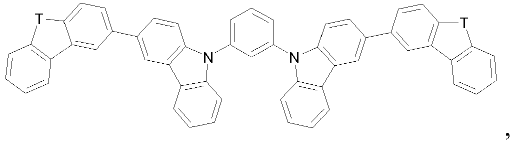 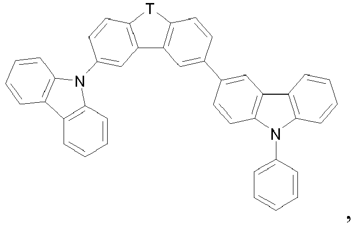 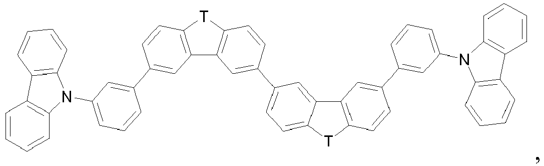 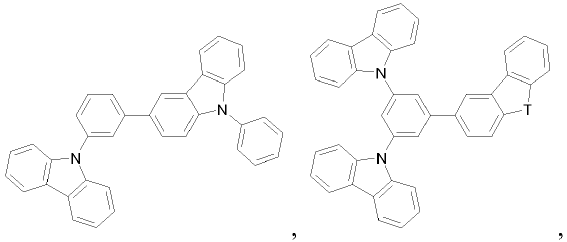 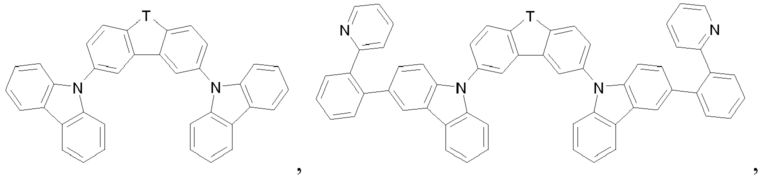 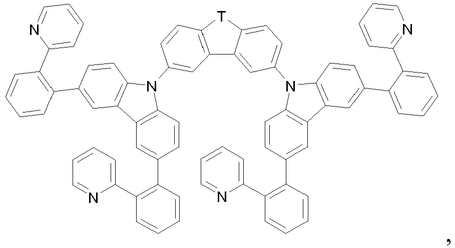 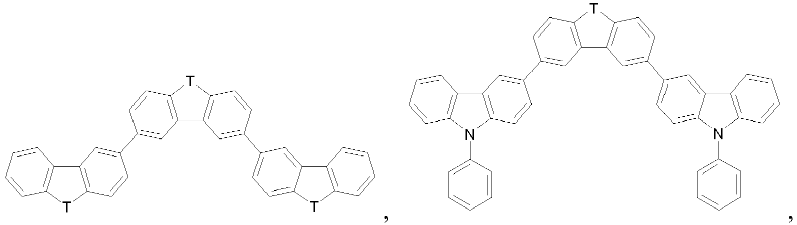 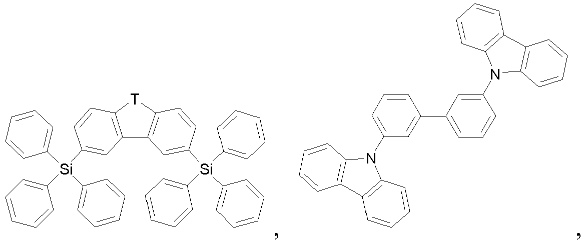 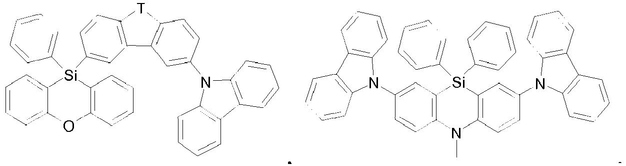 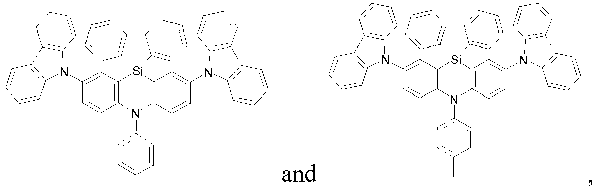 wherein T is O, or S.

14. The organic light-emitting device according to any of claims 2 to 13, wherein the second host compound is a compound of formula 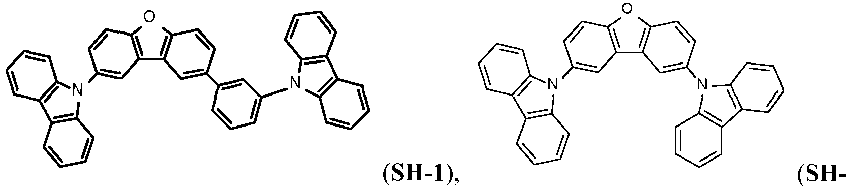 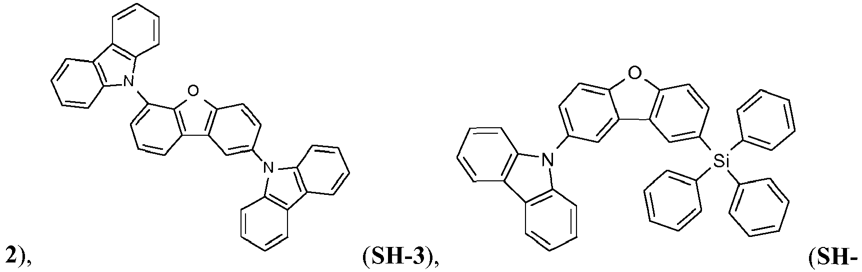 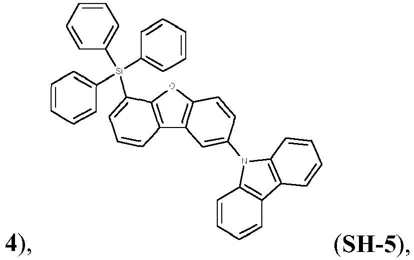 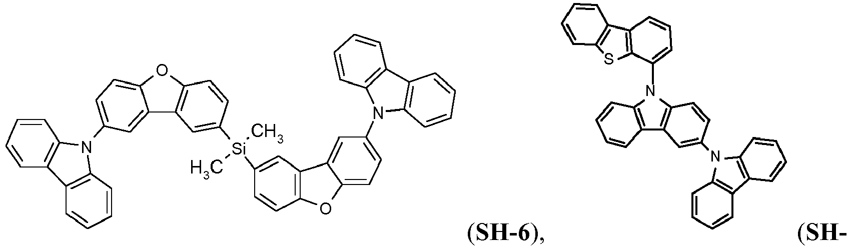 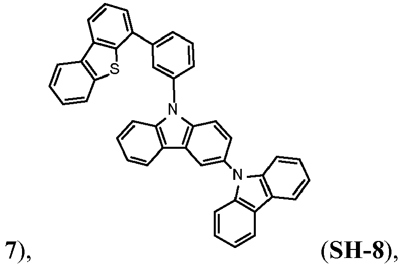 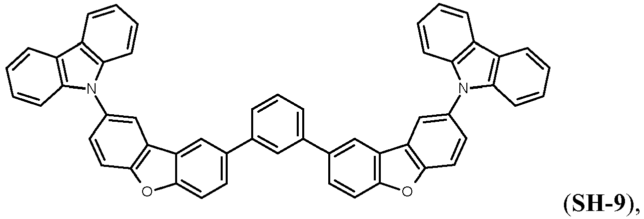 or

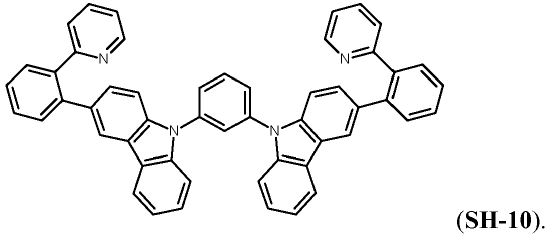

15. The organic light-emitting device according to any of claims 2 to 14, wherein the hole transport layer comprises a compound of formula 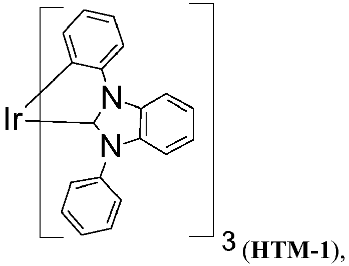 or

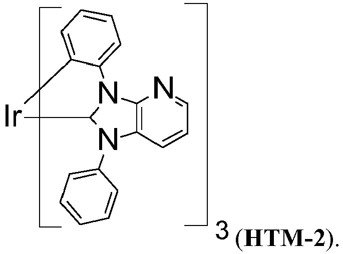

16. The organic light-emitting device according to any of claims 2 to 15, wherein the electron transport layer comprises a compound of formula 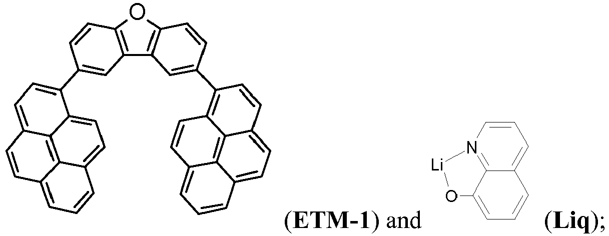 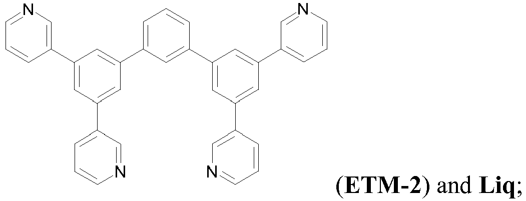 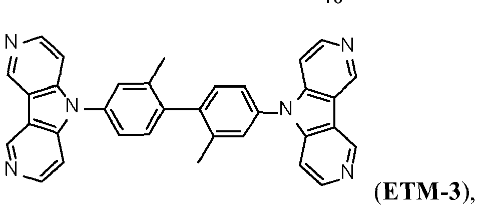 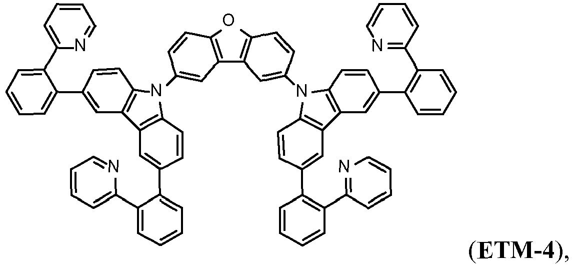 or

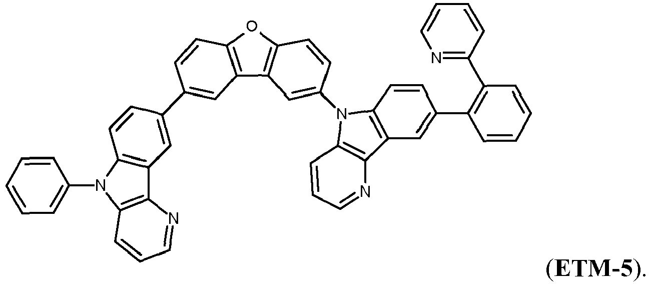

17. The organic light-emitting device according to any of claims 2 to 16, comprising in this order:
(a) an anode,
(b) **(sulfonatedpoly(thiophene-3-[2[(2-methoxyethoxy)ethoxy]-2,5-diyl)** (hole injection layer),
(c) **MoO₃**/ **HTM-1** (hole transport layer),
(d) **HTM-1** (exciton blocking layer)
(e) emitting layer, comprising:
(e1) **RE-2** / **HTM-1** (first light-emitting layer),
(e2) **BE-1** / **GE-1** / **SH-2** (second light-emitting layer),
(f) **SH-2** (exciton blocking layer)
(g) **ETM-1** / **Liq** (electron transport layer),
(h) **KF** (electron injection layer), and
(i) a cathode; or
comprising in this order:
(a) an anode,
(b) (sulfonated poly(thiophene-3-[2[(2-methoxyethoxy)ethoxy]-2,5-diyl) (hole injection layer),
(c) **MoO₃/HTM-2** (hole transport layer),
(d) **HTM-2** (exciton blocking layer),
(e) emitting layer, comprising:
(e1) **RE-2** / **HTM-2** (first light-emitting layer),
(e2) **BE-1** / **GE-1** / **SH-2** (second light-emitting layer),
(f) **SH-2** (exciton blocking layer)
(g) **ETM-1** / **Liq** (electron transport layer), and
h) **KF** (electron injection layer), and
(i) **Al** (cathode); or
comprising in this order:
(a) an anode,
(b) **(sulfonated poly(thiophene-3-[2[(2-methoxyethoxy)ethoxy]-2,5-diyl)** (hole injection layer),
(c) **MoO₃**/ **HTM-1** (Ir(DPBIC)₃) (hole transport layer),
(d) **HTM-1** (exciton blocking layer)
(e) emitting layer, comprising:
(e1) **RE-1** / **HTM-1** (first light-emitting layer),
(e2) **BE-1** / **GE-1** / **SH-1** (second light-emitting layer),
(f) **SH-1** (exciton blocking layer)
(g) **ETM-1** / **Liq** (electron transport layer), and
(h) a cathode; or
comprising in this order:
(a) an anode,
(b) (sulfonated poly(thiophene-3-[2[(2-methoxyethoxy)ethoxy]-2,5-diyl) (hole injection layer),
(c) **MoO₃**/**HTM-2** (hole transport layer),
(d) **HTM-2** (exciton blocking layer)
(e) emitting layer, comprising:
(e1) **RE-1** / **HTM-2** (first light-emitting layer),
(e2) **BE-1** / **GE-1** / **SH-1** (second light-emitting layer),
(f) **SH-1** (exciton blocking layer)
(g) **ETM-1** / **Liq** (electron transport layer), and
(h) a cathode.

18. An apparatus selected from the group consisting of stationary visual display units; illumination units; keyboards; items of clothing; furniture; wallpaper, comprising the organic electronic device according to any of claims 2 to 17, or the emitting layer of claim.

19. Use of the emitting layer (e) according to claim 1 for generating white light.

## Patentansprüche

1. Eine emittierende Schicht (e) zum Erzeugen von weißem Licht, umfassend (e1) eine erste lichtemittierende Schicht und (e2) eine zweite lichtemittierende Schicht, wobei die erste lichtemittierende Schicht in direktem Kontakt mit der zweiten lichtemittierenden Schicht ist, wobei die erste lichtemittierende Schicht einen phosphoreszierenden roten Emitter und eine erste Host-Verbindung aufweist, wobei die zweite lichtemittierende Schicht einen phosphoreszierenden blauen Emitter, einen phosphoreszierenden grünen Emitter und eine zweite Host-Verbindung aufweist.

2. Organische Vorrichtung zur Emission von weißem Licht, aufweisend:
(a) eine Anode,
(i) eine Kathode,
(e) eine emittierende Schicht gemäß Anspruch 1.

3. Organische Vorrichtung zur Emission von Licht gemäß Anspruch 2, wobei die erste lichtemittierende Schicht (e1) zwischen der Anode (a) und der zweiten lichtemittierenden Schicht (e2) angeordnet ist.

4. Organische Vorrichtung zur Emission von Licht gemäß Anspruch 2 oder 3, in dieser Reihenfolge aufweisend:
(a) eine Anode,
(b) optional eine Lochinjektionsschicht,
(c) eine Lochtransportschicht,
(d) Exzitonblockierungsschicht,
(e) eine emittierende Schicht, umfassend
(e1) eine erste lichtemittierende Schicht,
(e2) eine zweite lichtemittierende Schicht,
(f) eine Loch-/ Exzitonblockierungsschicht,
(g) eine Elektrontransportschicht,
(h) optional eine Elektroninjektionsschicht, und
(i) eine Kathode.

5. Organische Vorrichtung zur Emission von Licht gemäß einem der Ansprüche 2 bis 4, wobei der phosphoreszierende rote Emitter eine Verbindung ist gemäß den Formeln 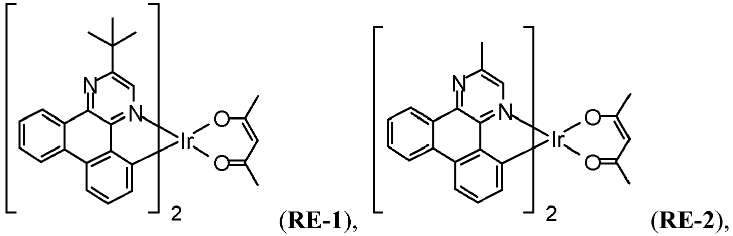 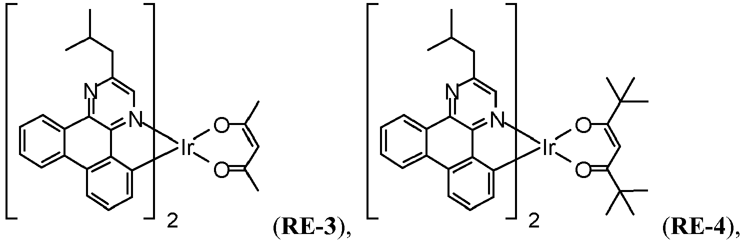 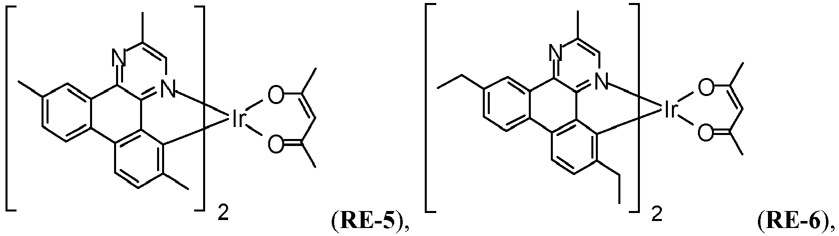 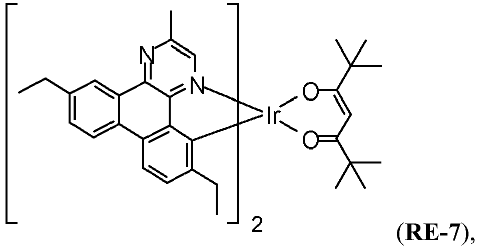 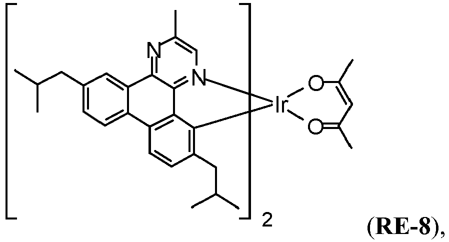 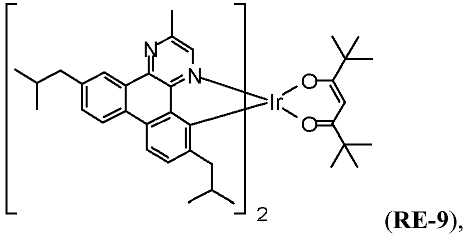 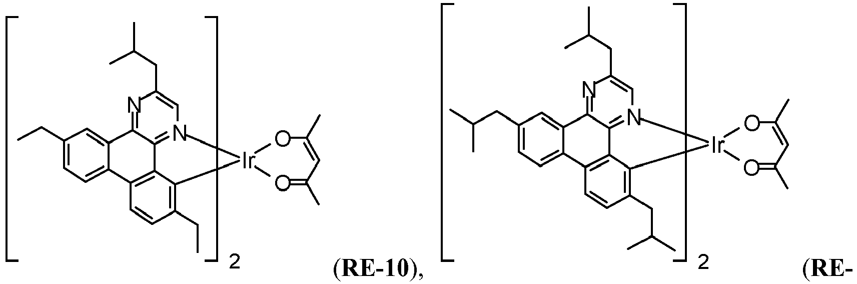 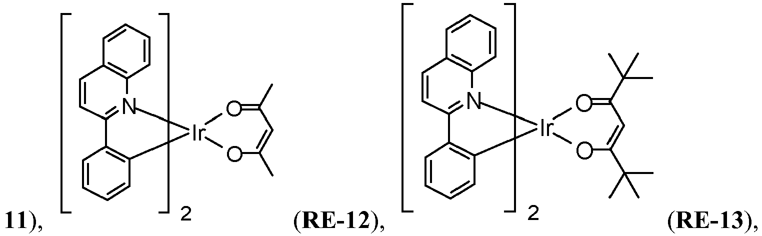 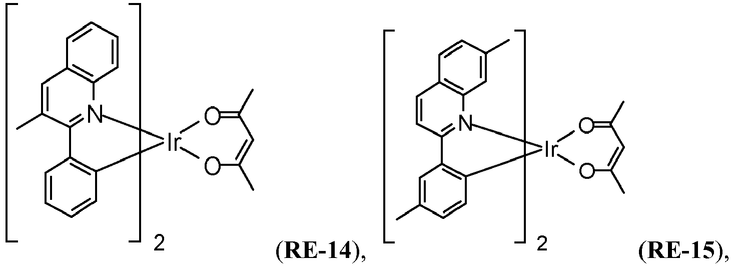 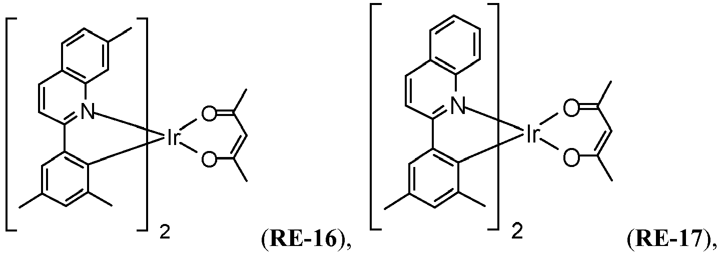 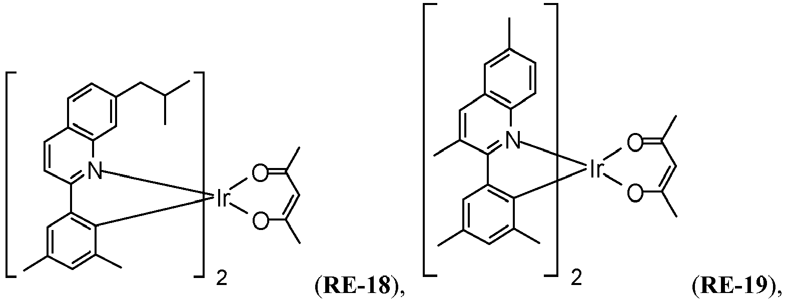 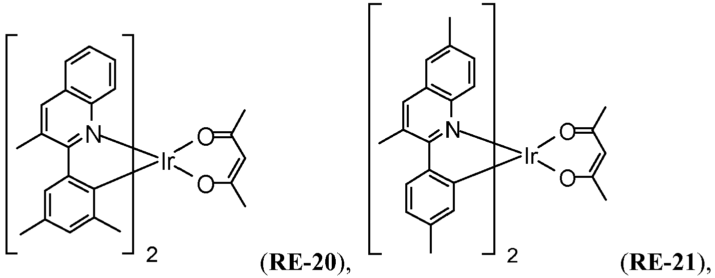 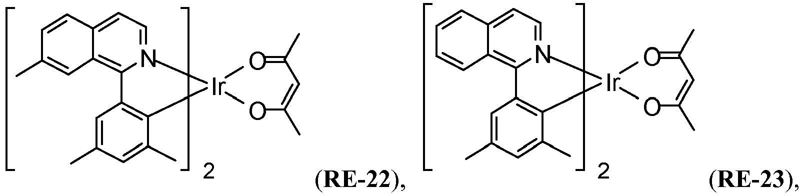 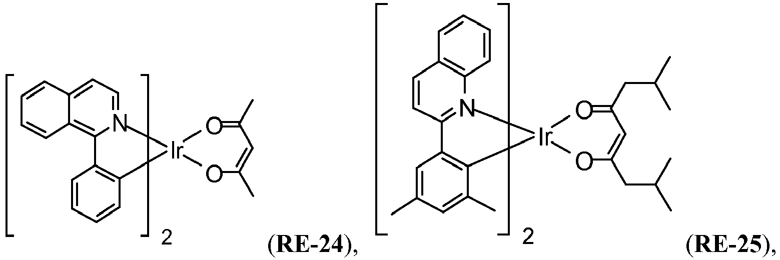 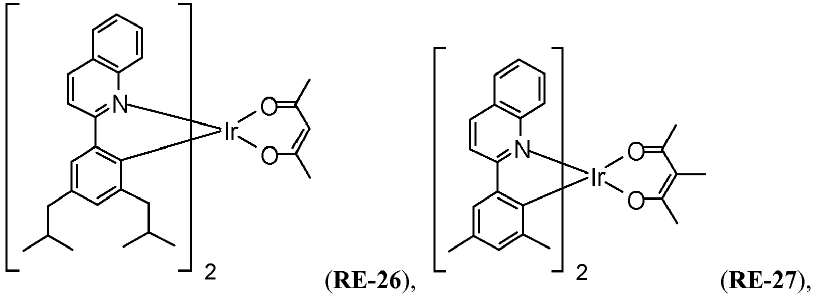 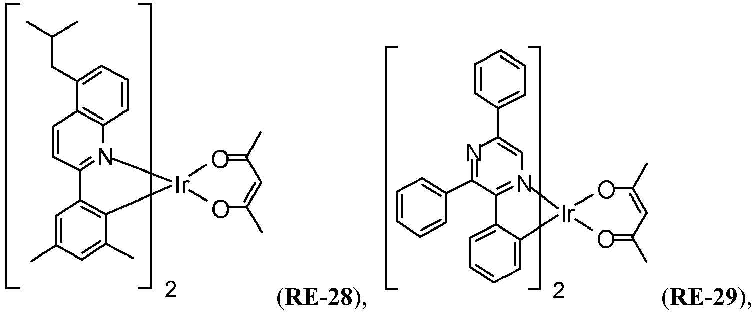 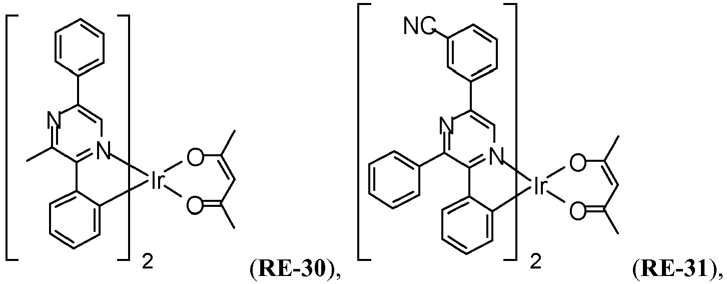 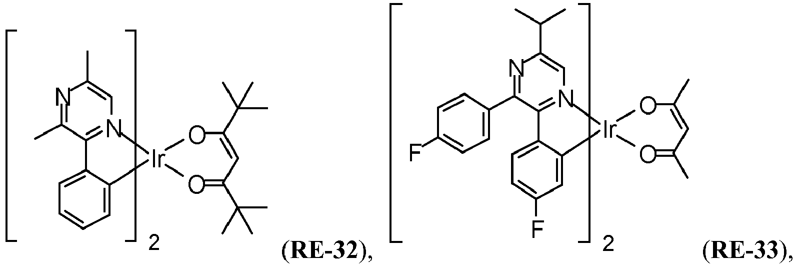 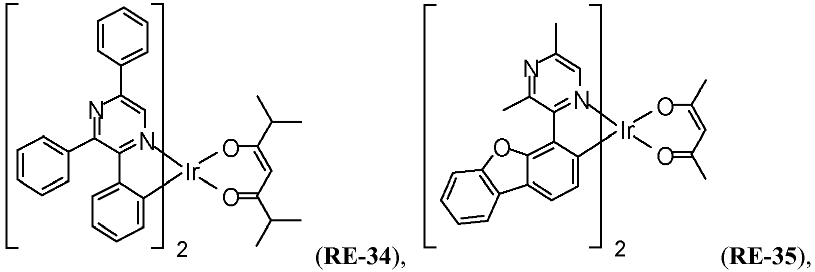 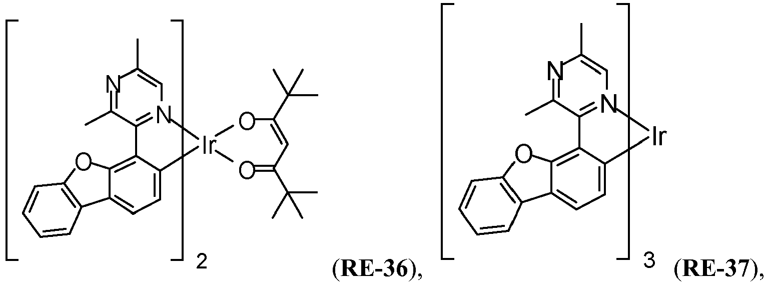 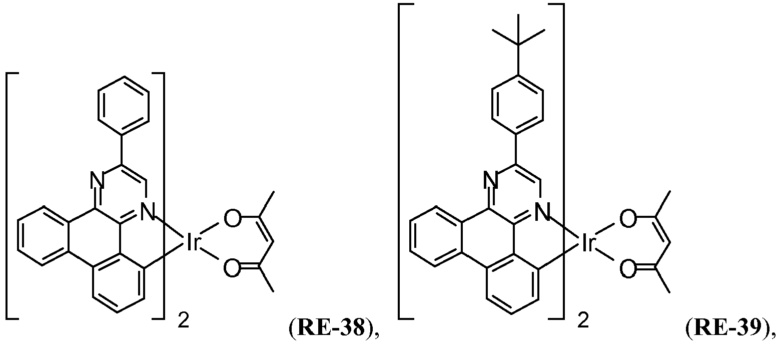 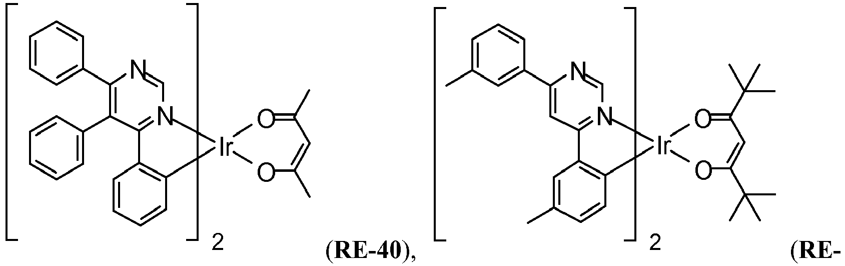 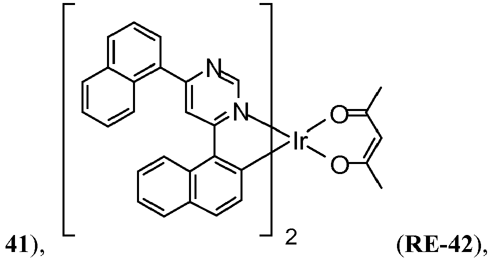 oder

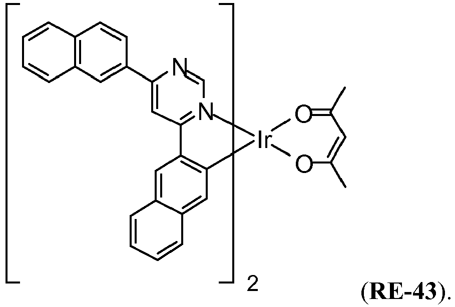

6. Organische Vorrichtung zur Emission von Licht gemäß Anspruch 5, wobei der phosphoreszierende rote Emitter eine Verbindung ist gemäß den Formeln 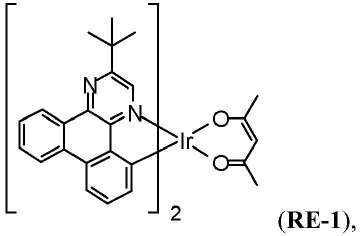 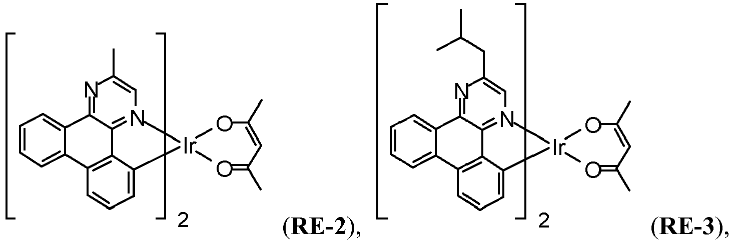 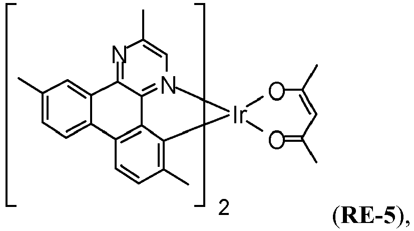 oder

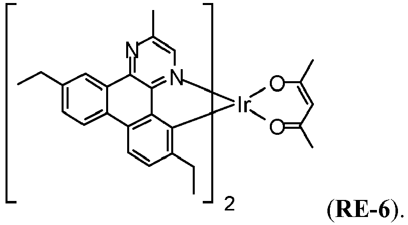

7. Organische Vorrichtung zur Emission von Licht gemäß einem der Ansprüche 2 bis 6, wobei die erste Host-Verbindung eine Verbindung ist gemäß den Formeln 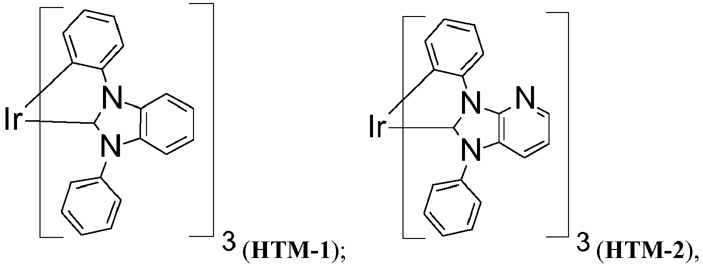 4,4'-bis[N-(1-naphthyl)-N-phenylamino]biphenyl (**FH-1**), oder 4,4',4"-tris(*N-*carbazolyl)triphenylamine (**FH-2**),

8. Organische Vorrichtung zur Emission von Licht gemäß Anspruch 7, wobei die erste Host-Verbindung eine Verbindung ist gemäß den Formeln 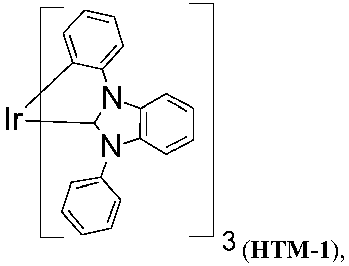 oder

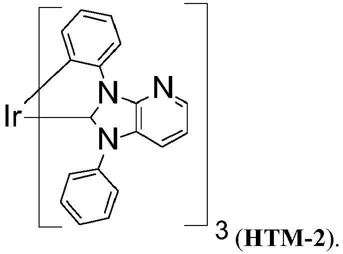

9. Organische Vorrichtung zur Emission von Licht gemäß einem der Ansprüche 2 bis 8, wobei der phosphoreszierende blaue Emitter eine Verbindung ist gemäß den Formeln

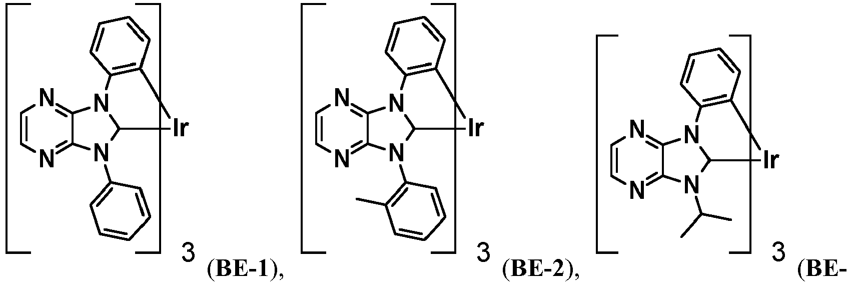

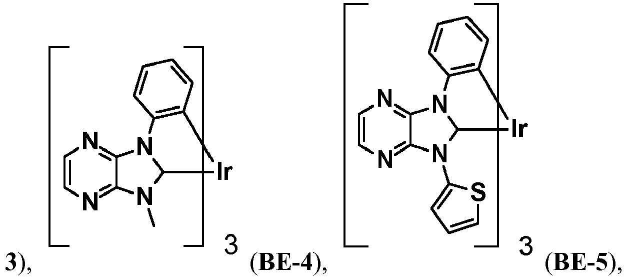

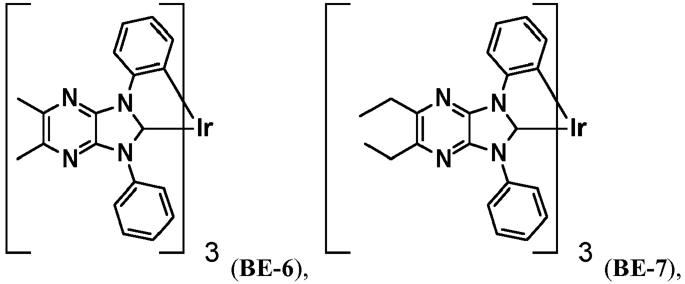

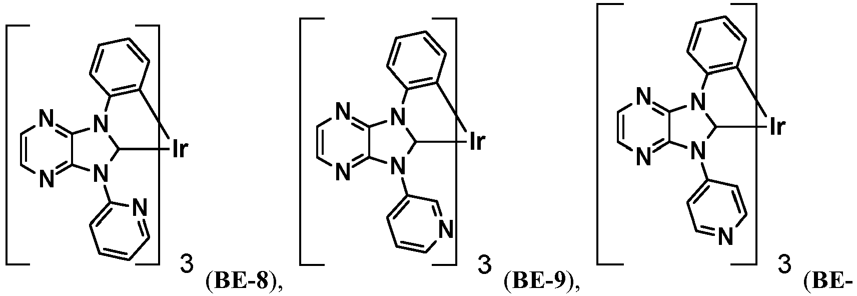

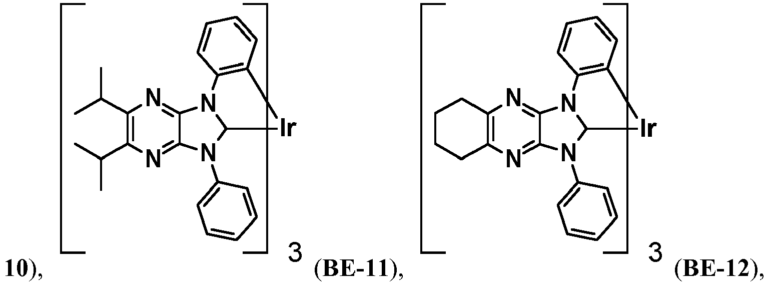

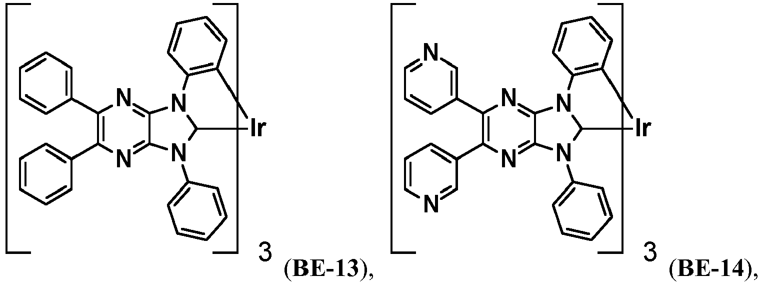

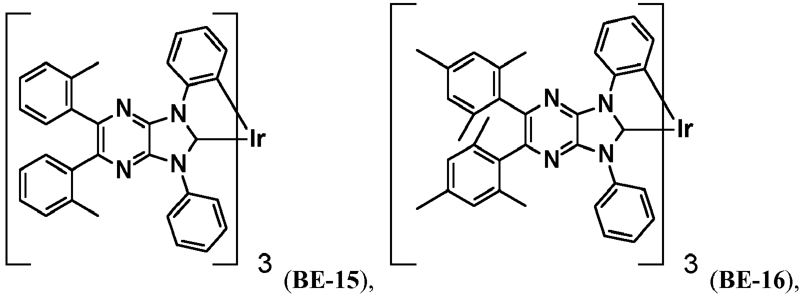

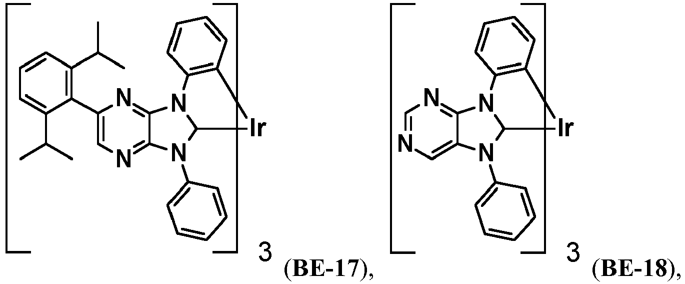

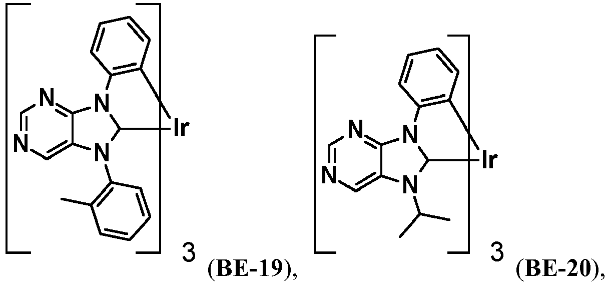

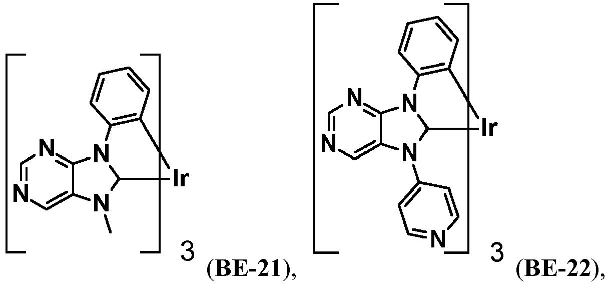

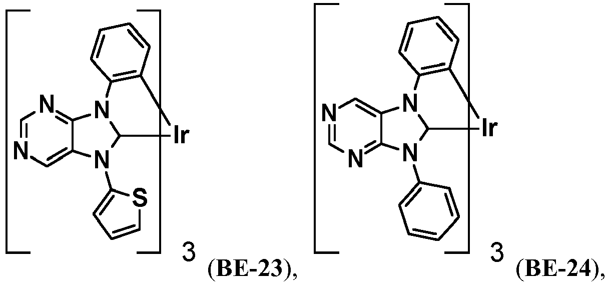

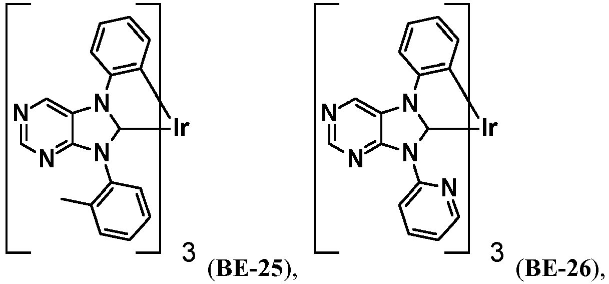

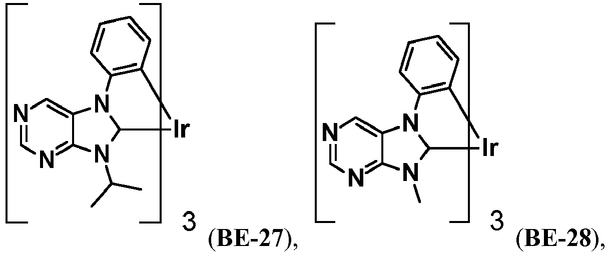

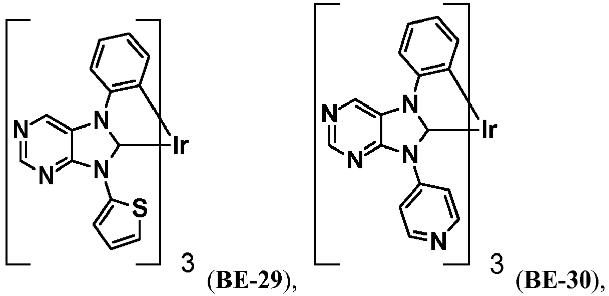

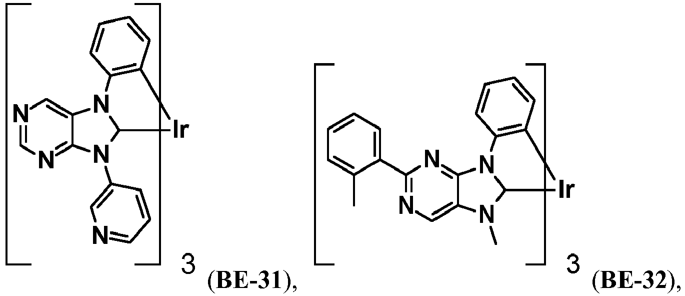

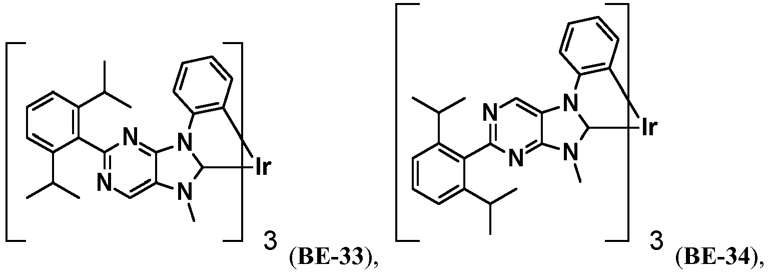

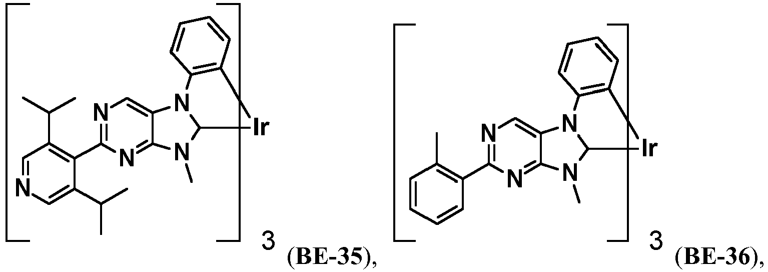

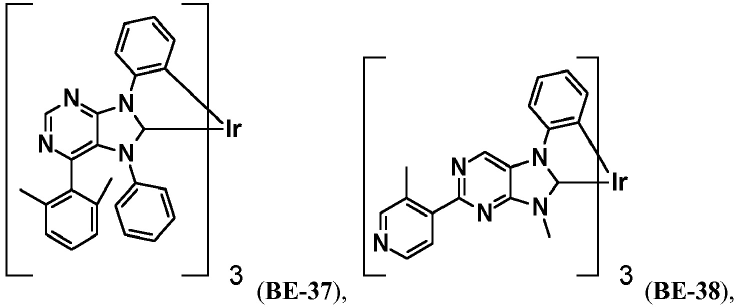

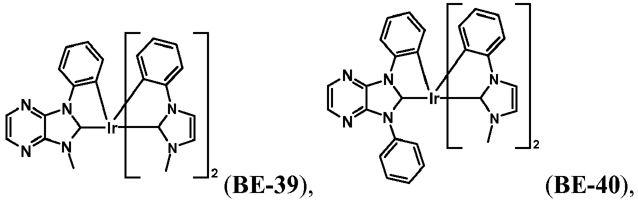

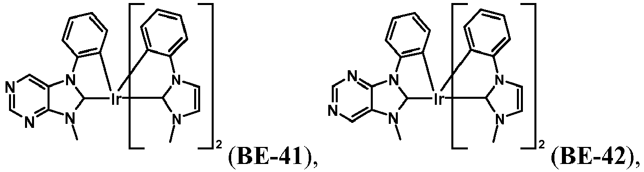

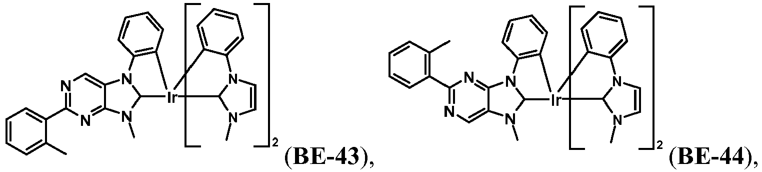

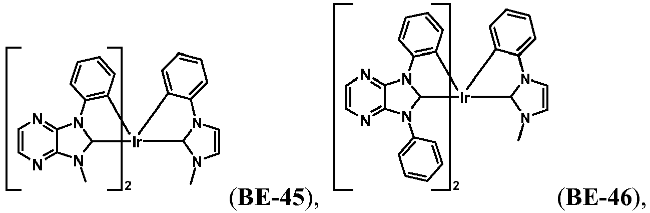

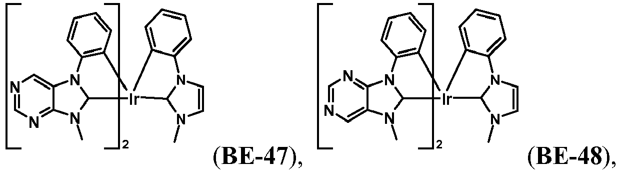

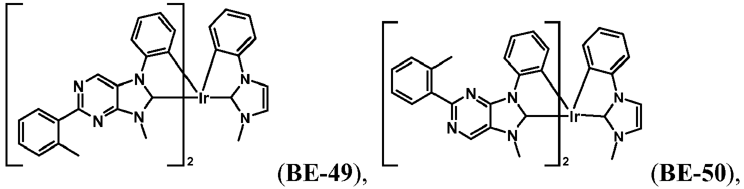

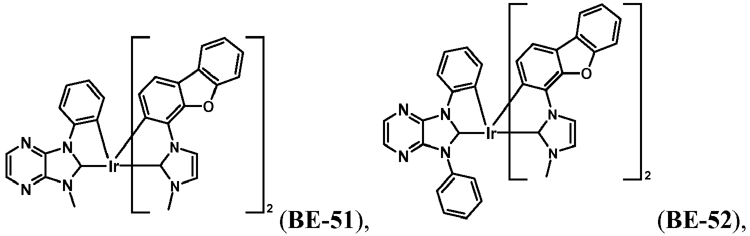

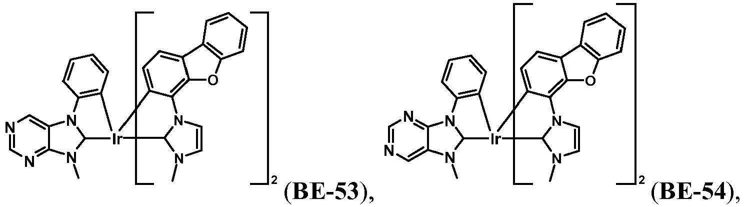

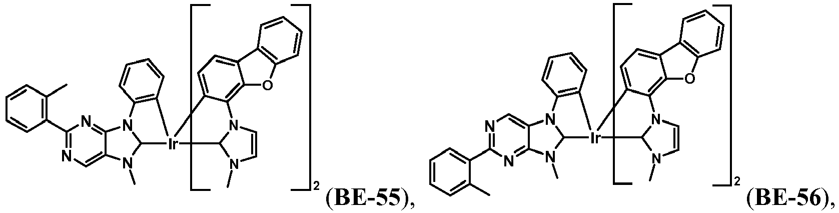

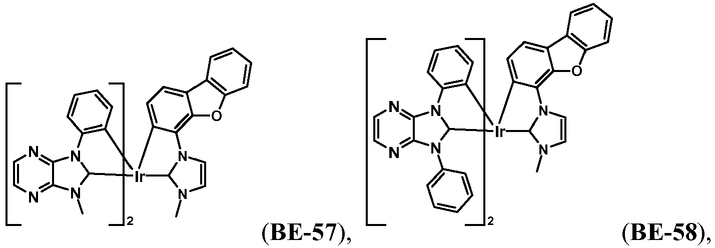

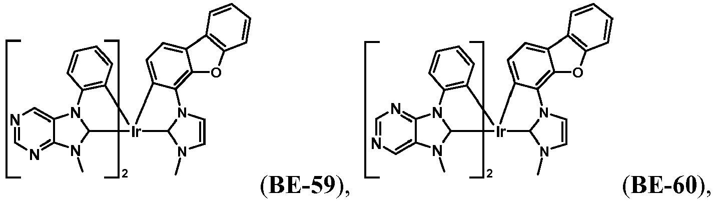

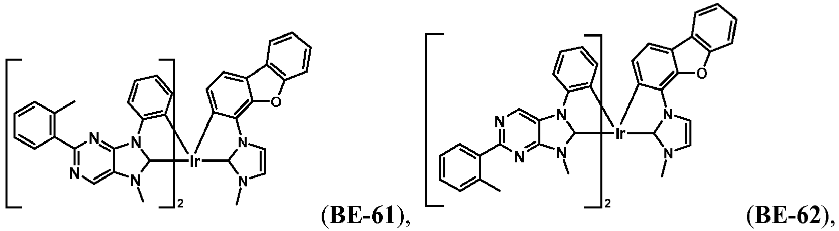

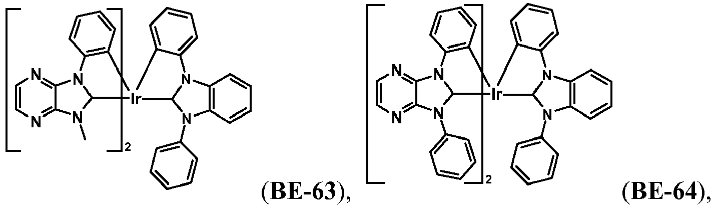

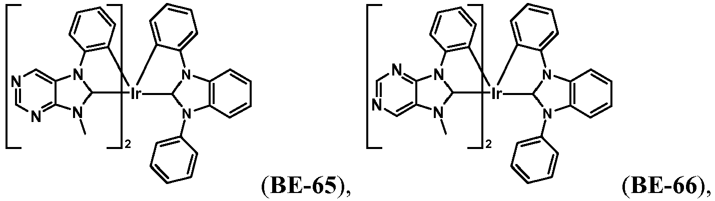

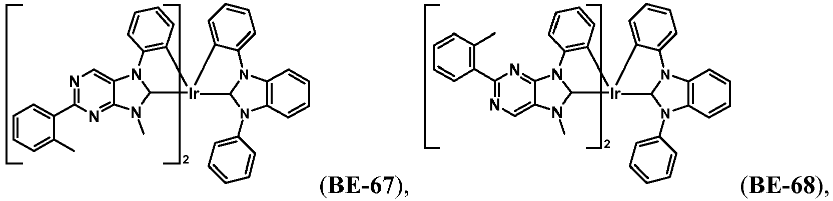

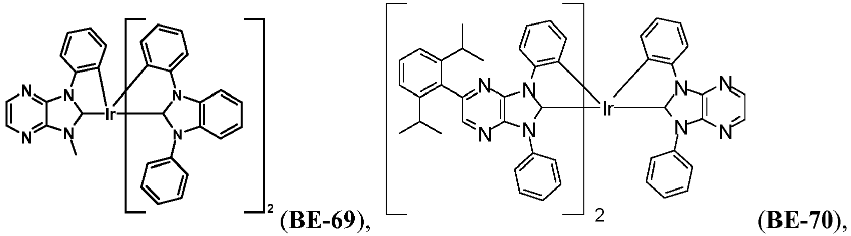

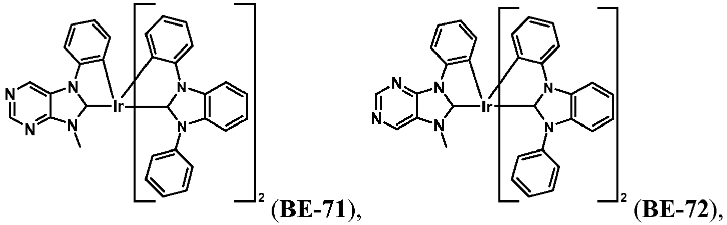

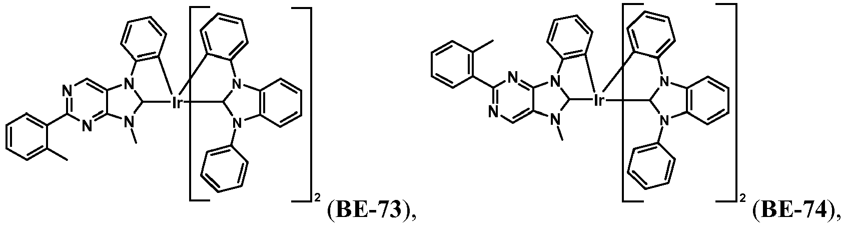

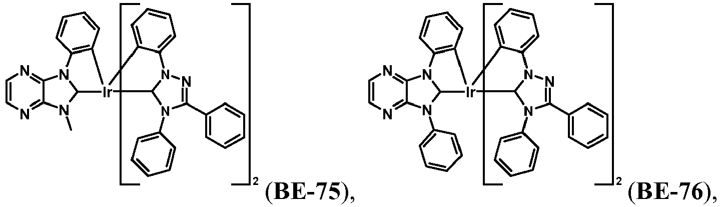

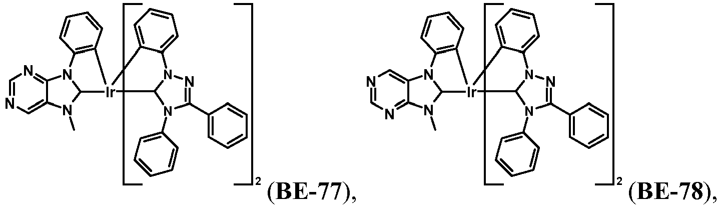

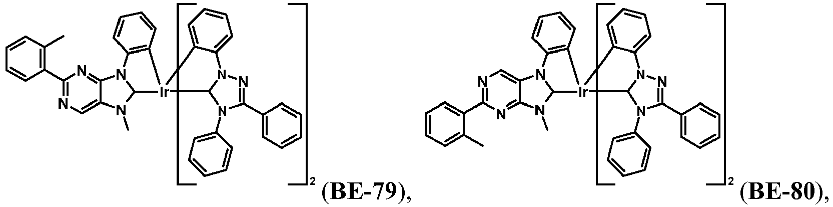

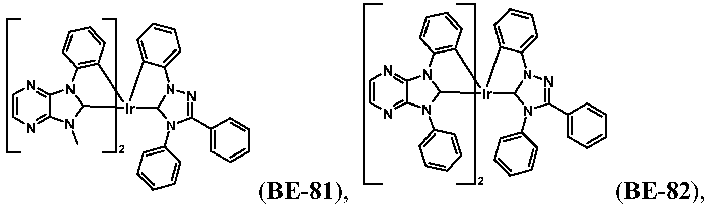

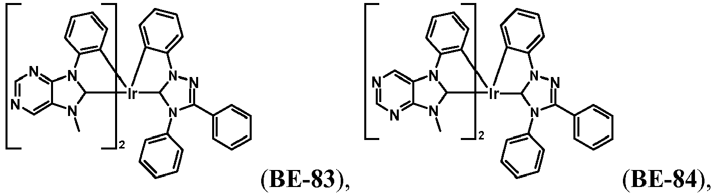

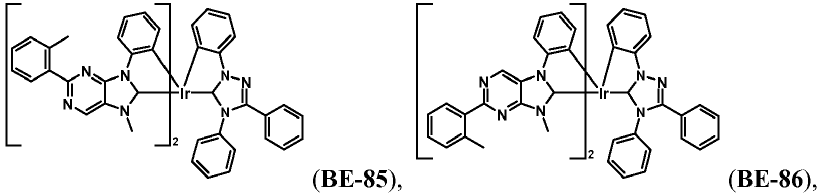

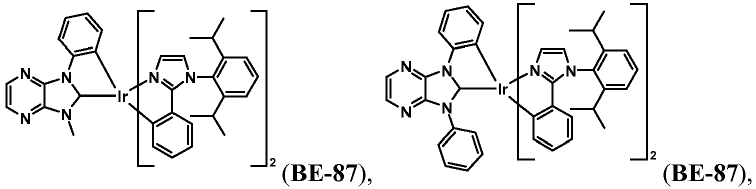

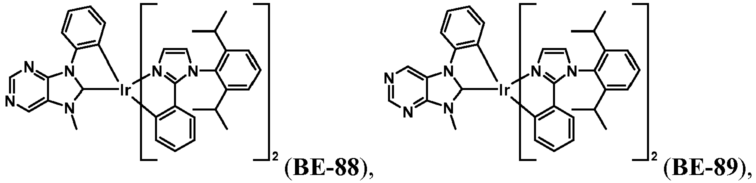

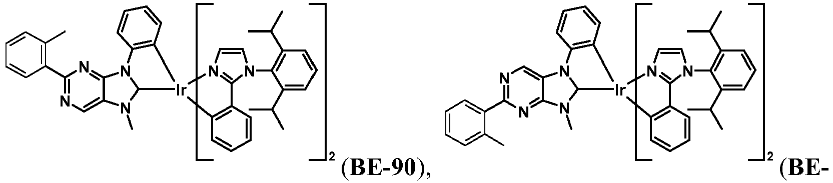

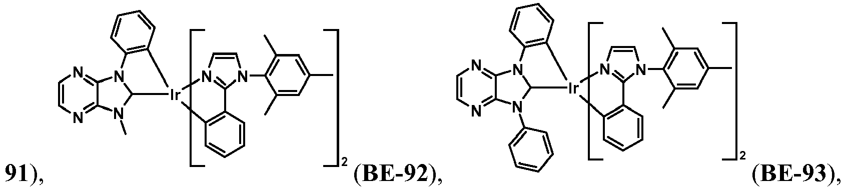

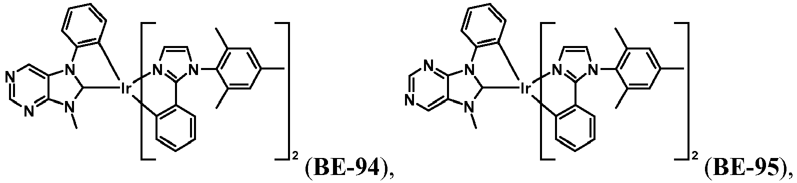

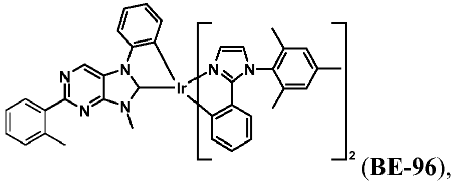

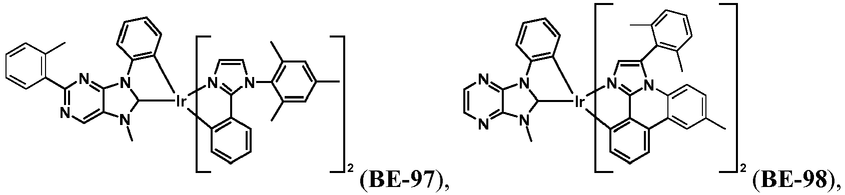

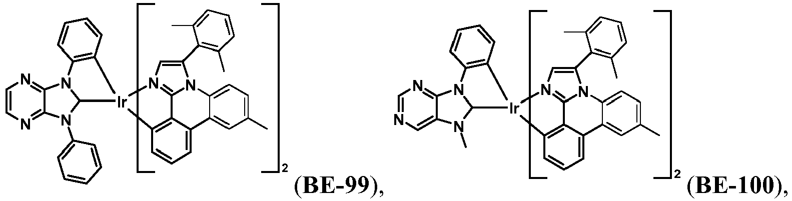

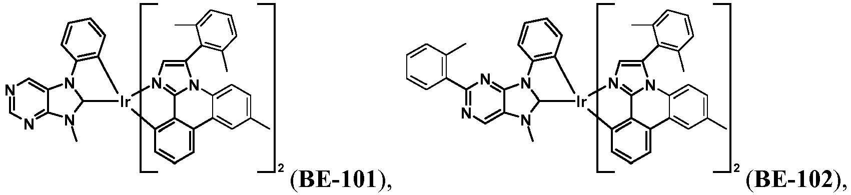

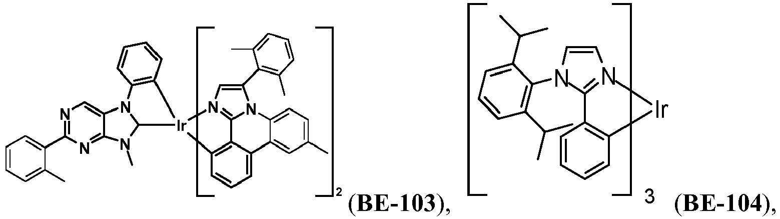

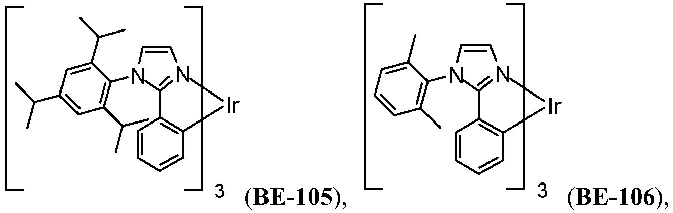

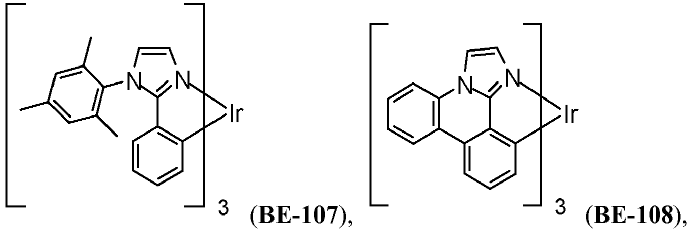

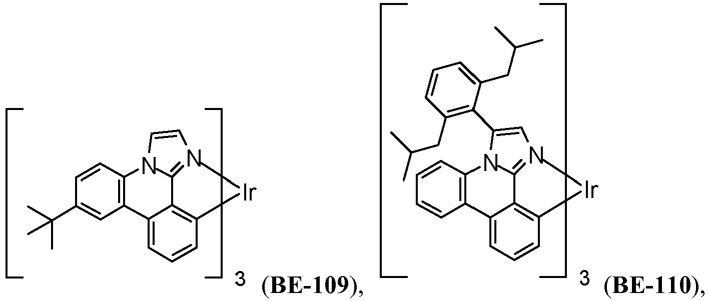

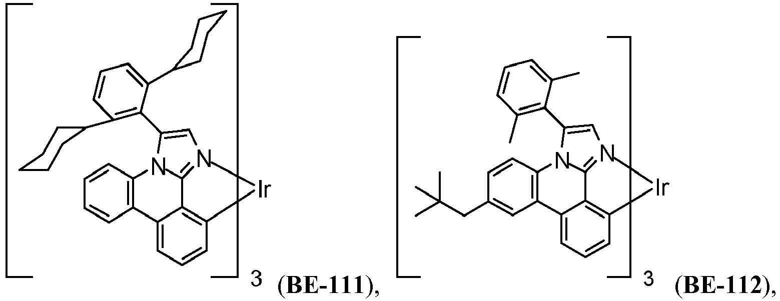

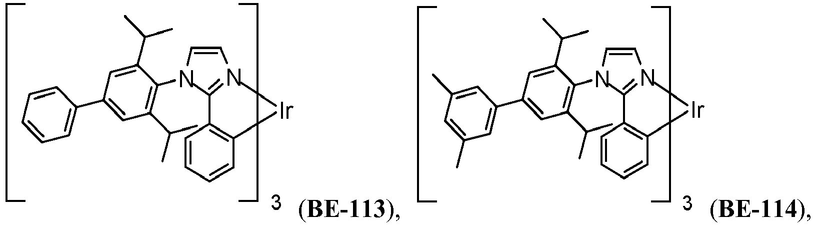

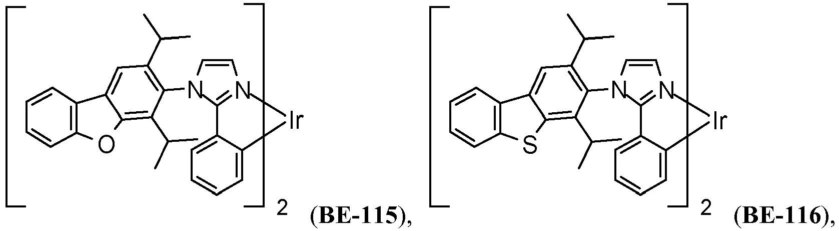

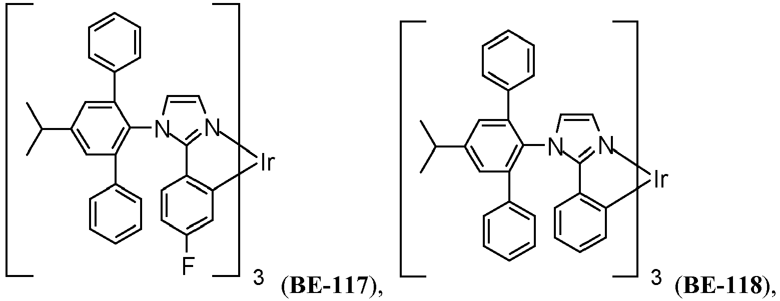

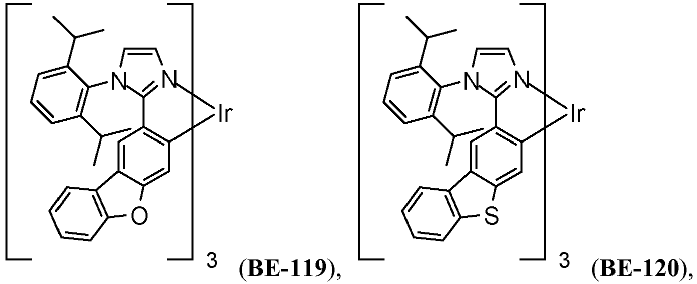

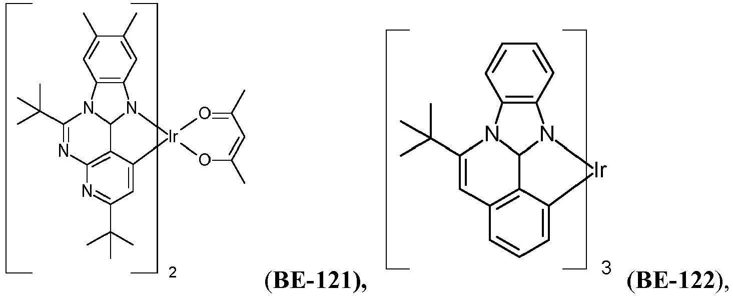

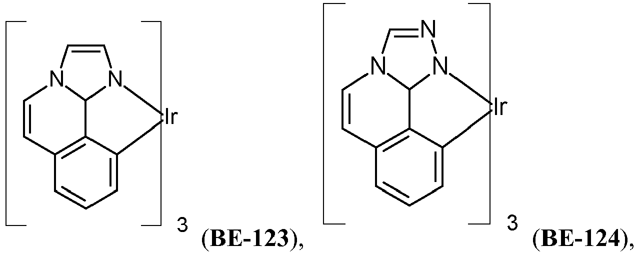

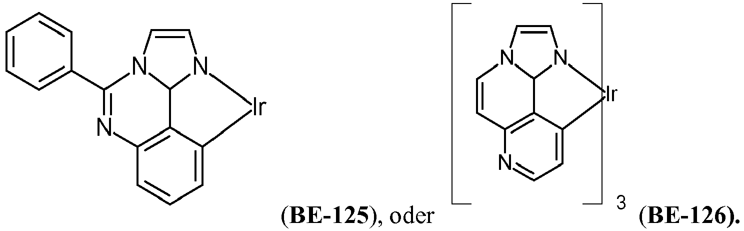

10. Organische Vorrichtung zur Emission von Licht gemäß einem der Ansprüche 2 bis 9, wobei der phosphoreszierende blaue Emitter eine Verbindung ist gemäß den Formeln

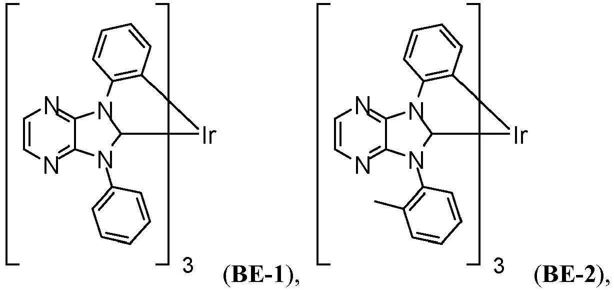

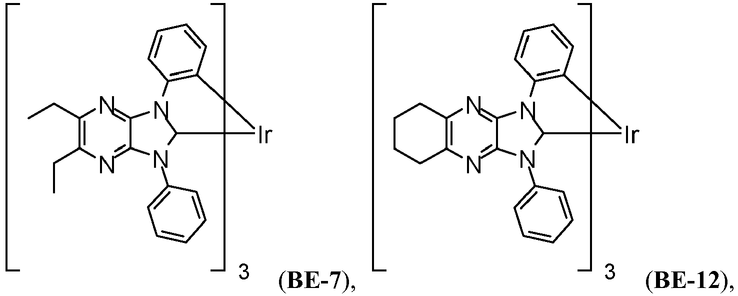

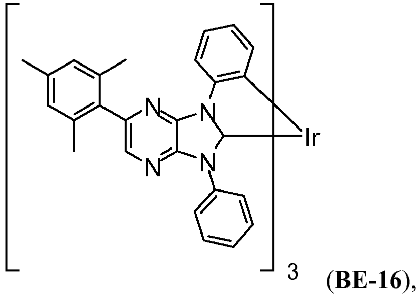

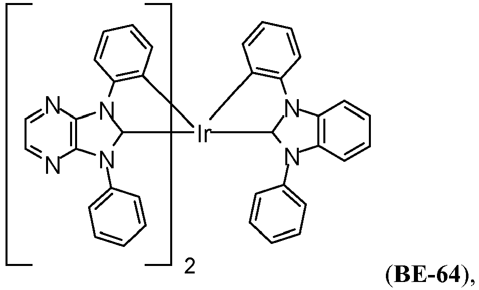

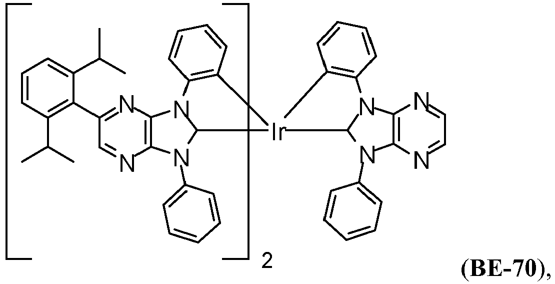

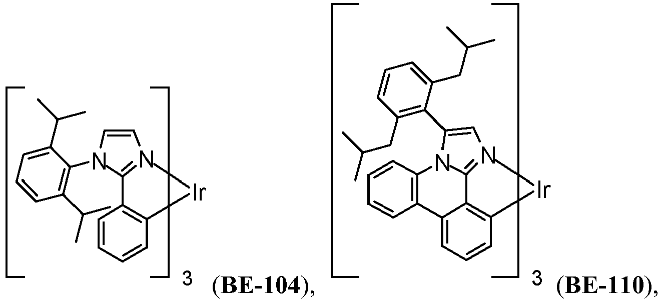

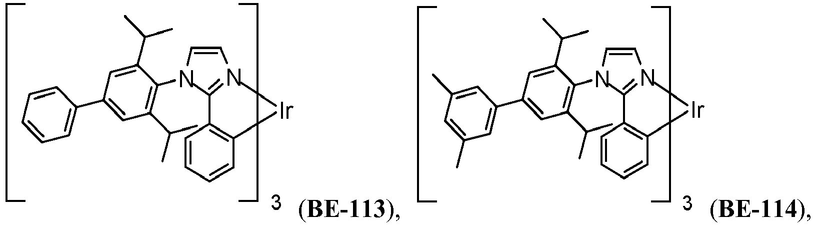

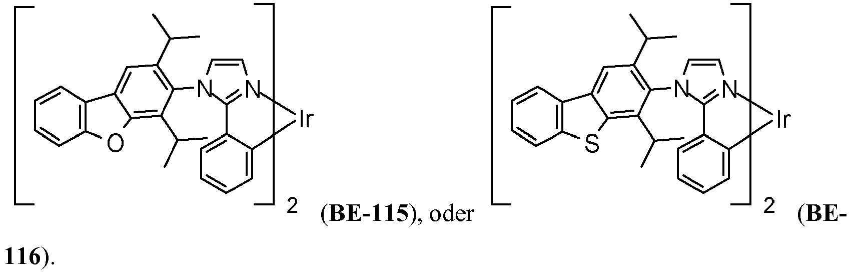

11. Organische Vorrichtung zur Emission von Licht gemäß einem der Ansprüche 2 bis 10, wobei der phosphoreszierende grüne Emitter eine Verbindung ist gemäß

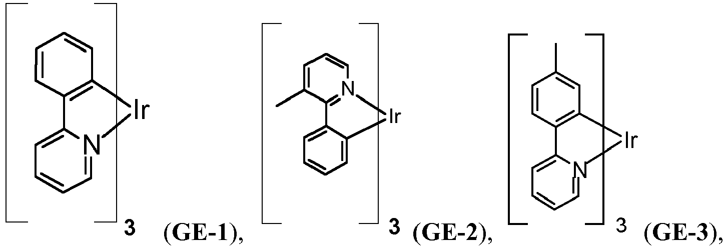

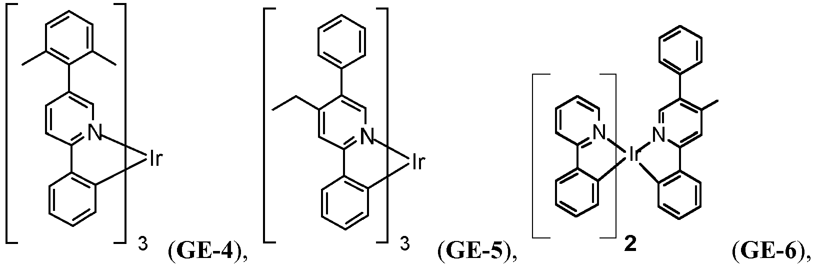

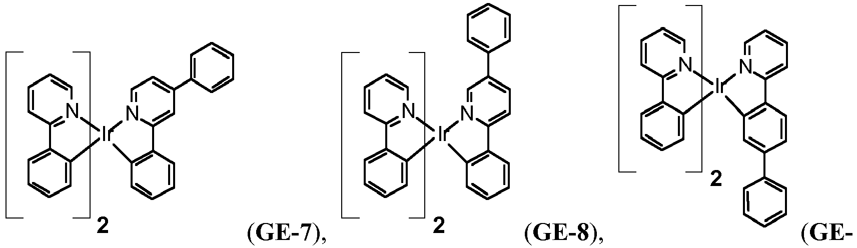

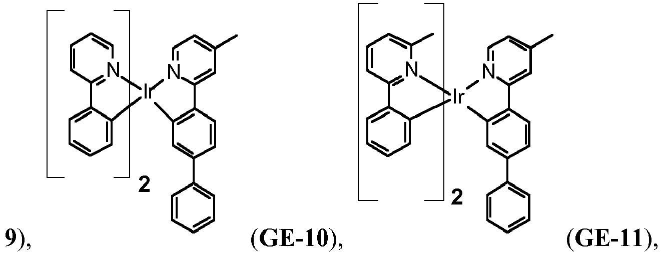

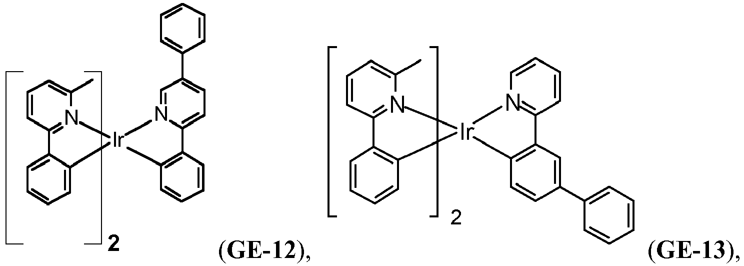

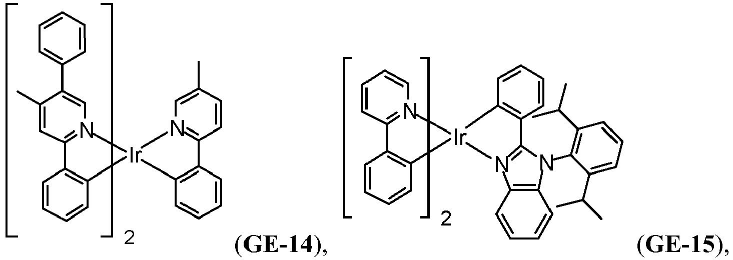

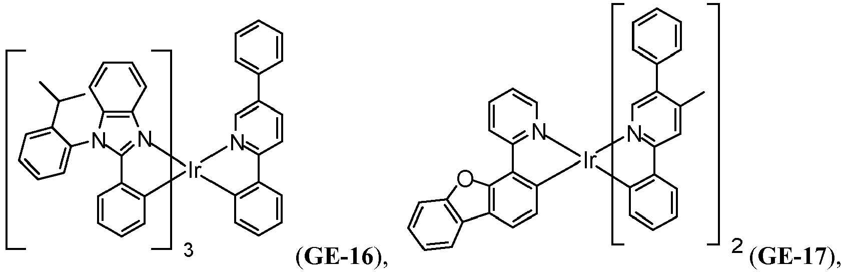

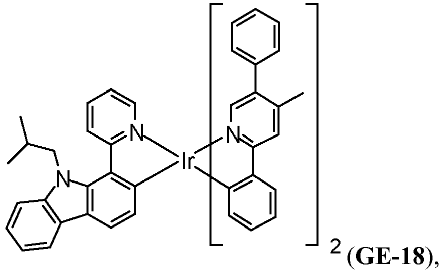

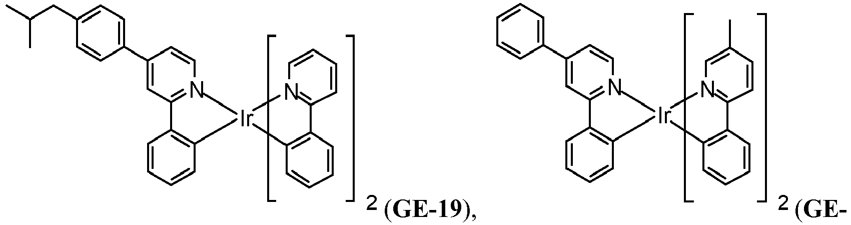

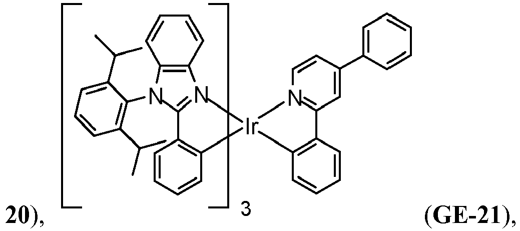

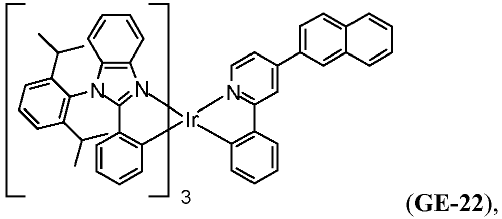

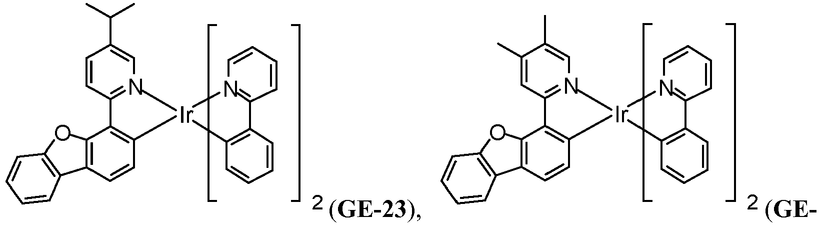

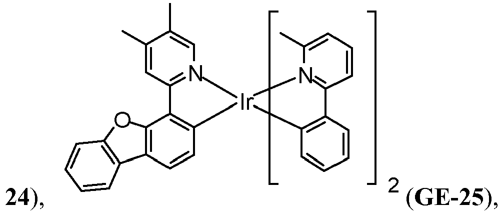

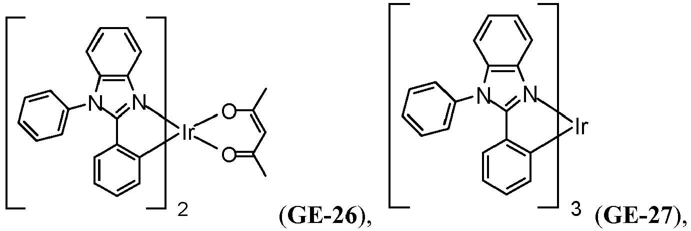

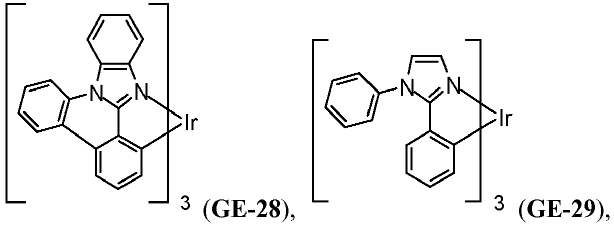

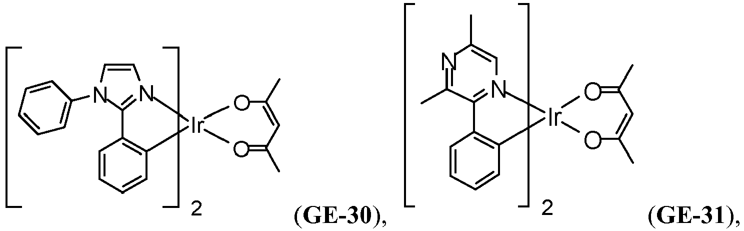

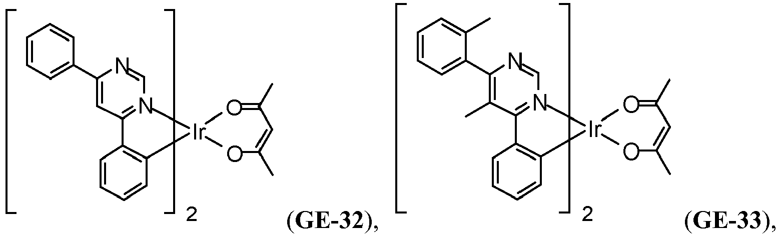

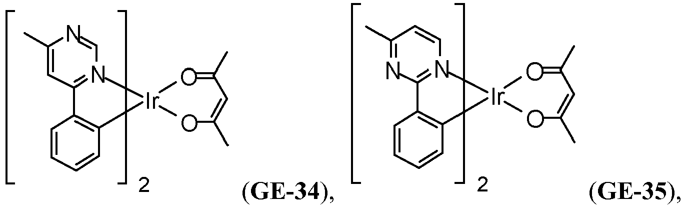

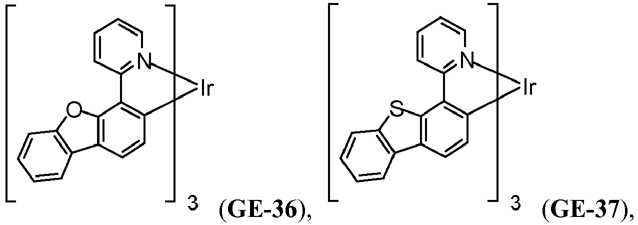

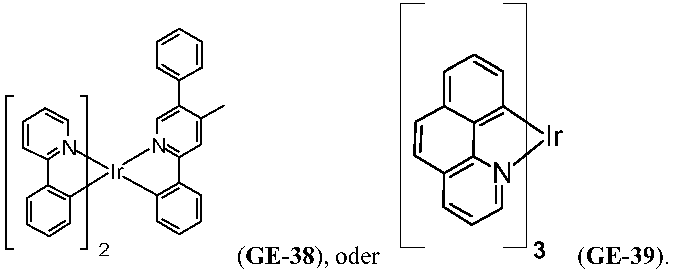

12. Organische Vorrichtung zur Emission von Licht gemäß Anspruch 11, wobei der phosphoreszierende grüne Emitter eine Verbindung ist gemäß den Formeln 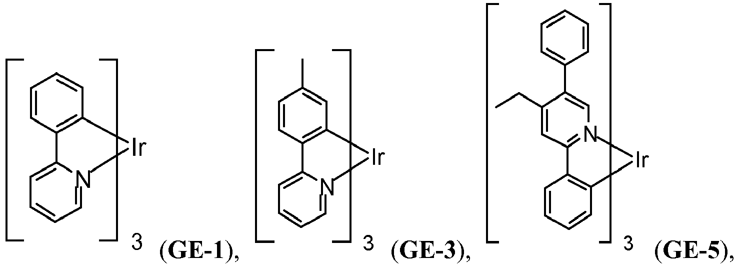 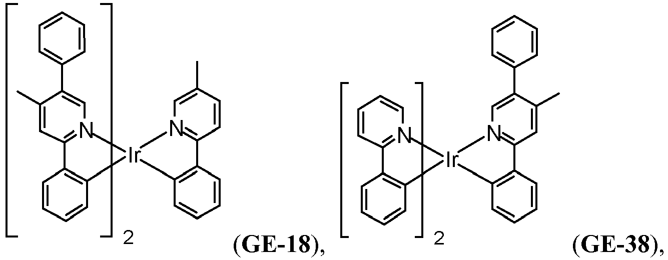 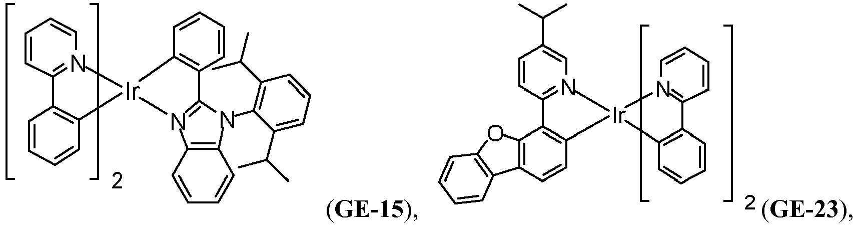 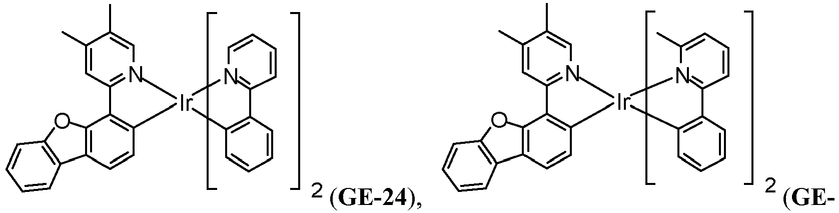 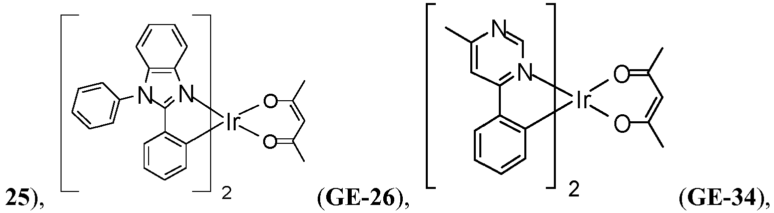 oder

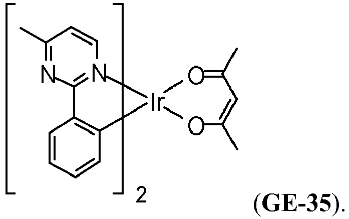

13. Organische Vorrichtung zur Emission von Licht gemäß einem der Ansprüche 2 bis 12, wobei die zweite Host-Verbindung eine Verbindung ist gemäß den Formeln 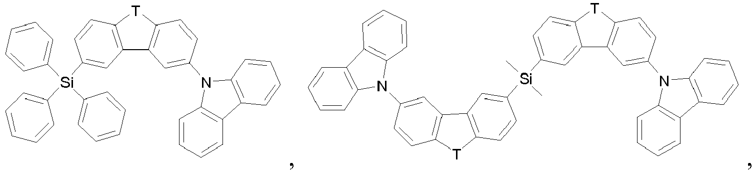 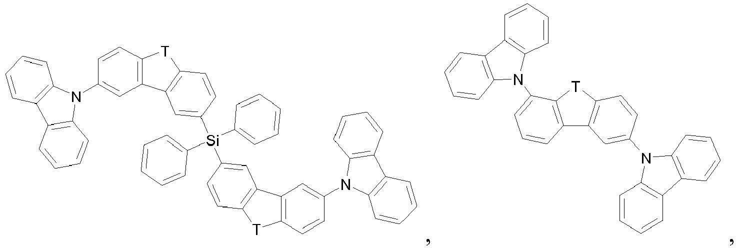 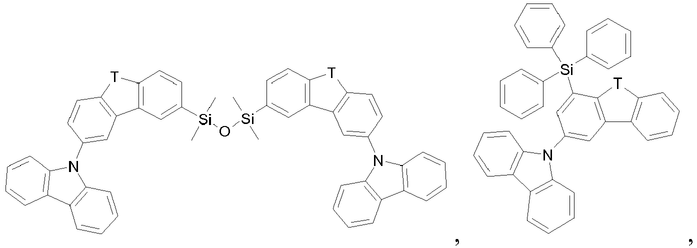 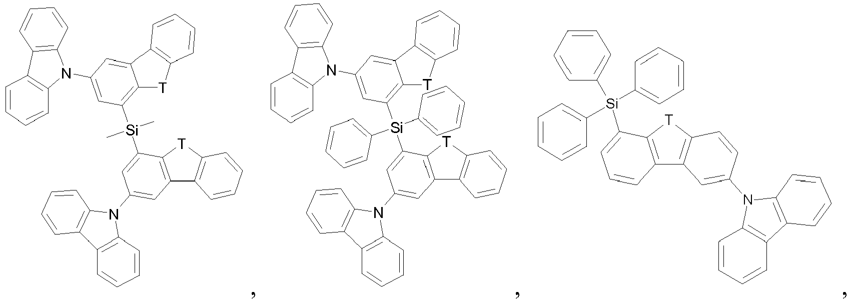 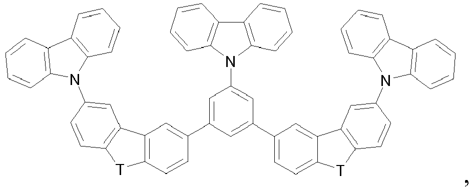 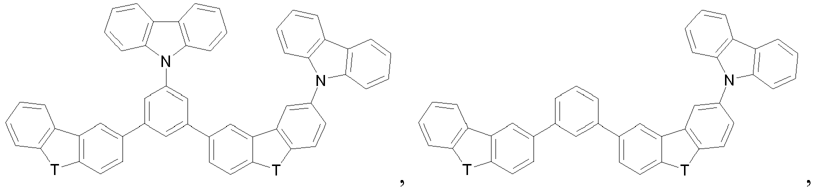 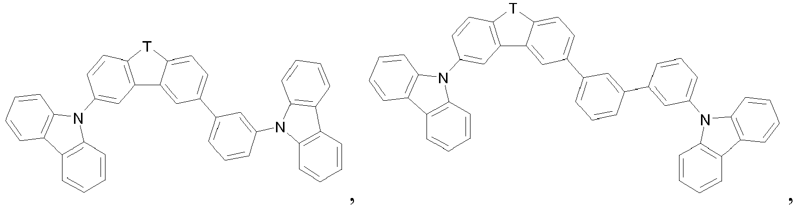 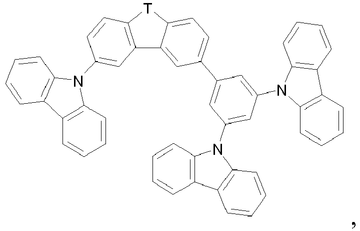 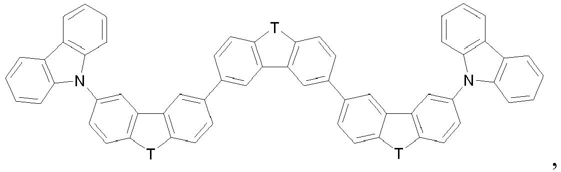 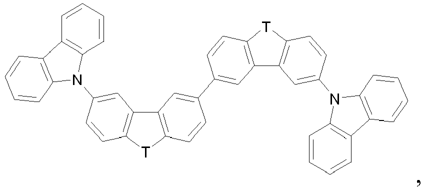 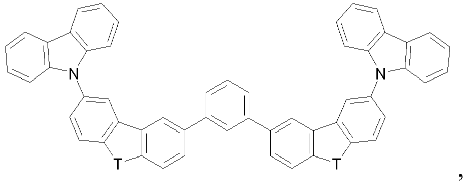 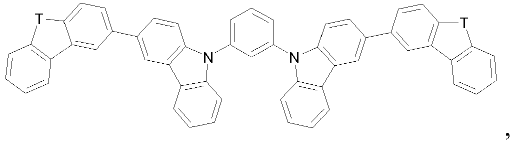 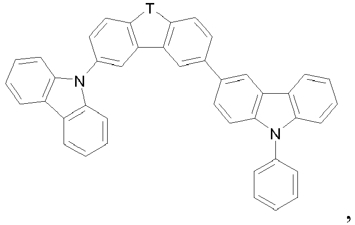 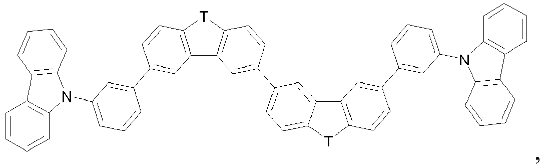 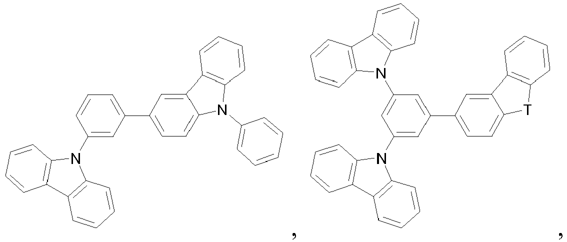 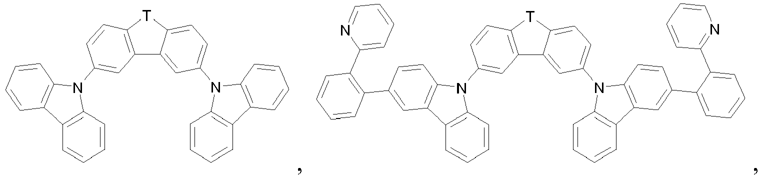 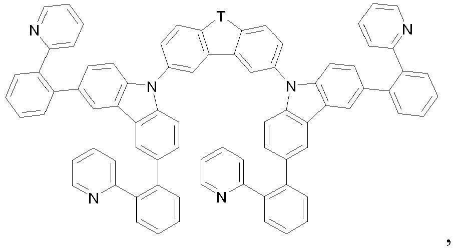 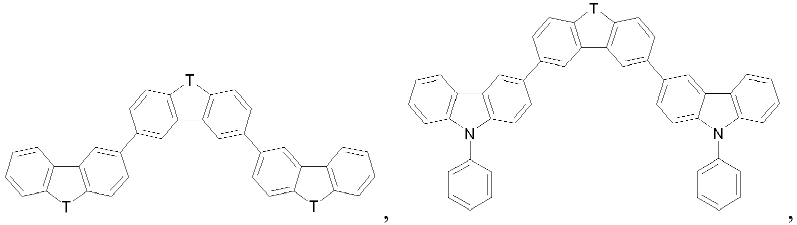 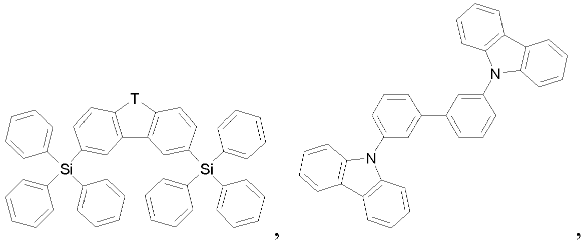 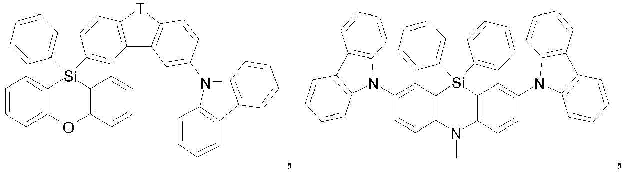 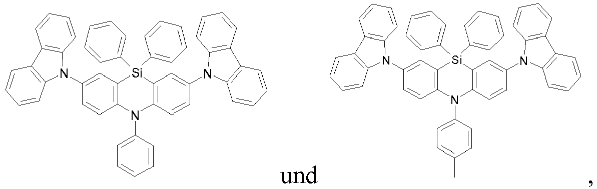 wobei T für O oder S steht.

14. Organische Vorrichtung zur Emission von Licht gemäß einem der Ansprüche 2 bis 13, wobei die zweite Host-Verbindung eine Verbindung ist gemäß den Formeln 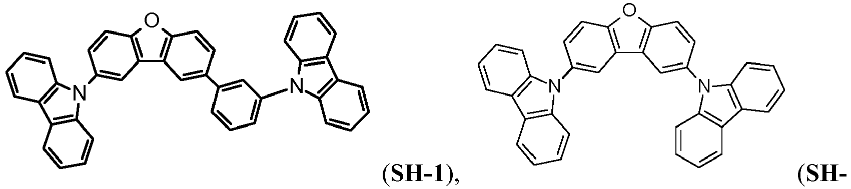 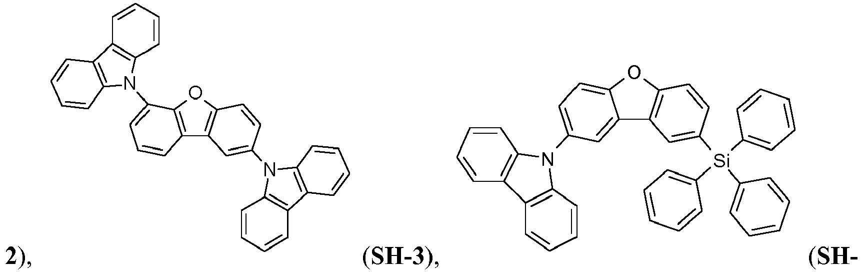 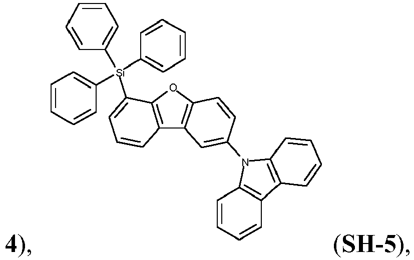 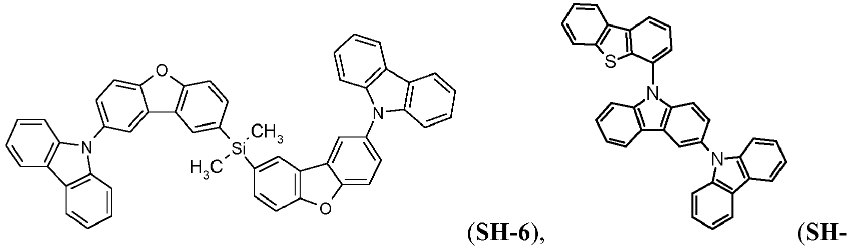 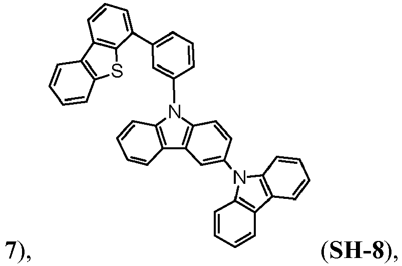 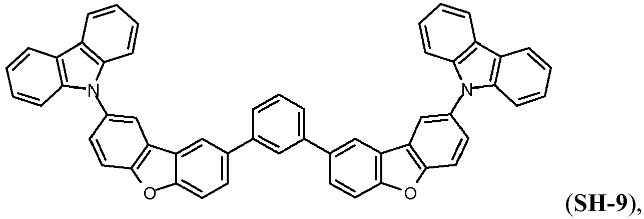 oder

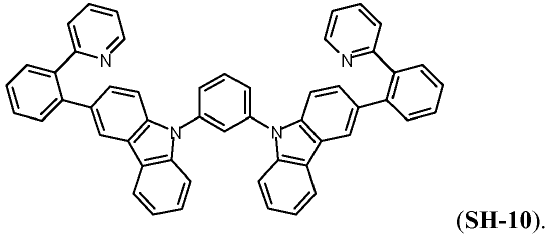

15. Organische Vorrichtung zur Emission von Licht gemäß einem der Ansprüche 2 bis 14, wobei die Lochtransportschicht eine Verbindung gemäß den Formeln aufweist 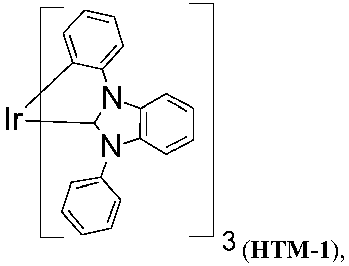 oder

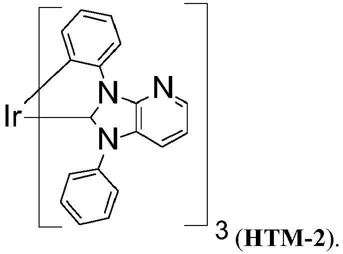

16. Organische Vorrichtung zur Emission von Licht gemäß einem der Ansprüche 2 bis 15, wobei die Elektrontransportschicht eine Verbindung gemäß den Formeln aufweist 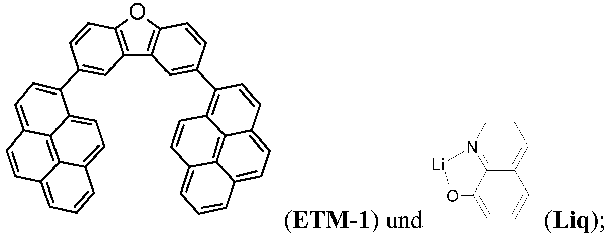 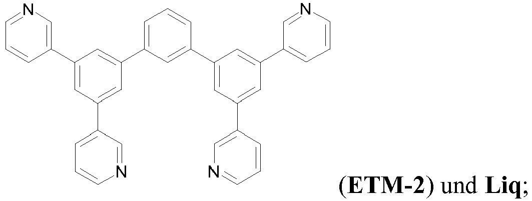 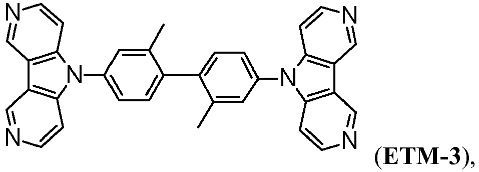 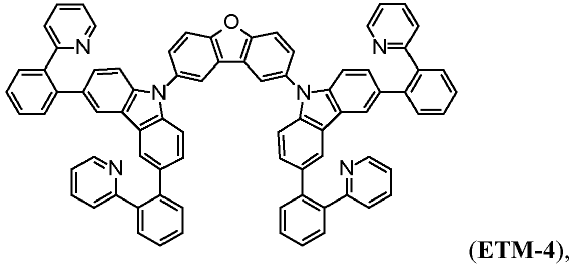 oder

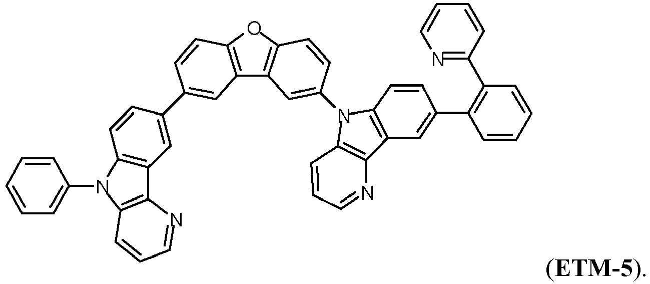

17. Organische Vorrichtung zur Emission von Licht gemäß einem der Ansprüche 2 bis 16,
in dieser Reihenfolge aufweisend:
(a) eine Anode,
(b) **(sulfonated poly(thiophene-3-[2[(2-methoxyethoxy)ethoxy]-2,5-diyl)** (Lochinjektionsschicht),
(c) **MoO₃**/ **HTM-1** (Lochtransportschicht),
(d) **HTM-1** (Exzitonblockierungsschicht),
(e) emittierende Schicht, aufweisend:
(e1) **RE-2** / **HTM-1** (erste lichtemittierende Schicht),
(e2) **BE-1** / **GE-1** / **SH-2** (zweite lichtemittierende Schicht),
(f) **SH-2** (Exzitonblockierungsschicht),
(g) **ETM-1** / **Liq** (Elektrontransportschicht),
(h) **KF** (Elektroninjektionsschicht), und
(i) eine Kathode; oder
in dieser Reihenfolge aufweisend:
(a) eine Anode,
(b) (sulfonated poly(thiophene-3-[2[(2-methoxyethoxy)ethoxy]-2,5-diyl) (Lochinjektionsschicht),
(c) **MoO₃/HTM-2** (Lochtransportschicht),
(d) **HTM-2** (Exzitonblockierungsschicht),
(e) emittierende Schicht, aufweisend:
(e1) **RE-2** / **HTM-2** (erste lichtemittierende Schicht),
(e2) **BE-1** / **GE-1** / **SH-2** (zweite lichtemittierende Schicht),
(f) **SH-2** (Exzitonblockierungsschicht),
(g) **ETM-1** / **Liq** (Elektrontransportschicht), und
h) KF (Elektroninjektionsschicht), und
(i) **Al** (Kathode); oder
in dieser Reihenfolge aufweisend:
(a) eine Anode,
(b) **(sulfonated poly(thiophene-3-[2[(2-methoxyethoxy)ethoxy]-2,5-diyl)** (Lochinjektionsschicht),
(c) **MoO₃**/**HTM-1** (Ir(DPBIC)₃) (Lochtransportschicht),
(d) **HTM-1** (Exzitonblockierungsschicht),
(e) emittierende Schicht, aufweisend:
(e1) **RE-1** / **HTM-1** (erste lichtemittierende Schicht),
(e2) **BE-1** / **GE-1** / **SH-1** (zweite lichtemittierende Schicht),
(f) **SH-1** (Exzitonblockierungsschicht),
(g) **ETM-1** / **Liq** (Elektrontransportschicht), und
(h) eine Kathode; oder
in dieser Reihenfolge aufweisend:
(a) eine Anode,
(b) (sulfonated poly(thiophene-3-[2[(2-methoxyethoxy)ethoxy]-2,5-diyl) (Lochinjektionsschicht),
(c) **MoO₃/HTM-2** (Lochtransportschicht),
(d) **HTM-2** (Exzitonblockierungsschicht),
(e) emittierende Schicht, aufweisend:
(e1) **RE-1** / **HTM-2** (erste lichtemittierende Schicht),
(e2) **BE-1** / **GE-1** / **SH-1** (zweite lichtemittierende Schicht),
(f) **SH-1** (Exzitonblockierungsschicht),
(g) **ETM-1** / **Liq** (Elektrontransportschicht), und
(h) eine Kathode.

18. Eine Vorrichtung ausgewählt aus der Gruppe bestehend aus stationären Bildschirmeinheiten; Beleuchtungseinheiten; Tastaturen; Kleidungsstücke; Möbel; Tapeten, uaufweisend die organische elektronische Vorrichtung gemäß einem der Ansprüche 2 bis 17, oder
die emittierende Schicht gemäß Anspruch 1.

19. Verwendung der emittierenden Schicht (e) gemäß Anspruch 1 zum Erzeugen von weißem Licht.

## Revendications

1. Couche émettrice (e) pour générer de la lumière blanche, comportant (e1) une première couche électroluminescente et (e2) une seconde couche électroluminescente, dans laquelle la première couche électroluminescente est en contact direct avec la seconde couche électroluminescente, la première couche électroluminescente comporte un émetteur de rouge phosphorescent et un premier composé hôte, la seconde couche électroluminescente comporte un émetteur de bleu phosphorescent, un émetteur de vert phosphorescent et un second composé hôte.

2. Dispositif organique émetteur de lumière blanche comportant :
(a) une anode,
(b) une cathode,
(e) une couche émettrice selon la revendication 1.

3. Dispositif électroluminescent organique selon la revendication 2, dans lequel la première couche électroluminescente est disposée entre l'anode et la seconde couche électroluminescente.

4. Dispositif électroluminescent organique selon la revendication 2 ou 3, comportant dans cet ordre :
(a) une anode,
(b) facultativement une couche d'injection de trous,
(c) une couche de transport de trous,
(d) une couche de blocage d'excitons,
(e) une couche émettrice comportant :
(e1) une première couche électroluminescente,
(e2) une seconde couche électroluminescente,
(f) une couche de blocage de trous/excitons,
(g) une couche de transport d'électrons,
(h) facultativement une couche d'injection d'électrons, et
(i) une cathode.

5. Dispositif électroluminescent organique selon l'une quelconque des revendications 2 à 4, dans lequel l'émetteur de rouge phosphorescent est un composé de formule : 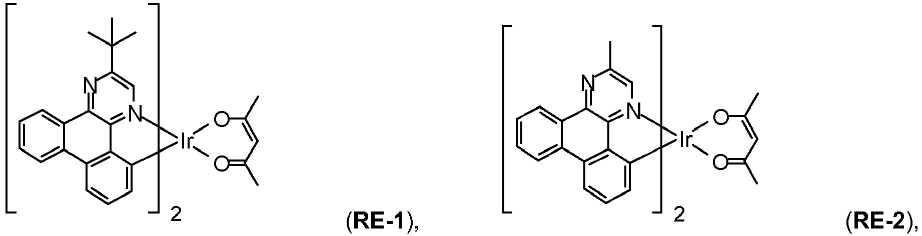 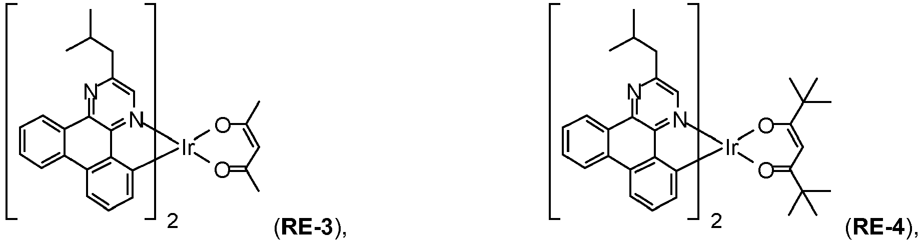 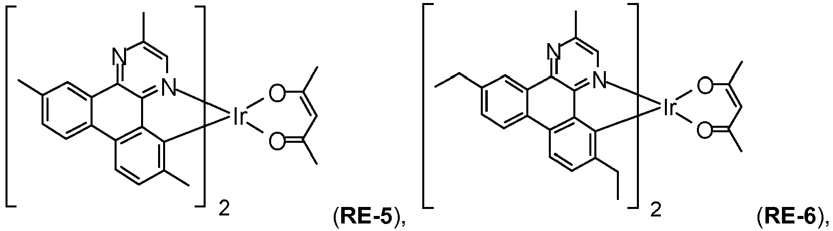 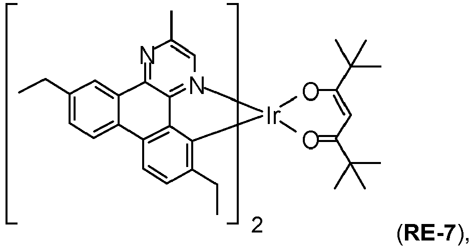 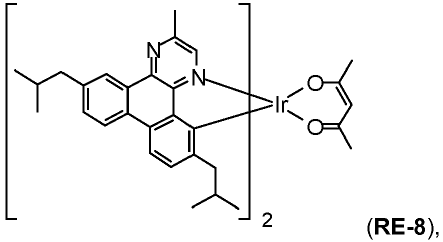 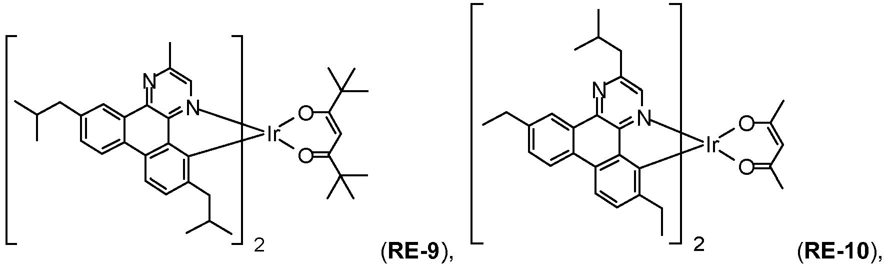 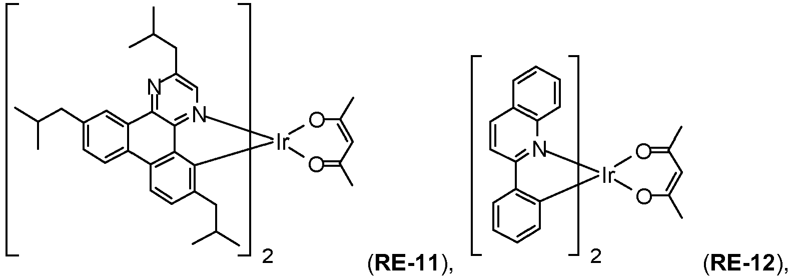 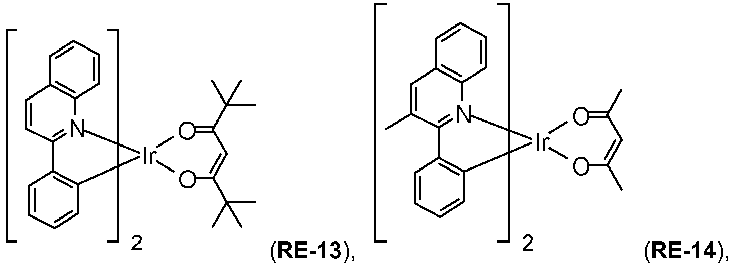 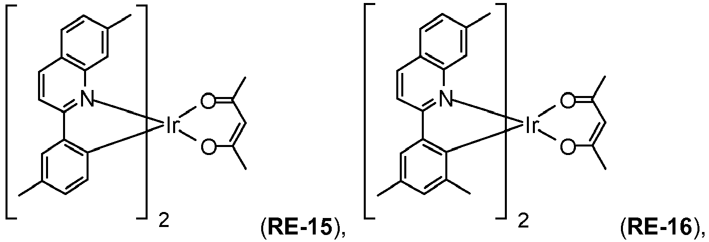 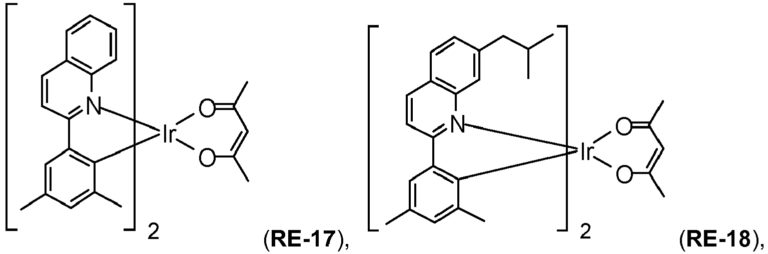 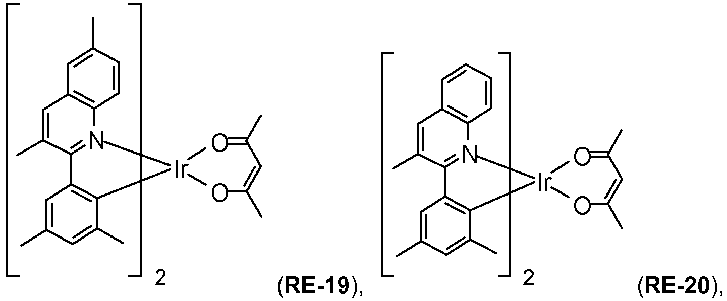 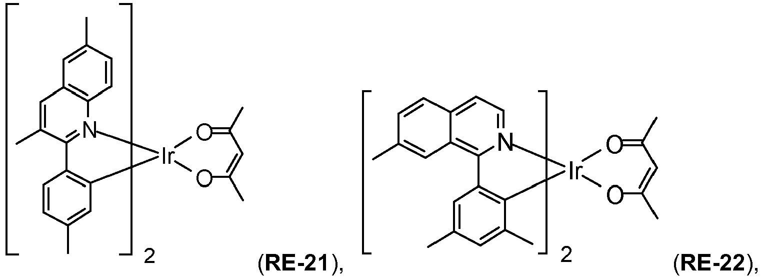 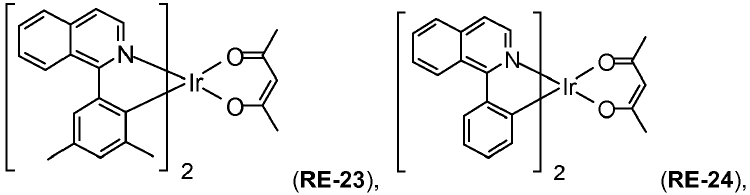 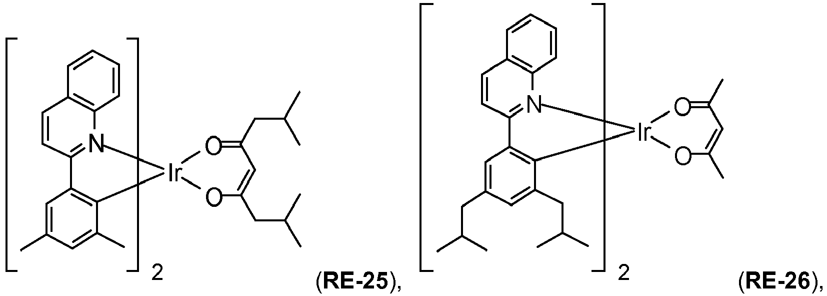 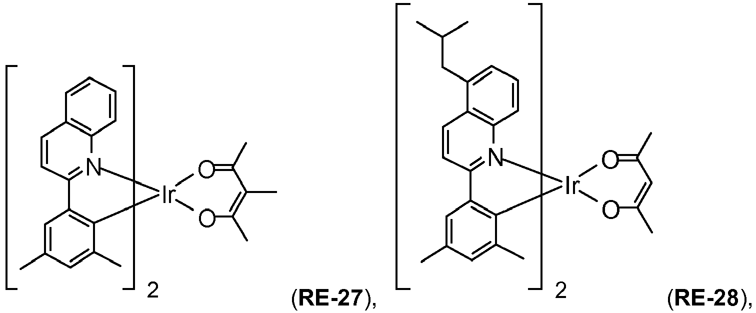 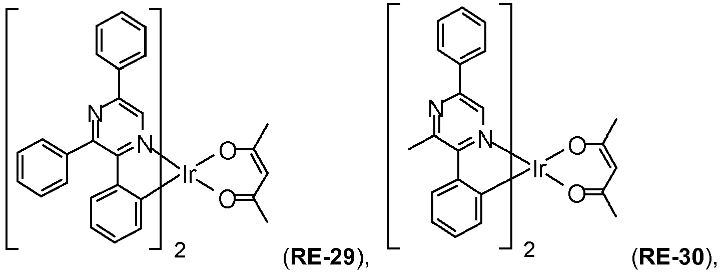 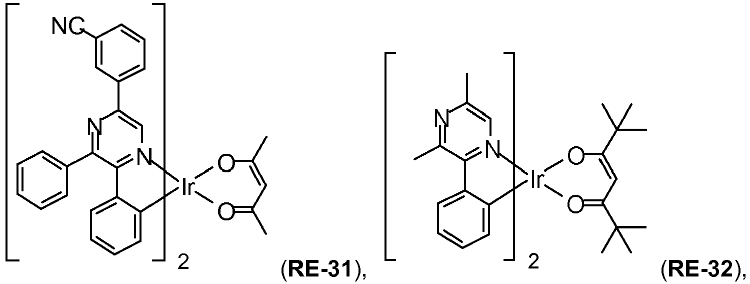 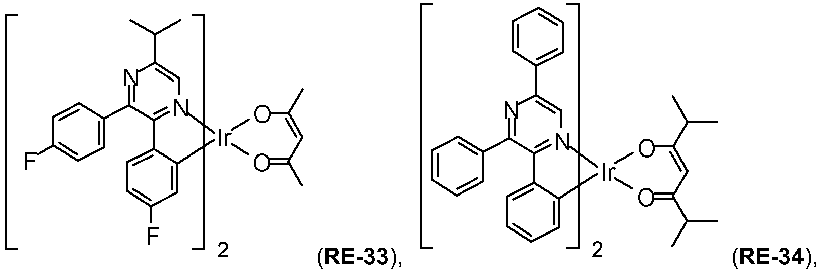 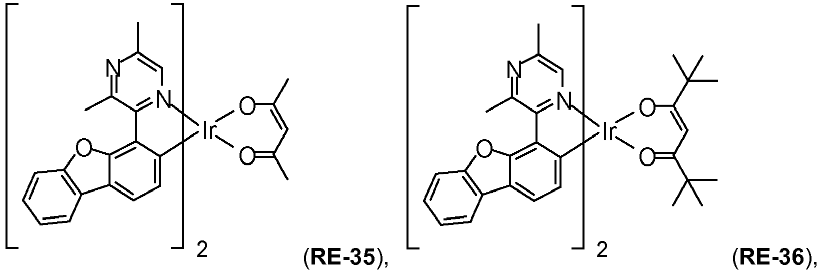 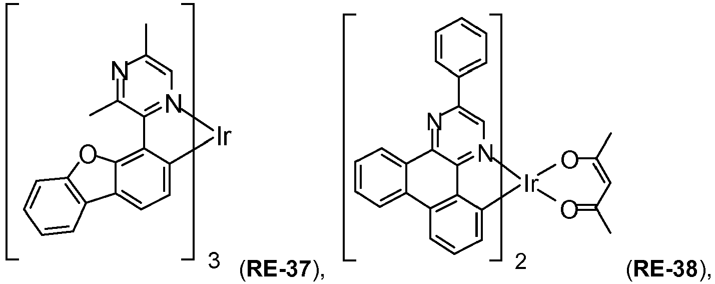 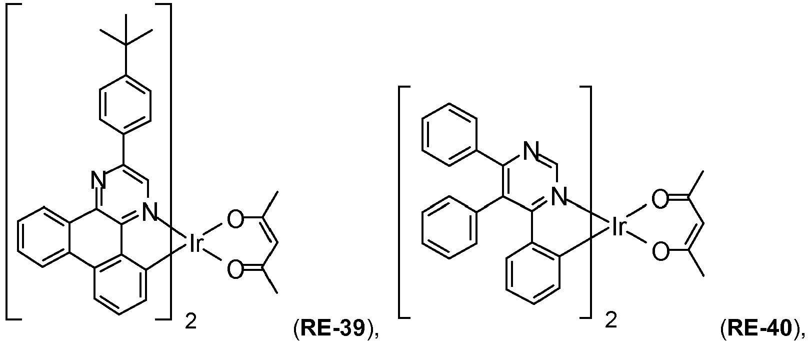 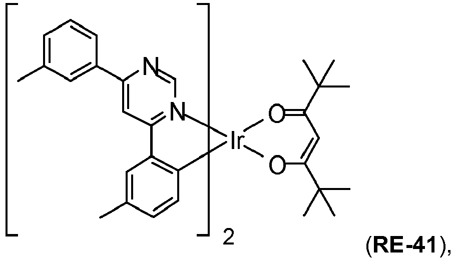 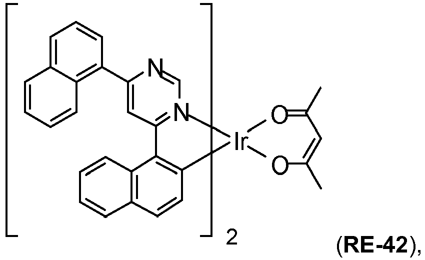 ou

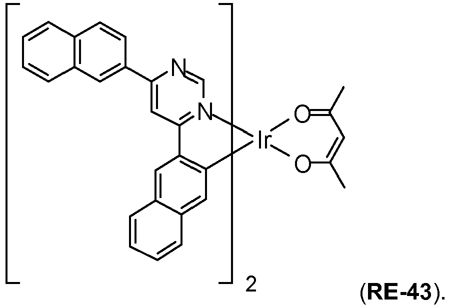

6. Dispositif électroluminescent organique selon la revendication 5, dans lequel l'émetteur de rouge phosphorescent est un composé de formule :

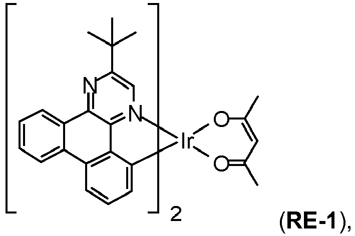

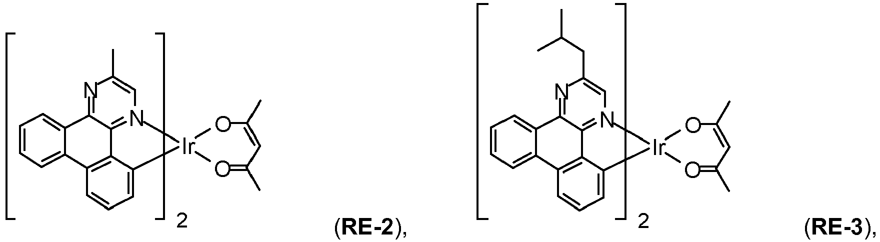

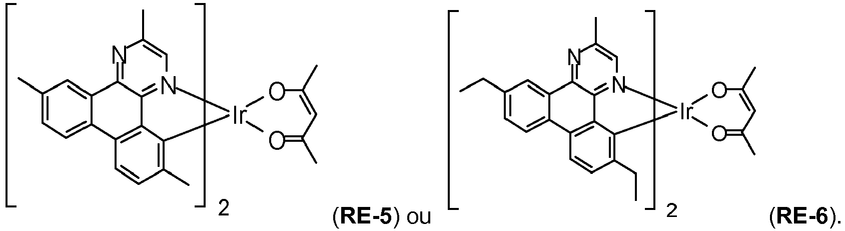

7. Dispositif électroluminescent organique selon l'une quelconque des revendications 2 à 6, dans lequel le premier composé hôte est un composé de formule : 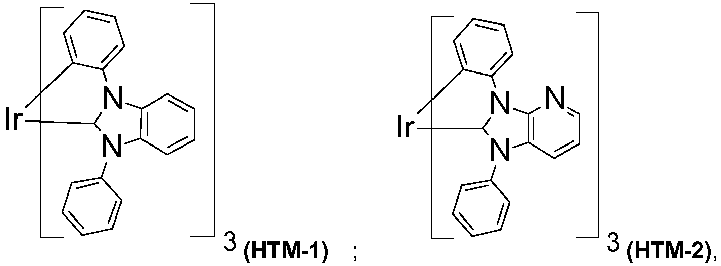 4,4'-bis[N-(1-naphthyl)-N-phénylamino]biphényl (FH-1), ou 4,4',4"-tris(*N*-carbazolyl)triphénylamine (FH-2).

8. Dispositif électroluminescent organique selon la revendication 7, dans lequel le premier composé hôte est un composé de formule :

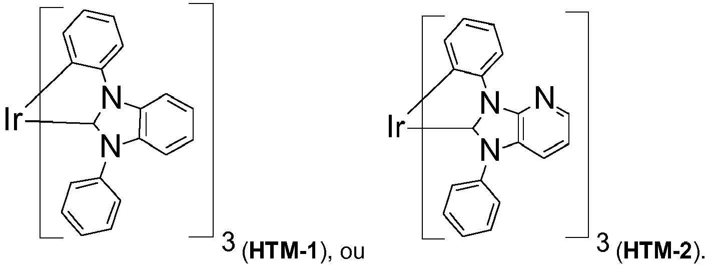

9. Dispositif électroluminescent organique selon l'une quelconque des revendications 2 à 8, dans lequel l'émetteur de bleu phosphorescent est un composé de formule :

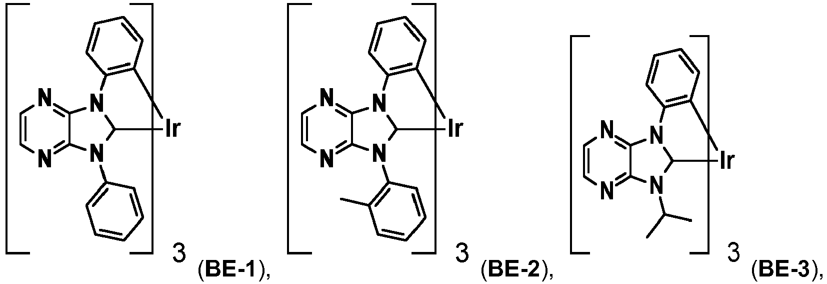

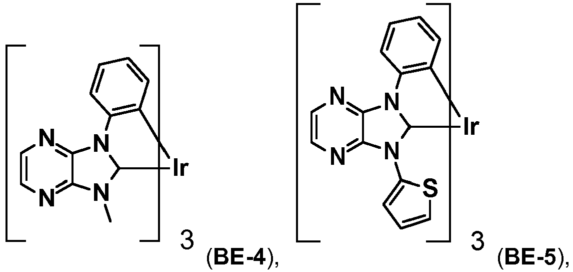

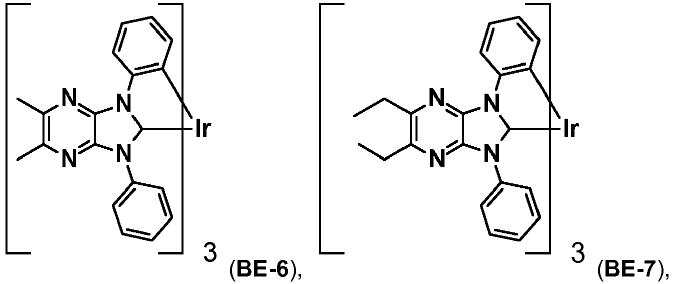

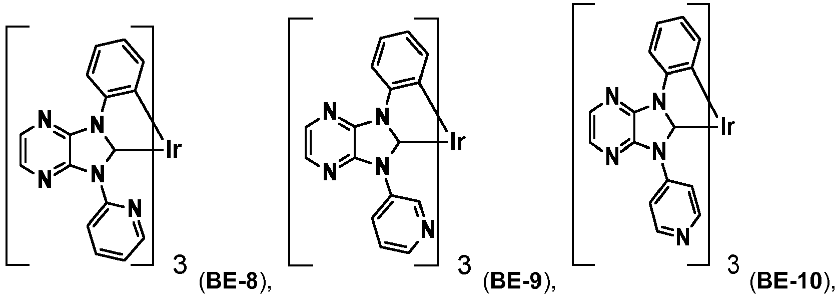

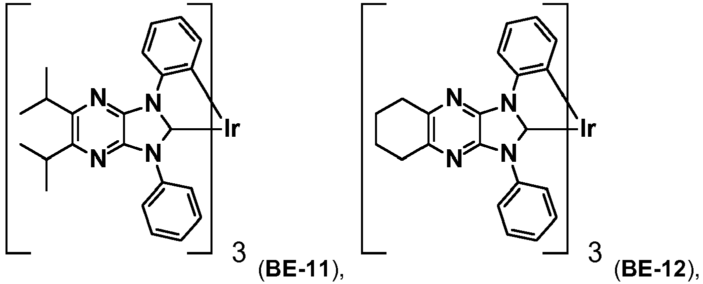

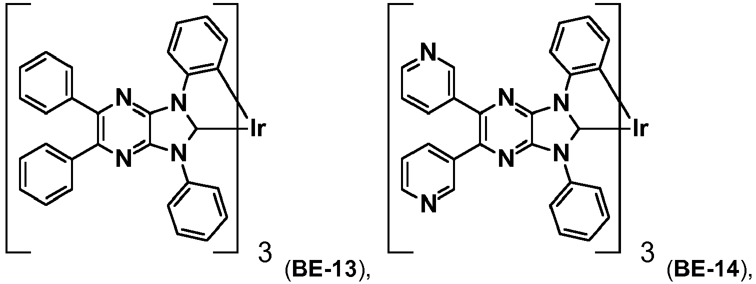

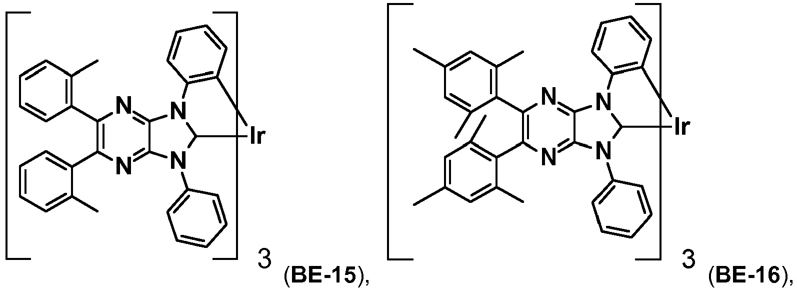

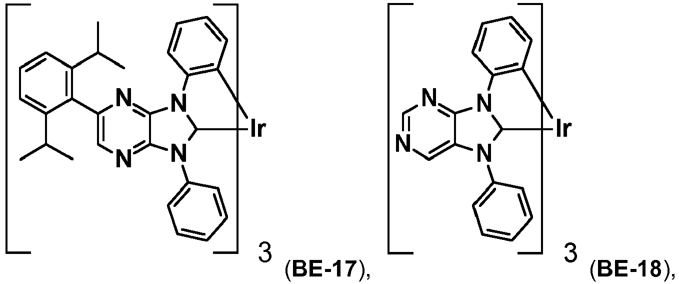

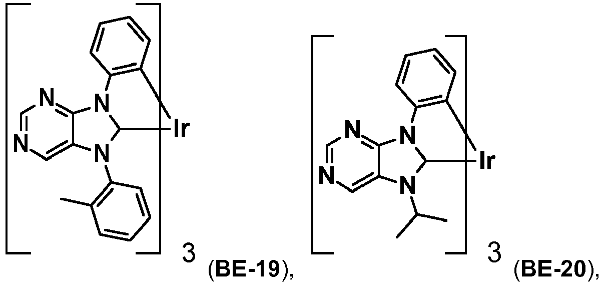

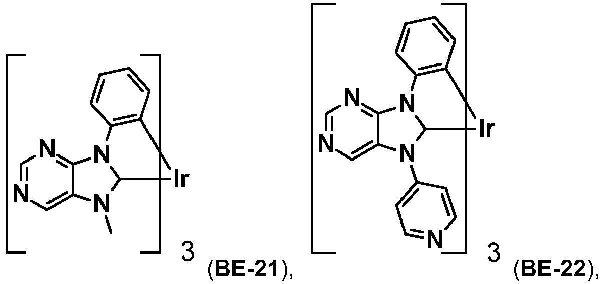

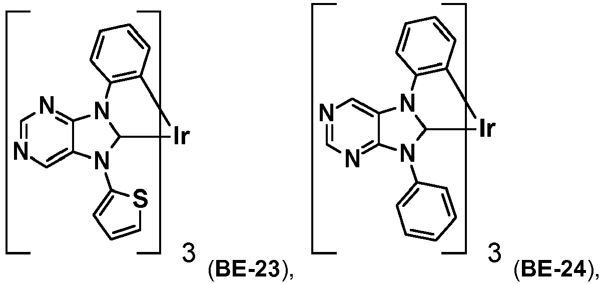

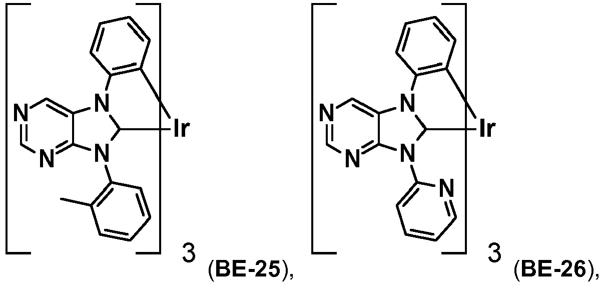

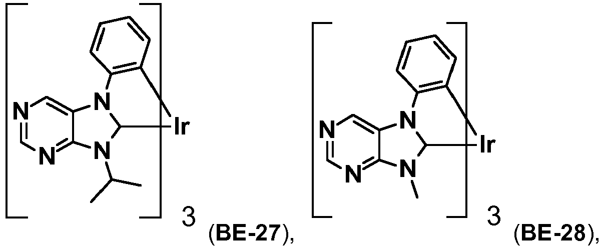

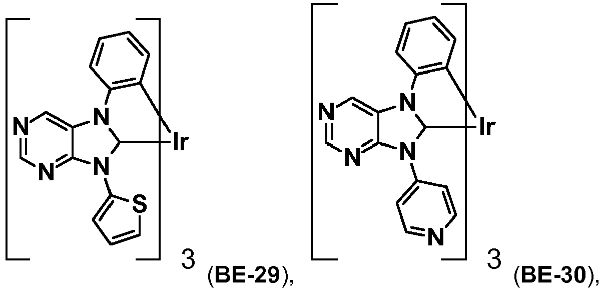

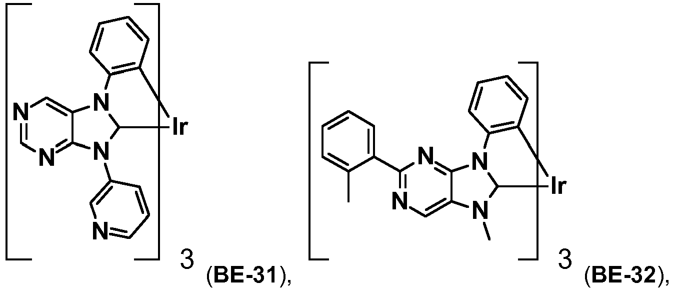

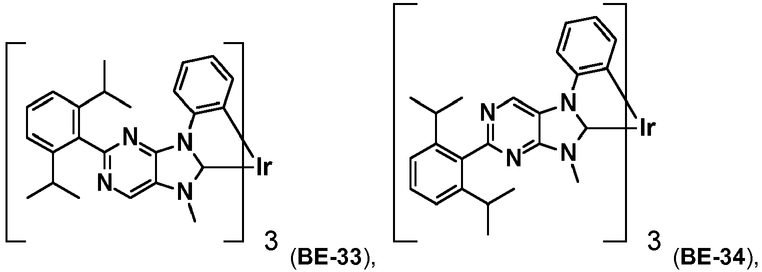

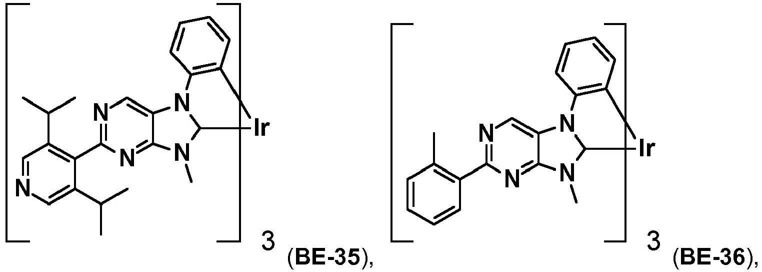

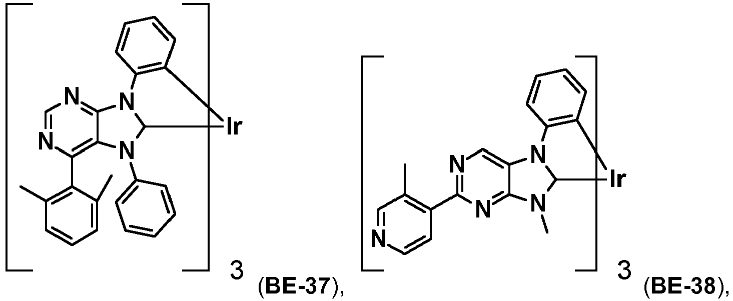

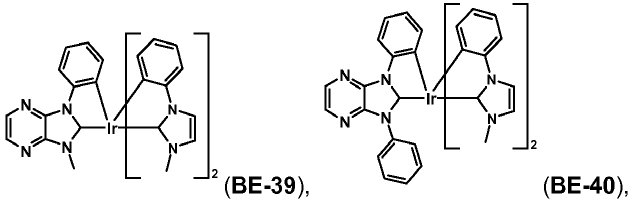

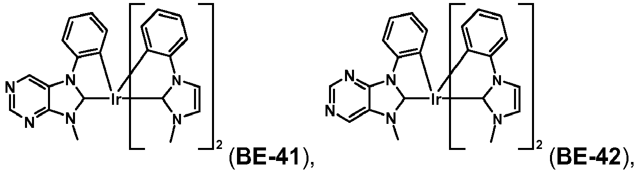

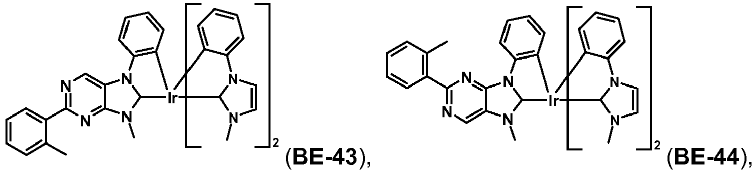

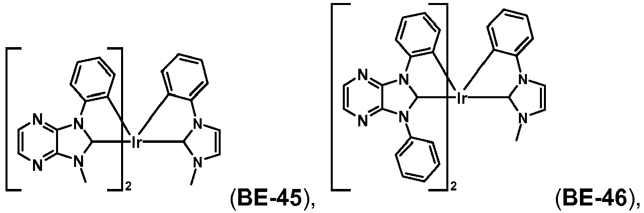

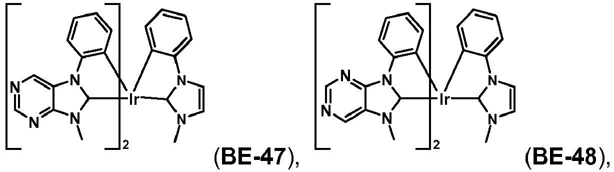

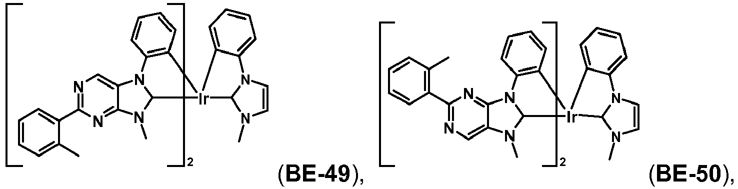

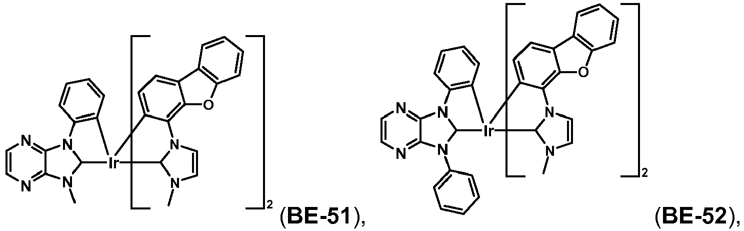

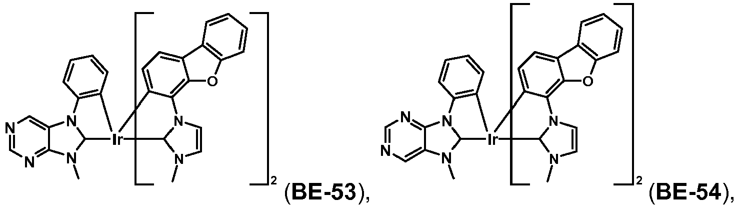

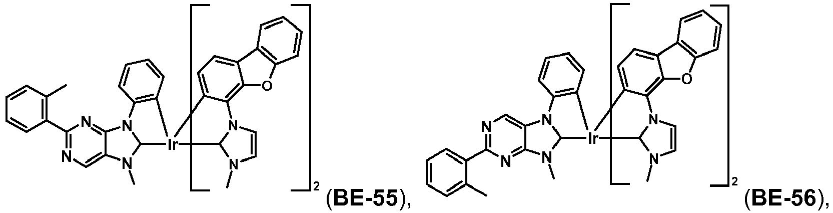

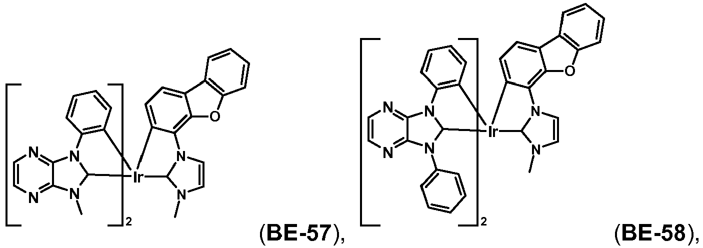

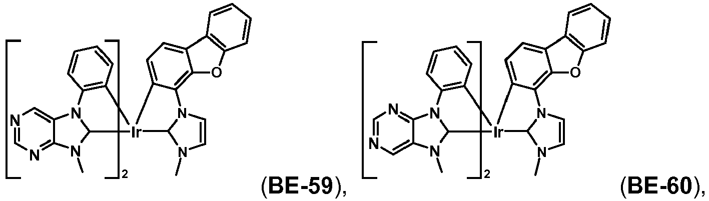

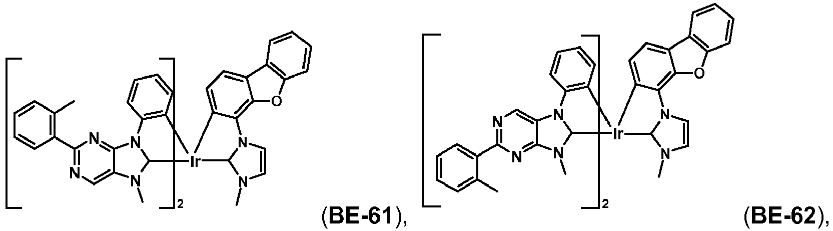

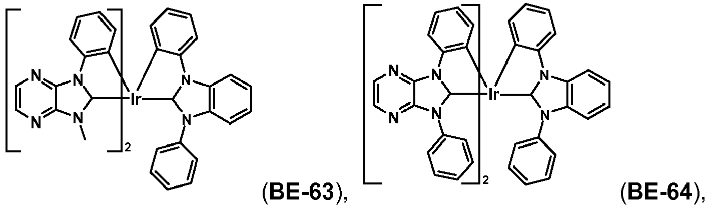

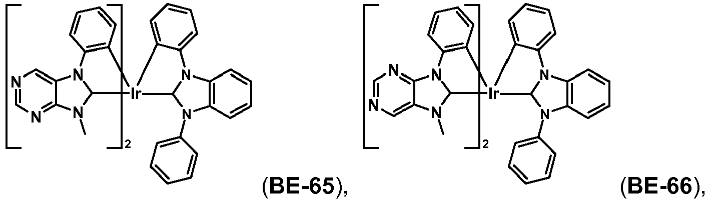

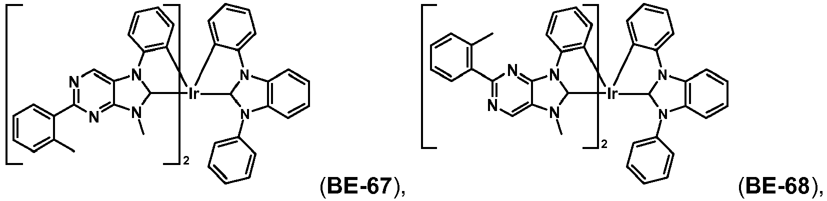

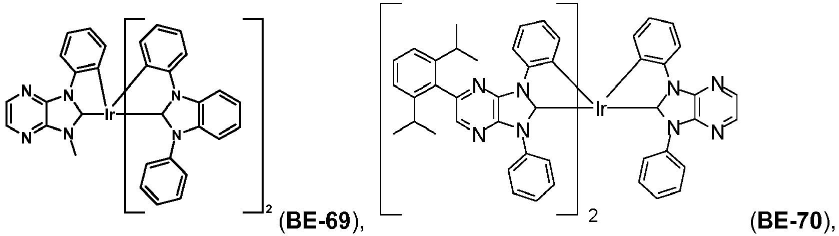

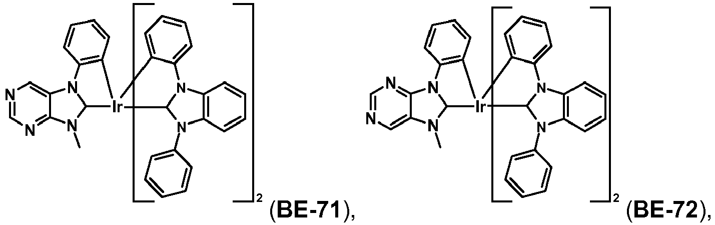

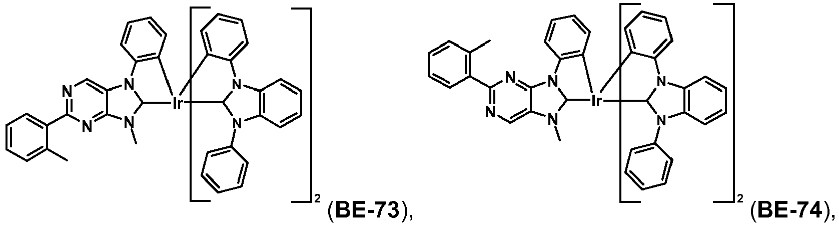

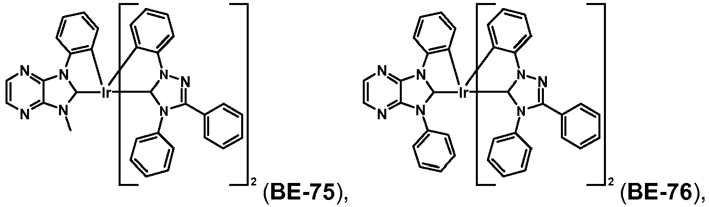

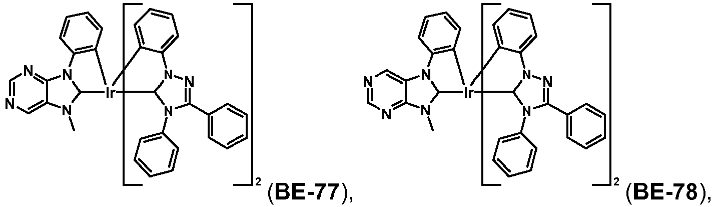

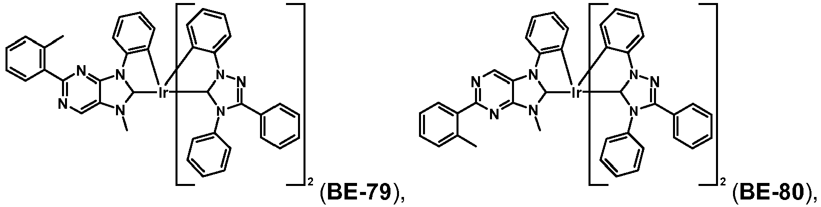

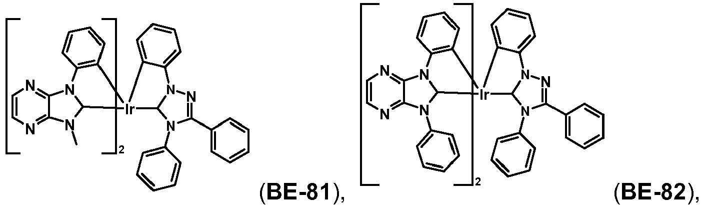

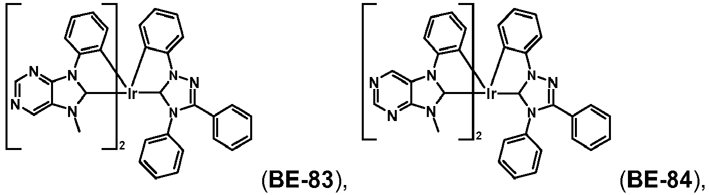

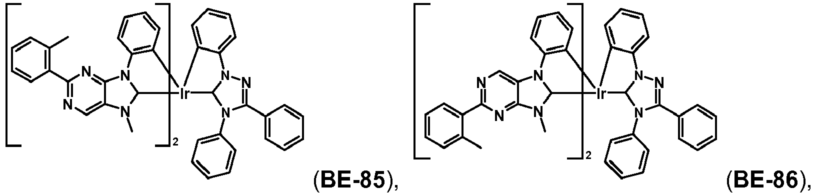

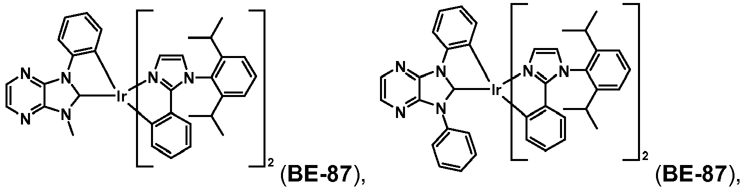

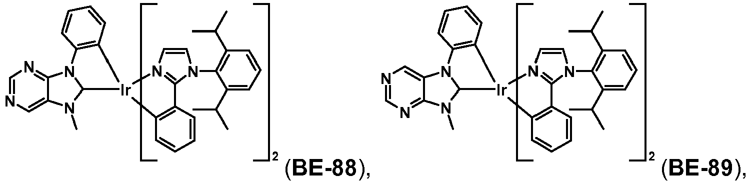

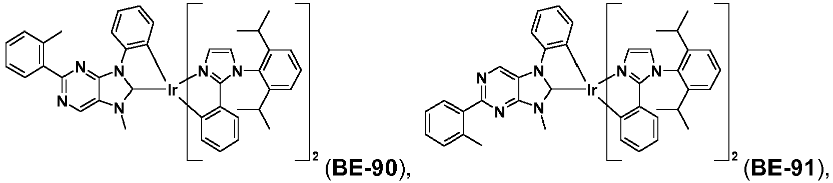

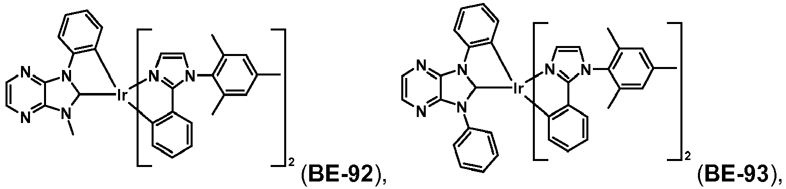

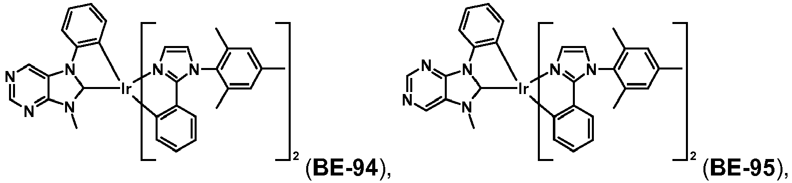

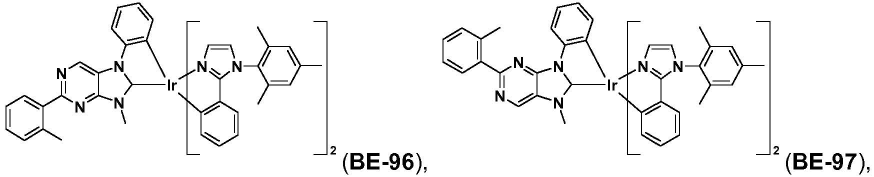

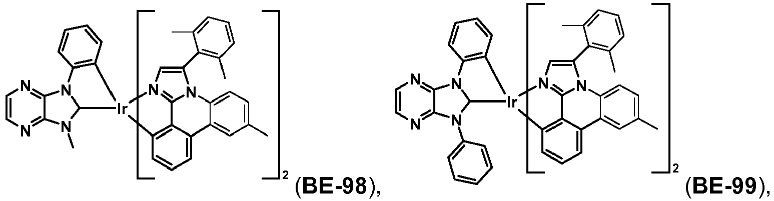

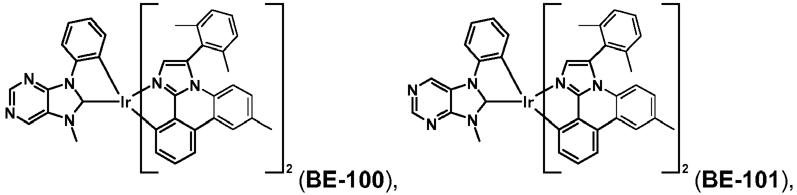

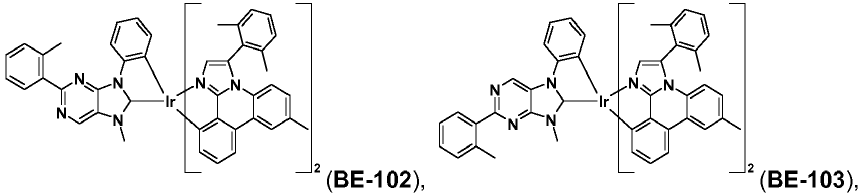

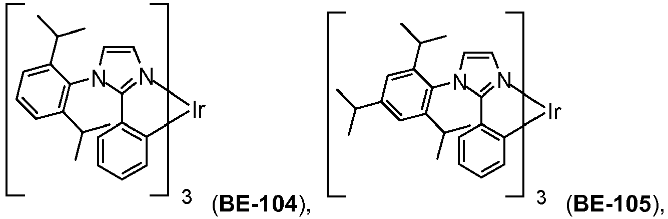

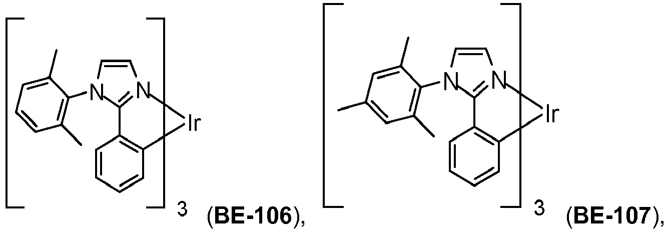

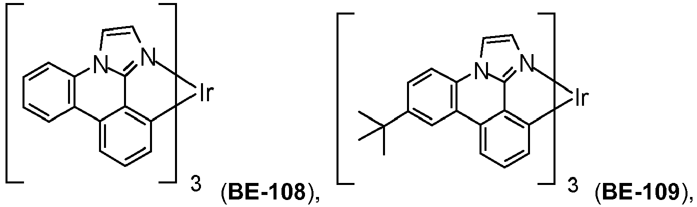

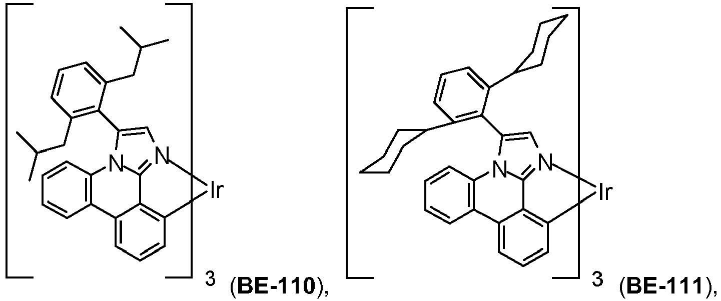

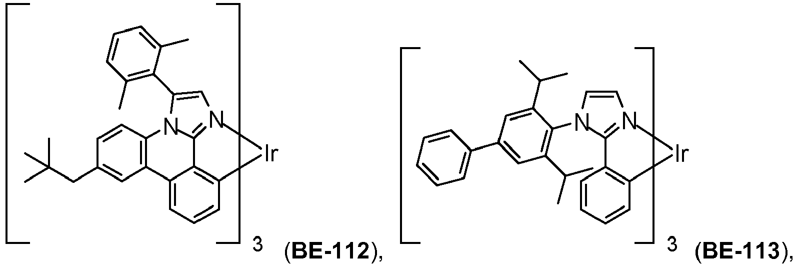

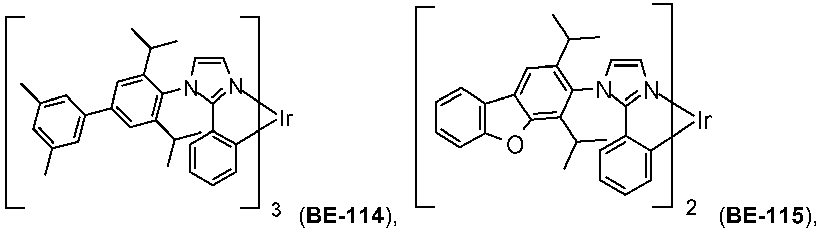

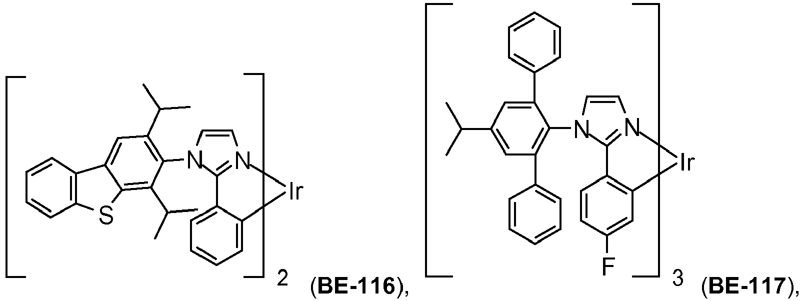

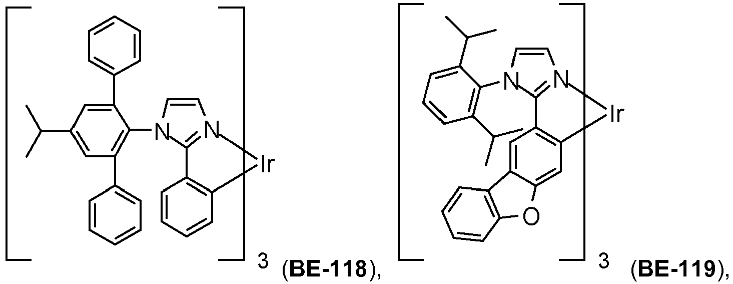

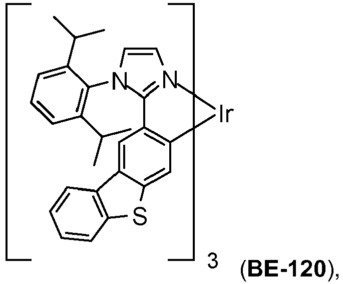

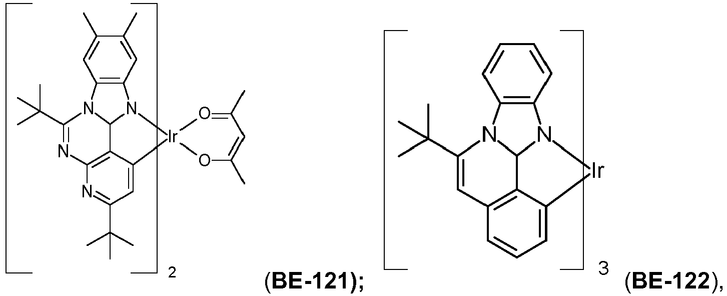

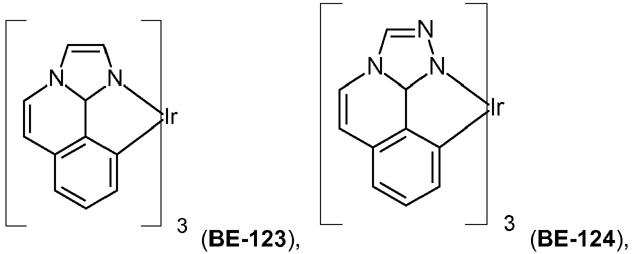

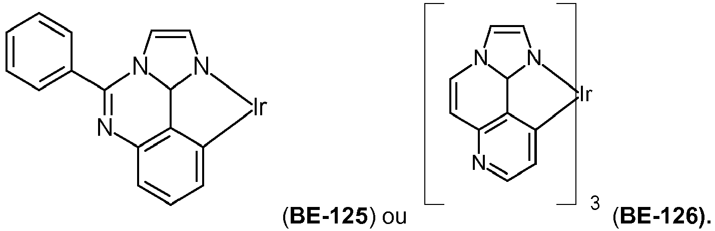

10. Dispositif électroluminescent organique selon l'une quelconque des revendications 2 à 9, dans lequel l'émetteur de bleu phosphorescent est un composé de formule :

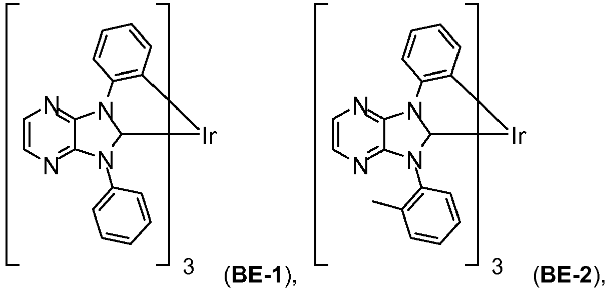

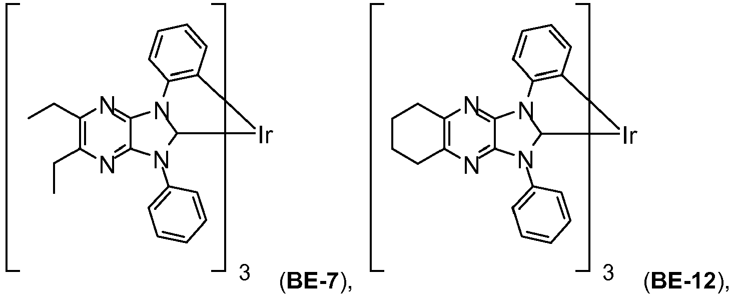

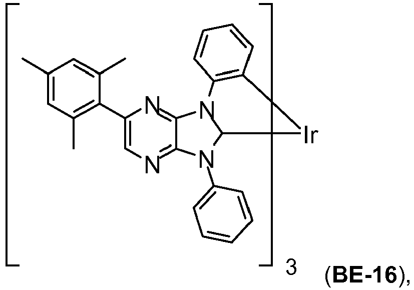

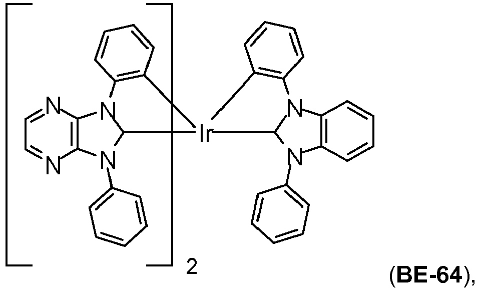

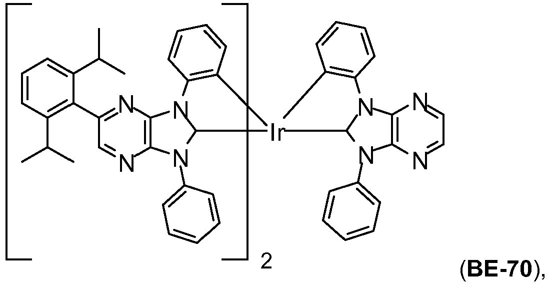

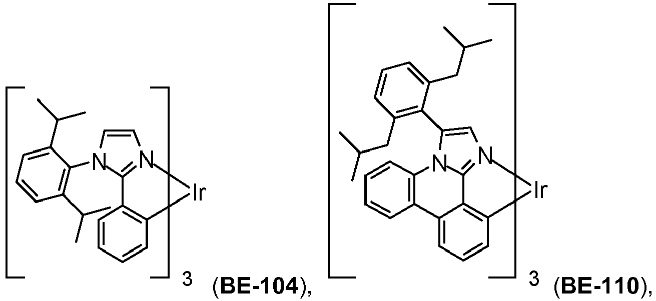

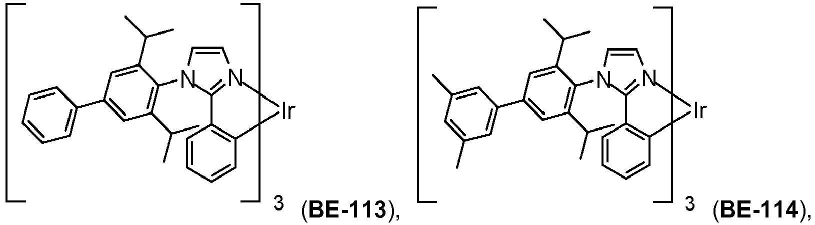

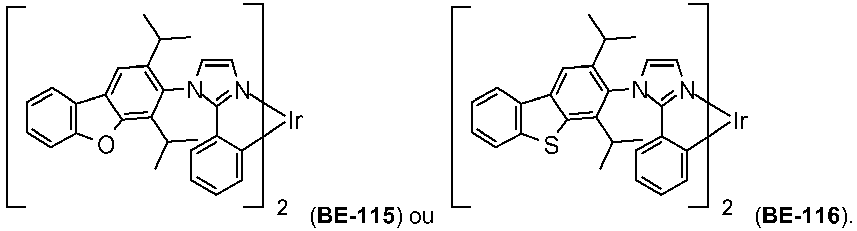

11. Dispositif électroluminescent organique selon l'une quelconque des revendications 2 à 10, dans lequel l'émetteur de vert phosphorescent est un composé de formule :

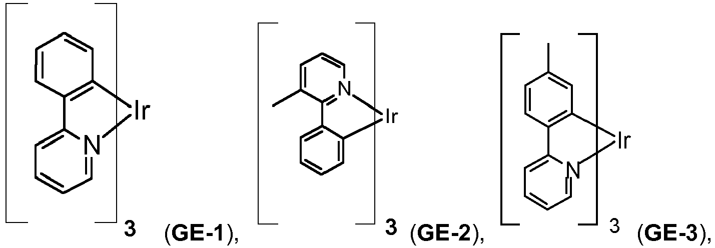

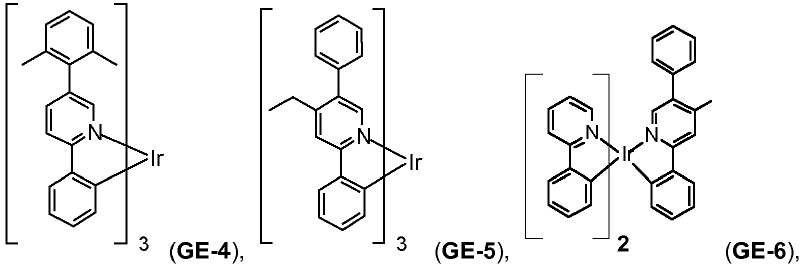

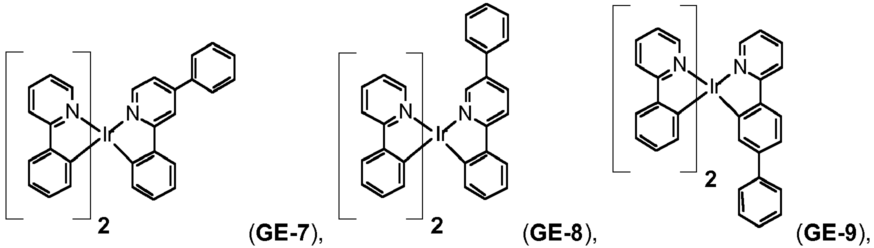

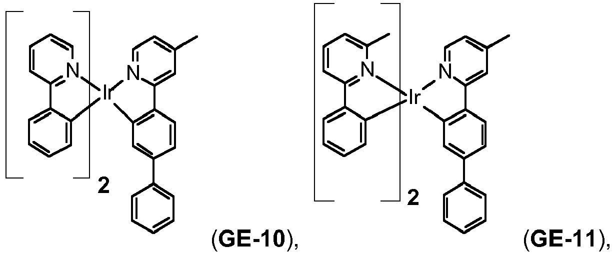

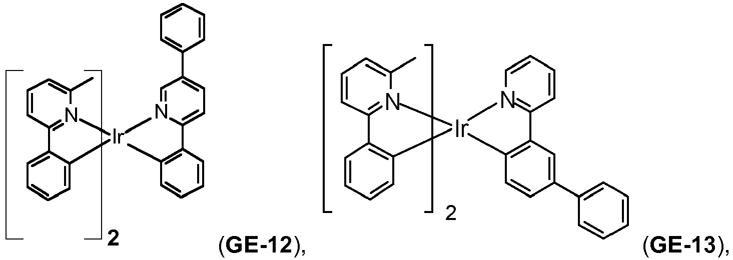

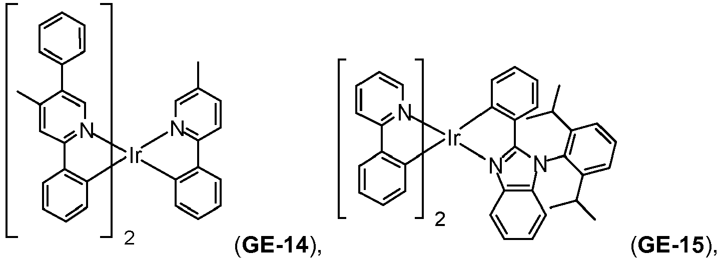

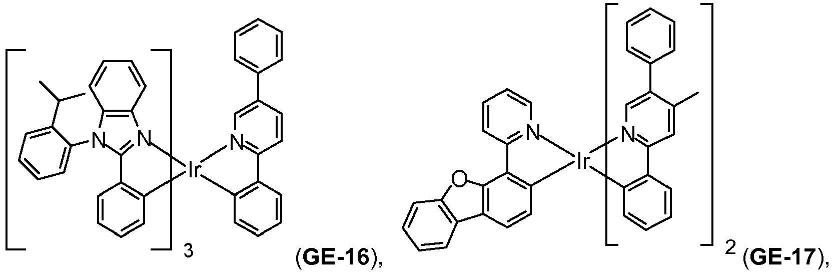

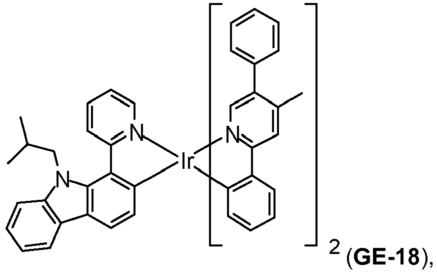

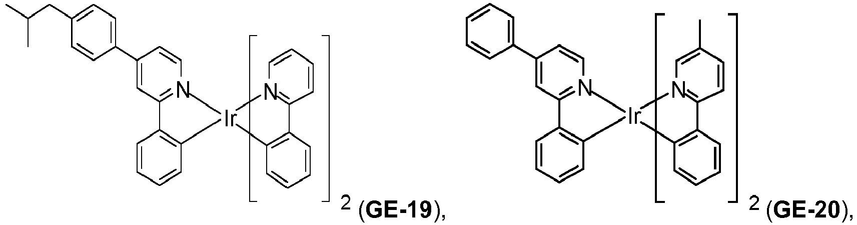

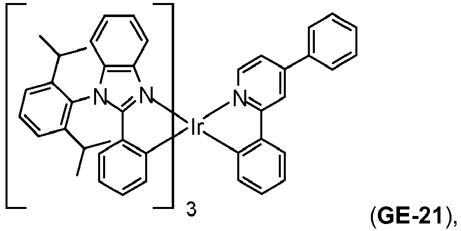

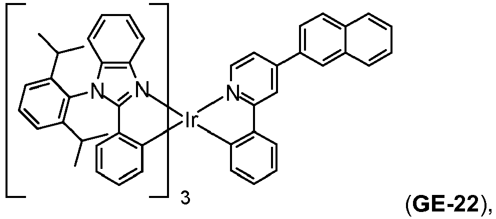

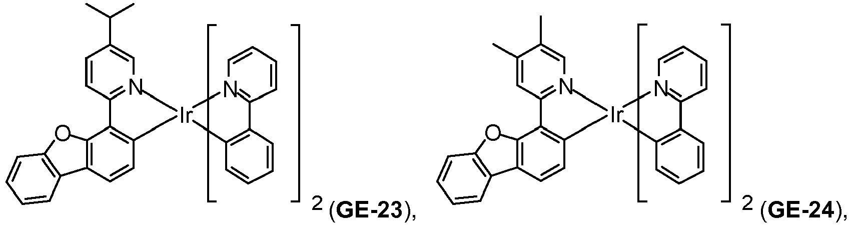

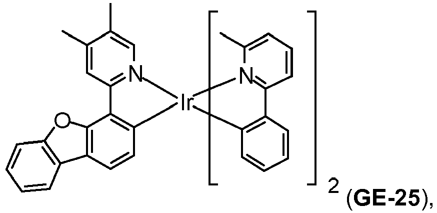

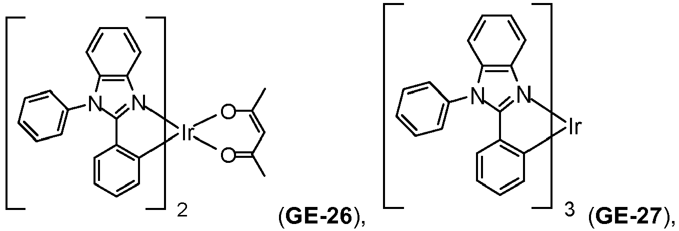

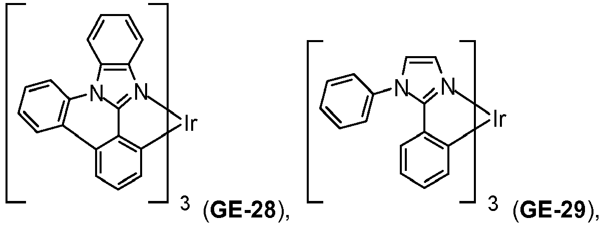

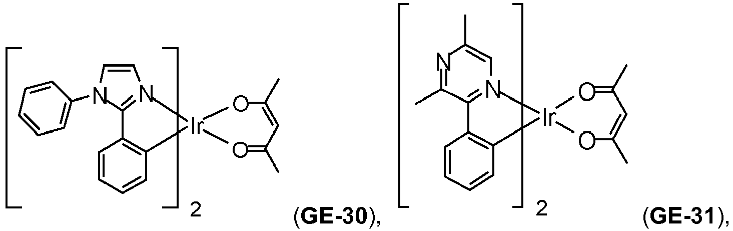

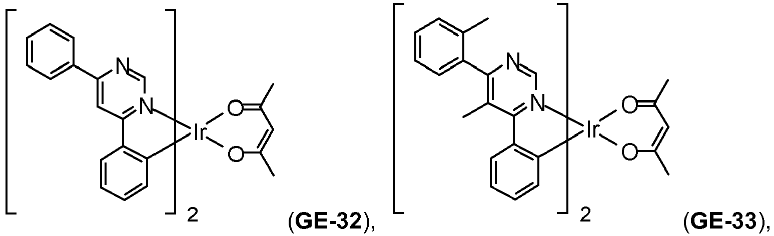

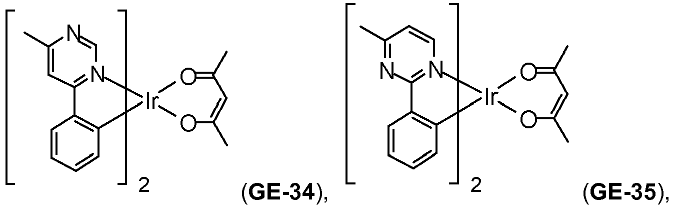

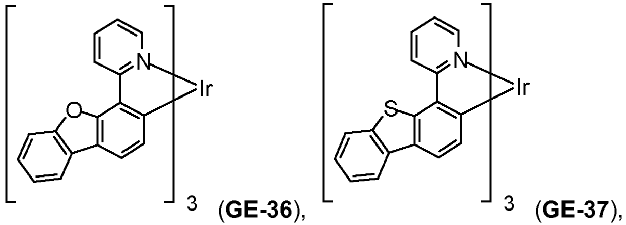

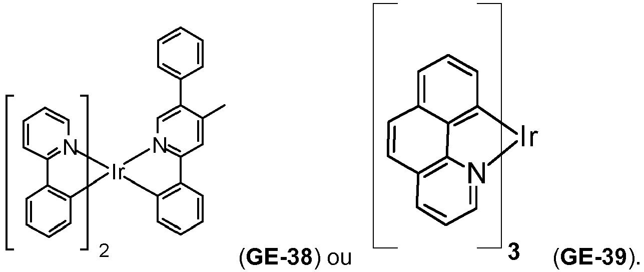

12. Dispositif électroluminescent organique selon la revendication 11, dans lequel l'émetteur de vert phosphorescent est un composé de formule : 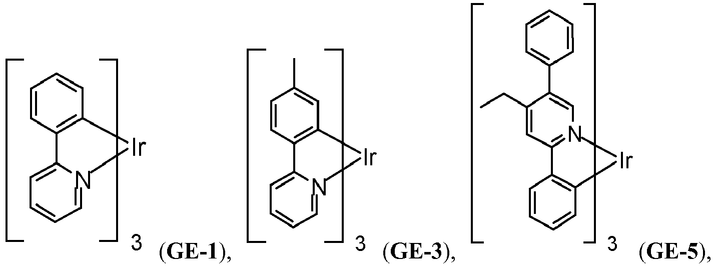 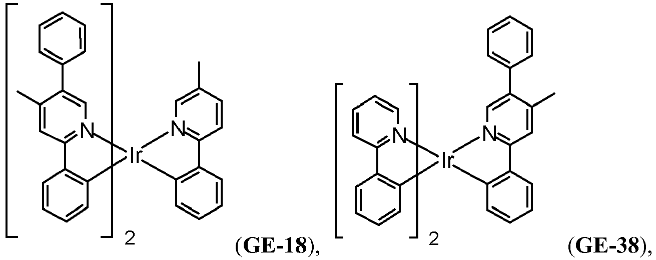 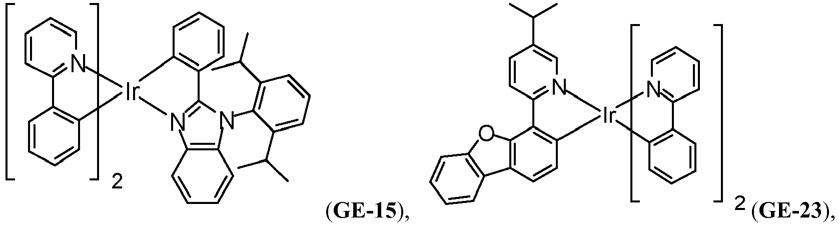 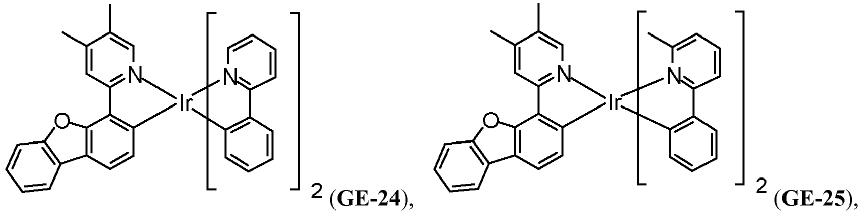 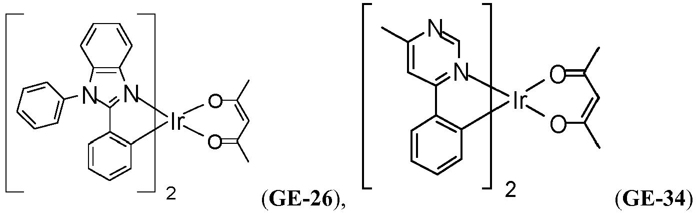 ou

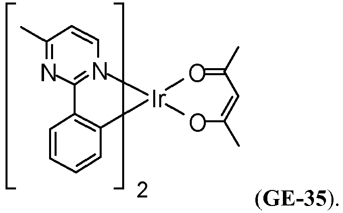

13. Dispositif électroluminescent organique selon l'une quelconque des revendications 2 à 12, dans lequel le second composé hôte est un composé de formule : 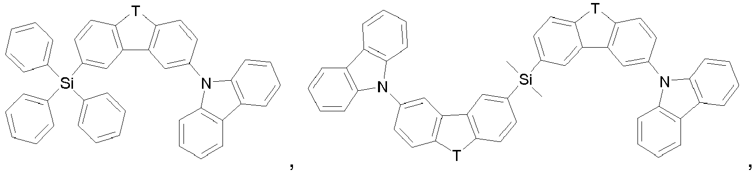 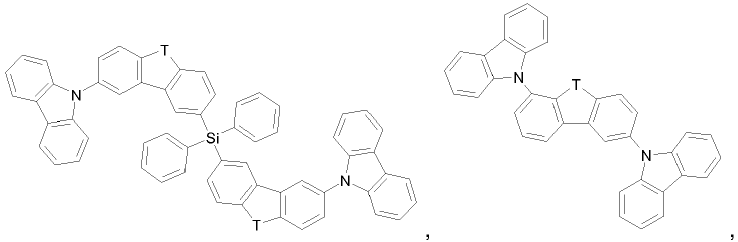 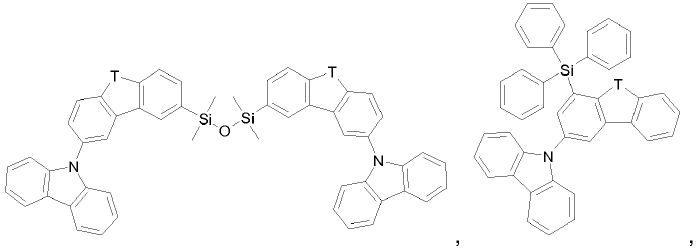 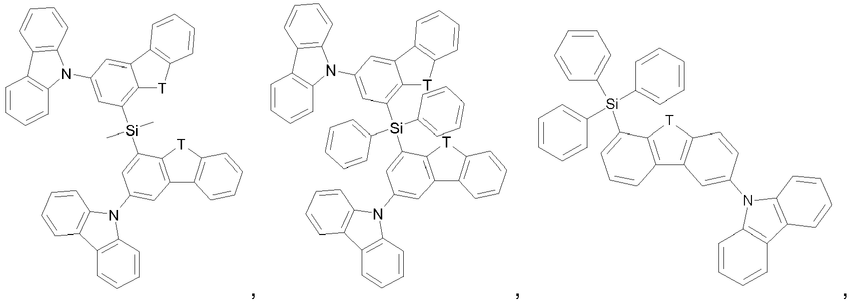 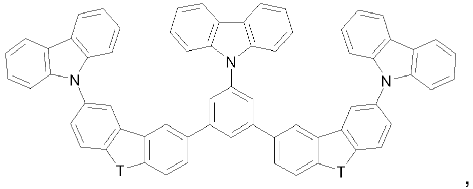 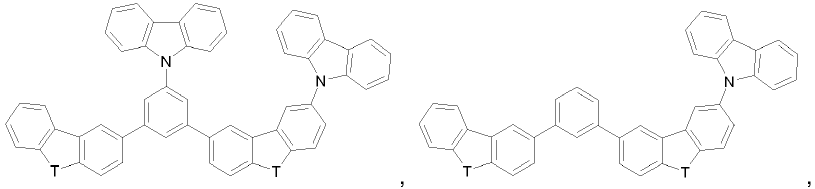 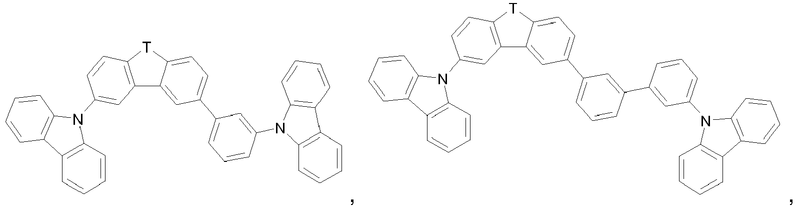 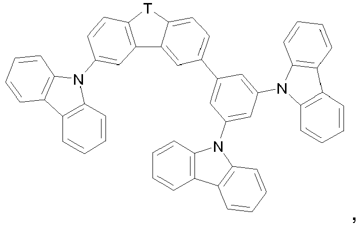 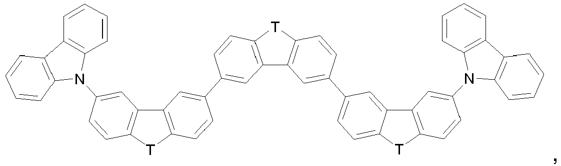 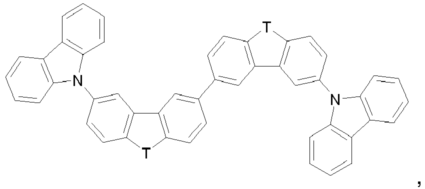 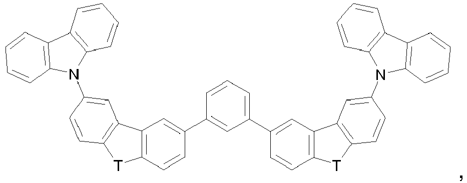 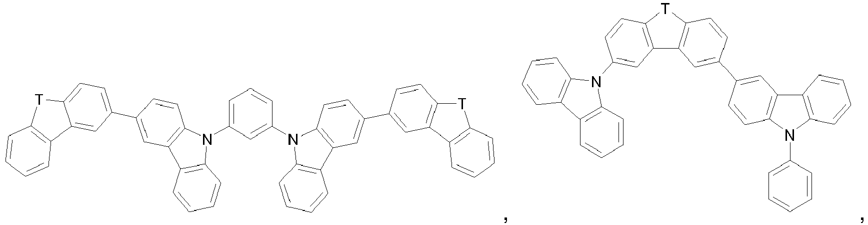 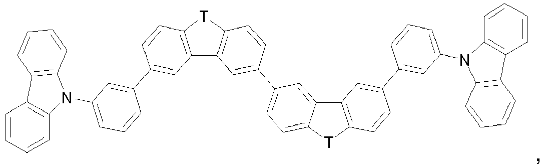 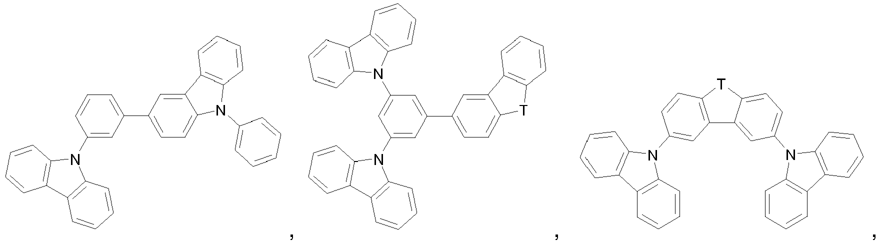 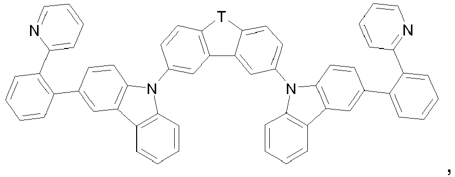 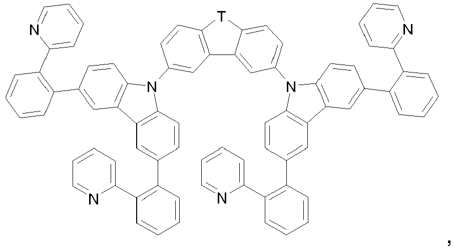 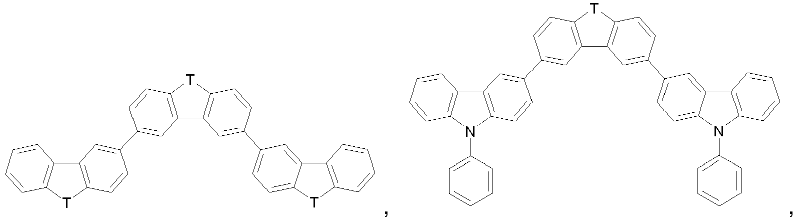 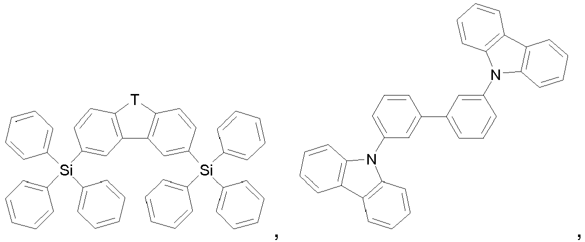 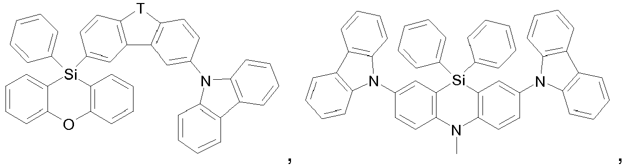 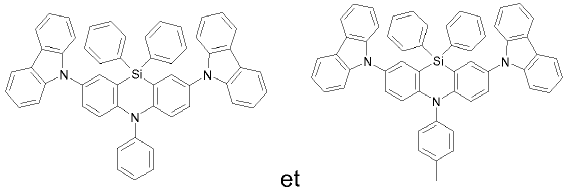 dans laquelle T représente O ou S.

14. Dispositif électroluminescent organique selon l'une quelconque des revendications 2 à 13, dans lequel le second composé hôte est un composé de formule : 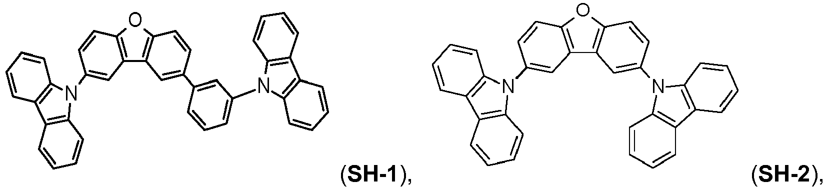 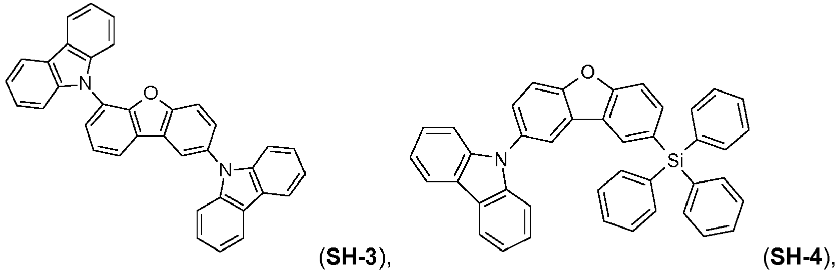 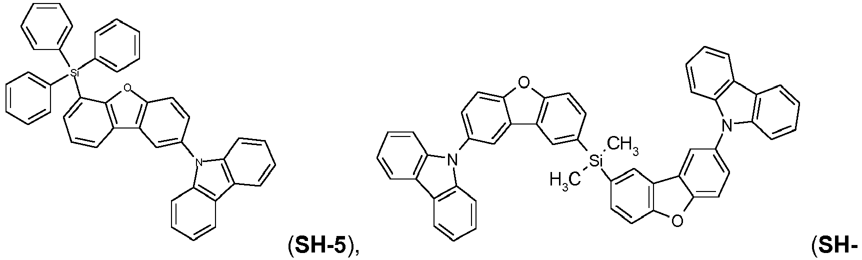 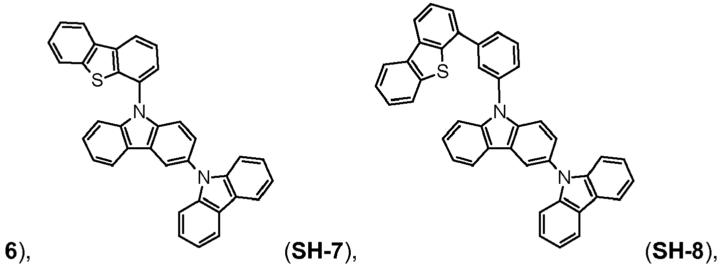 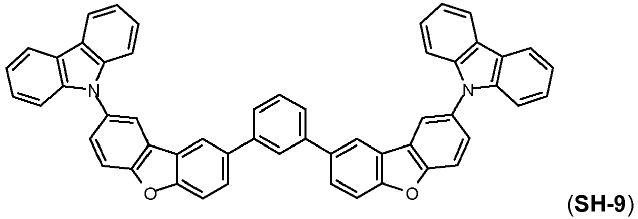 ou

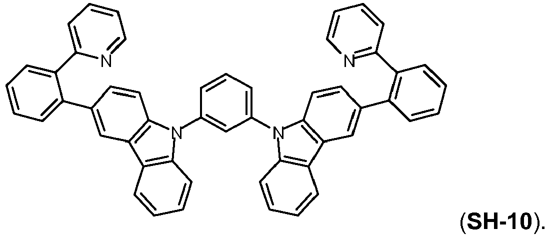

15. Dispositif électroluminescent organique selon l'une quelconque des revendications 2 à 14, dans lequel la couche de transport de trous comporte un composé de formule : 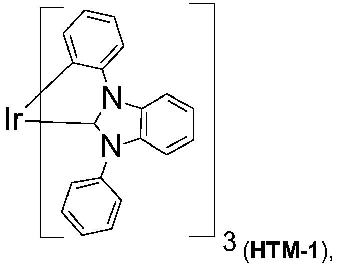 ou

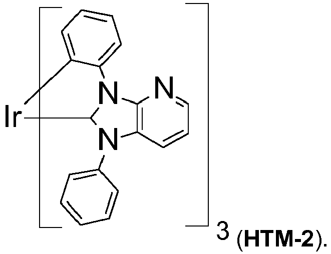

16. Dispositif électroluminescent organique selon l'une quelconque des revendications 2 à 15, dans lequel la couche de transport d'électrons comporte un composé de formule : 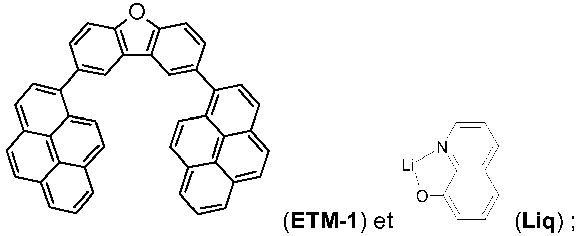 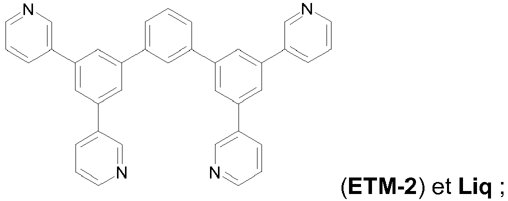 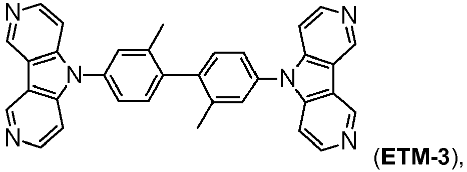 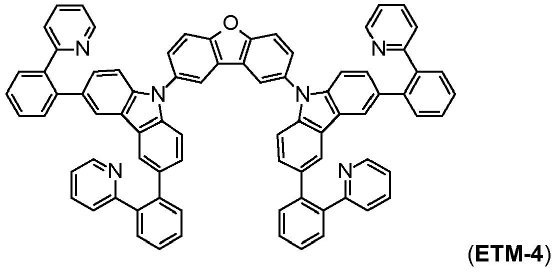 ou

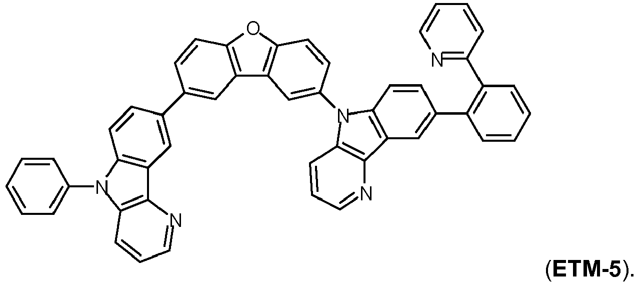

17. Dispositif électroluminescent organique selon l'une quelconque des revendications 2 à 16, comportant dans cet ordre :
(a) une anode,
(b) (poly(thiophène-3-[2[(2-méthoxyéthoxy)éthoxy]-2,5-diyle sulfoné) (couche d'injection de trous),
(c) MoO₃/ HTM-1 (couche de transport de trous),
(d) HTM-1 (couche de blocage d'excitons),
(e) couche émettrice comportant :
(e1) RE-2/HTM-1 (première couche électroluminescente),
(e2) BE-1/GE-1/SH-2 (seconde couche électroluminescente),
(f) SH-2 (couche de blocage d'excitons),
(g) ETM-1/Liq (couche de transport d'électrons),
(h) KF (couche d'injection d'électrons), et
(i) une cathode, ou
comportant dans cet ordre :
(a) une anode,
(b) (poly(thiophène-3-[2[(2-méthoxyéthoxy)éthoxy]-2,5-diyle sulfoné) (couche d'injection de trous),
(c) MoO₃/HTM-2 (couche de transport de trous),
(d) HTM-2 (couche de blocage d'excitons),
(e) couche émettrice comportant :
(e1) RE-2/HTM-2 (première couche électroluminescente),
(e2) BE-1/GE-1/SH-2 (seconde couche électroluminescente),
(f) SH-2 (couche de blocage d'excitons),
(g) ETM-1/Liq (couche de transport d'excitons), et
(h) KF (couche d'injection d'électrons), et
(i) A1 (cathode), ou
comportant cet ordre :
(a) une anode,
(b) (poly(thiophène-3-[2[(2-méthoxyéthoxy)éthoxy]-2,5-diyle sulfoné) (couche d'injection de trous),
(c) MoO₃/ HTM-1 (Ir(DPBIC)₃) (couche de transport de trous),
(d) HTM-1 (couche de blocage d'excitons),
(e) couche émettrice comportant :
(e1) RE-1/HTM-1 (première couche électroluminescente),
(e2) BE-1/GE-1/SH-1 (seconde couche électroluminescente),
(f) SH-1 (couche de blocage d'excitons),
(g) ETM-1/Liq (couche de transport d'électrons), et
(h) une cathode, ou
comportant dans cet ordre :
(a) une anode,
(b) (poly(thiophène-3-[2[(2-méthoxyéthoxy)éthoxy]-2,5-diyle sulfoné) (couche d'injection de trous),
(c) MoO₃/HTM-2 (couche de transport par trous),
(d) HTM-2 (couche de blocage d'excitons),
(e) couche émettrice comportant :
(e1) RE-1/HTM-2 (première couche électroluminescente),
(e2) BE-1/GE-1/SH-1 (seconde couche électroluminescente),
(f) SH-1 (couche de blocage d'excitons),
(g) ETM-1/Liq (couche de transport de trous), et
(h) une cathode.

18. Appareil choisi parmi le groupe constitué d'unités d'affichage visuel fixes, d'unités éclairage, de claviers, de vêtements, de meubles ou de papiers peints, comportant le dispositif électronique organique selon l'une quelconque des revendications 2 à 17, ou la couche émettrice selon la revendication 1.

19. Utilisation de la couche émettrice (e) selon la revendication 1 pour générer de la lumière blanche.
